# EUROPEAN PATENT APPLICATION

(11) **EP 1 609 615 A1**
(43) Date of publication of application: **28.12.2005**
(21) Application number: 04720261.9
(22) Date of filing: 12.03.2004
(51) Int. Cl.: B41M 5/26, G11B 7/24, G11B 7/26

(54) **INFORMATION RECORDING MEDIUM AND METHOD FOR MANUFACTURING SAME**

(30) Priority: 24.03.2003 JP 2003079994
(71) Applicant: MATSUSHITA ELECTRIC INDUSTRIAL CO., LTD., Kadoma-shi, Osaka 571-8501 (JP)
(72) Inventor: SUENAGA, Taeko, Osaka 569-0818 (JP); KOJIMA, Rie, Osaka 571-0030 (JP); NISHIHARA, Takashi, Osaka 573-1118 (JP); YAMADA, Noboru, Osaka 573-1104 (JP)
(74) Representative: Eisenführ, Speiser & Partner
(86) International application number: PCT/JP2004/003331
(87) International publication number: WO 2004/085167

(57) **Abstract**

An information recording medium, comprising:
a recording layer which can phase-change reversibly between a crystal phase and an amorphous phase by using an optical means or an electric means,
wherein the recording layer comprises at least Ge, Te, M1 (which is at least one element selected from the group consisting of Sc, Y, La, Ce, Pr, Nd, Sm, Gd, Tb, Dy, Ho, Er, Yb and Lu), M2 (which is at least one element selected from the group consisting of Sb and Bi) and M3 (which is at least one element selected from the group consisting of Te and Bi).

## Description

### FIELD OF THE INVENTION

The present invention relates to an information recording medium on and from which information is recorded, erased, rewritten and reproduced optically or electrically and a method for manufacturing such an information recording medium.

### BACKGROUND OF THE INVENTION

Information recording media include a phase-change optical information recording medium on and from which information is recorded, erased, rewritten and reproduced optically by using a laser beam. Upon recording, erasing and rewriting information on and from the phase-change optical information recording medium, a phenomenon in which the recording layer can phase-change reversibly between a crystal phase and an amorphous phase is utilized. In general, upon recording information, a high-power (recording power) laser beam is applied to the recording layer to heat the recording layer to a temperature higher than its melting point; thus, the irradiated portion is fused and then rapidly cooled so that an amorphous phase is formed in the irradiated portion to record the information. In contrast, upon erasing information, a laser beam having a power (erasing power) lower than that at the time of recording is applied to the recording layer so that the recording layer is heated to a temperature that is sufficiently higher than the crystallizing temperature of the recording layer and is lower than the melting point; thus, the recording layer is cooled gradually after having been heated so that a crystal phase is formed in the irradiated portion to erase the previous information. Therefore, in the phase-change optical information recording medium, a laser beam which has been power-modulated between a high-power level and a low-power level is applied to the recording layer so that it becomes possible to record or rewrite new information, while previously recorded information is being erased. Upon reproducing information from the phase-change optical information recording medium, a laser beam that has a power (reproducing power) lower than the erasing power is applied to the recording medium so that information is read by utilizing a difference in reflectances between the amorphous portion and the crystal portion. Therefore, in order to increase the amplitude of a regenerative signal, it is necessary to make a change in reflectances between the crystal phase and the amorphous phase greater.

There have been strong demands for a greater capacity in the information recording medium, and various techniques for increasing the capacity have been examined. For example, with respect to optical information recording media, a technique has been proposed in which an optical information recording medium having two recording layers is used to double the information capacity and a laser beam that is made incident on one side is used for recording and reproducing on and from the two recording layers. In the case when this technique is used, since a change in reflectances is read from the recording layers as a reproducing signal by using the laser beam that is made incident onto the two recording layers from one side thereof, the recording layer on the laser-light incident side requires sufficient light transparency. Therefore, the thickness of the recording layer on the laser-light incident side has to be made thinner in order to increase the light transparency. However, in the case when the thickness of the recording layer is made thinner, since it becomes difficult to move atoms, the crystallization speed of the recording layer is reduced. For this reason, when the thickness of the recording layer is made thinner, it is necessary to increase the crystallization speed of the recording layer. For this purpose, the inventors of the present invention have disclosed a method in which Sn is added to Ge-Sb-Te (Rie KOJIMA and Noboru YAMADA, "Acceleration of Crystallization Speed by Sn Addition to Ge-Sb-Te Phase-Change Recording Material", Japanese Journal of Applied Physics, Vol. 40(2001) pp. 5930-5937).

In order to make a spot diameter of the laser beam smaller to achieve a high-density recording operation, techniques have been proposed in which, with respect to the laser to be used for recording, erasing, rewriting and reproducing information, a purple-blue laser having a wavelength shorter than that of the conventional red laser is used and the thickness of a substrate on the light-incident side of a laser beam is made thinner, with an objective lens with a greater numerical aperture (NA) being used.

In the information recording medium, there have been also strong demands for a higher transfer rate through high-speed recording. In the case when the linear velocity of an information recording medium is increased, since the irradiation time of a laser beam becomes shorter, the time required for crystallization of the recording layer has to be made shorter. For this reason, it becomes necessary to improve the crystallization speed of the recording layer.

As described above, in order to achieve a higher density and a higher transfer rate for the information recording medium, it is necessary to improve the crystallization speed of the recording layer. With respect to a method for improving the crystallization speed of the recording layer, for example, the inventors of the present invention have proposed a method in which Sn is added to a Ge-Sb-Te recording layer also in a DVD-RAM of 4.7 GB that was released in June, 2000 (for example, see Japanese Patent Application Laid-Open No. 2001-322357).

### (Technical Problems to be Solved by the Invention)

With respect to the information recording medium having a high density and a high transfer rate that is applicable to high-vision recording, that is, the aforementioned information recording medium using a purple-blue laser, further improvements in the crystallization speed are required. In this case, the addition of a greater amount of Sn is required; however, experiments by the inventors have proved that, although the crystallization speed is improved to achieve a high density and a high transfer rate, the crystallizing temperature is lowered to cause degradation in the reproducing signal quality due to reproducing light.

Consequently, crystallization in the amorphous phase corresponding to recorded information is allowed to progress by reproducing light, with the result that the amplitude of the reproducing signal is reduced to cause degradation in the reproducing signal quality.

In order to suppress the progress of crystallization due to reproducing light in the recording layer, the reproducing power is made as low as possible; however, when the reproducing power is lowered, an increase in laser noise and a reduction in the reproducing signal amplitude tend to occur, failing to provide a sufficient signal amplitude at the time of reproducing. In particular, in the case of an information recording medium using a purple-blue laser, the reflectance in the amorphous portion is designed to be close to 0%, with the result that the absorbing rate in the amorphous portion of the recording layer sometimes reaches 90% or more. In the case when the absorbing rate in the amorphous portion is great in this manner, since more reproducing light is absorbed, the amorphous portion tends to have a temperature rise. For this reason, the crystallization of the amorphous portion progresses due to irradiation with the reproducing light, thereby making the reproducing signal amplitude smaller. Therefore, an attempt may be made to make the absorbing rate in the amorphous portion smaller; however, when the absorbing rate in the amorphous portion is reduced, the reflectance in the amorphous portion increases, resulting in a reduction in the reflectance contrast between the amorphous portion and the crystal portion (indicated by (Rc - Ra)/Rc, supposing that the reflectance in the crystal portion is Rc and that the reflectance in the amorphous portion is Ra) to cause degradation in the reproducing signal quality. Consequently, even when only a method for reducing the reproducing power or a method for making the absorbing rate in the amorphous portion smaller is used, degradation in the reproducing signal quality tends to occur, failing to provide a means for sufficiently suppressing crystallization in the amorphous portion.

The objective of the present invention is to provide an information recording medium which suppresses degradation in the recording signal due to reproducing light and carries out a reproducing operation stably, even when used as an information recording medium having a high density and a high transfer rate.

### (Means to Solve the Problems)

In order to achieve the above-mentioned objectives, an information recording medium of the present invention in which its recording layer can phase-change reversibly between a crystal phase and an amorphous phase by using an optical means or an electric means is provided with a recording layer that contains at least Ge, Te, M1 (which is at least one element selected from the group consisting of Sc, Y, La, Ce, Pr, Nd, Sm, Gd, Tb, Dy, Ho, Er, Yb and Lu (the same is true for the following description)), M2 (which is at least one element selected from the group consisting of Sb and Bi (the same is true for the following description)) and M3 (which is at least one element selected from the group consisting of Te and Bi (the same is true for the following description)). This information recording medium, which allows the recording layer to have a high melting point and a high crystallizing temperature, provides superior thermal stability, and also prevents degradation in reproducing light.

In the case of an information recording medium provided with at least two recording layers, when at least one recording layer is allowed to phase-change reversibly between a crystal phase and an amorphous phase by using an optical means or an electric means, the same functions are achieved by placing the same recording layer as described above.

In the information recording medium, the recording layer contains at least GeTe, M2₂Te₃ and M1M3 (which is a compound containing M1 and M3 at a virtually equal rate), or may contain a material represented by GeTe-M1M3-M2₂Te₃. With this structure, by the use of M1M3 that is a stoichiometric composition compound having a high melting point, the recording layer is allowed to have a high melting point and a high crystallizing temperature so that it is possible to provide an information recording medium which has a high crystallization speed with superior thermal stability, and prevents degradation in reproducing light.

In the information recording medium, with respect to the material for the recording layer, one portion of GeTe may be substituted by M1M3 (in which M3 is at least one element selected from the group consisting of Te and Bi), and represented by (GeTe-M1M3)-M2₂Te₃. In accordance with this information recording medium, M1 by which Ge in the Ge-M2-Te3 three-element composition is substituted makes it possible to raise the crystallizing temperature of the recording layer so that an information recording medium which has superior thermal stability, and prevents degradation in reproducing light can be obtained. Since GeTe and M1M3 are the same NaCl-type compounds in the crystal structure, there is no change in the crystallizing process of the recording layer even when Ge is substituted by M1.

In the above-mentioned information recording medium, the recording layer may further contain M2, and may be represented by GeTe-M1M3-M2₂Te₃-M2. With this structure, when Bi is used as M2, the crystallizing property of the recording layer is improved to make the spot diameter of a laser beam smaller so that an information recording medium which can form stable recording marks even in the case of a short laser irradiation time is achieved. When Sb is used as M2, an excessive amount of Sb is added to the material represented by GeTe-M1M3-M2₂Te₃, so that the excessive amount of Sb can adjust the crystallization speed depending on the amount of addition, thereby making it possible to improve the crystallizing temperature to enhance the thermal stability of recording marks, and also to suppress a substance transfer upon repetitive recording operations.

The information recording medium may be designed so that the recording layer is represented by a composition formula GeₐM1_{b}M2_{c}M3_{b}Te_{100-a-2b-c}, and relationships, 5 < a < 50, 0 < b ≤ 26, 0 < c ≤ 52, b ≤ a and 42 < a + 2b + c < 77 (in which a, b and c indicate % by atom), are satisfied. With this structure, it becomes possible to provide an information recording medium which allows the recording layer to have a high melting point , has superior thermal stability, and suppresses degradation in reproducing light, without causing a serious reduction in the crystallization speed.

The information recording medium may be designed so that the recording layer is represented by [(GeTe)ₓ(M1M3)₁₋ₓ ]_{A}M2_{2+B}Te₃, and relationships, 2 ≤ A ≤ 60, 0 ≤ B ≤ 5 and 0.5 ≤ x < 1, are satisfied. In accordance with this information recording medium, since M1 by which Ge in the Ge-M2-Te3 three-element composition is substituted makes it possible to raise the crystallizing temperature of the recording layer without causing a serious reduction in the crystallization speed of the recording layer so that an information recording medium which has superior thermal stability, and suppresses degradation in reproducing light can be obtained.

In the information recording medium, at least, a reflective layer, a second dielectric layer, the recording layer and a first dielectric layer may be placed on a substrate in this order. This structure makes it possible to provide an information recording medium that achieves superior reproducing signal quality. For example, this information recording medium may be applied to an optical system in which a purple-blue laser and a high-NA are used.

In the information recording medium, at least, a first dielectric layer, the recording layer, a second dielectric layer and a reflective layer may be placed on a substrate in this order. This structure makes it possible to provide an information recording medium that achieves superior reproducing signal quality. For example, this information recording medium may be applied to a DVD-RAM in which a red laser is used.

In the information recording medium, an interface layer may be placed in at least either between the recording layer and the second dielectric layer or between the first dielectric layer and the recording layer. This structure makes it possible to provide an information recording medium that is free from a substance transfer between the recording layer and the second dielectric layer or between the first dielectric layer and the recording layer. More specifically, when ZnS-SiO₂ is used as the dielectric layer, the interface layer is allowed to prevent diffusion of S toward the recording layer.

In the information recording medium, a nucleus-forming layer may be formed in contact with the recording layer through an interface. This structure makes it possible to provide an information recording medium that is also superior in rewriting function after a long-term storage.

In the information recording medium, the nucleus-forming layer may have a cubic crystal in its crystal structure thereof. Since this structure allows the nucleus-forming layer to form a nucleus upon crystallization of the recording layer, the crystallizing process of the recording layer is accelerated.

In the information recording medium, the nucleus-forming layer may contain at least one material selected from the group consisting of M1M3, SnTe and PbTe. This structure makes it possible to provide an information recording medium that is also superior in a rewriting performance after a long-term storage. M1M3 has a high melting point of about 2000°C and SnTe and PbTe are crystallized in a state formed as a layer, and the crystal structure of each of these compounds has a NaCl type that is the same as the crystal structure of the recording layer.

In order to achieve the above-mentioned objectives, a method for manufacturing the information recording medium of the present invention, which is a manufacturing method for the information recording medium that has at least the step of forming a recording layer that can phase-change, is characterized in that the step of forming the recording layer uses a sputtering target that contains at least Ge, Te, M1 (which is at least one element selected from the group consisting of Sc, Y, La, Ce, Pr, Nd, Sm, Gd, Tb, Dy, Ho, Er, Yb and Lu), M2 (which is at least one element selected from the group consisting of Sb and Bi) and M3 (which is at least one element selected from the group consisting of Te and Bi). With this method, it becomes possible to manufacture an information recording medium that has a recording layer containing Ge and Te, M1, M2, M3.

The method for manufacturing an information recording medium may be applied to a method in which at least two of the steps of forming the recording layer.

In the method for manufacturing an information recording medium, the sputtering target may contain at least GeTe, M2₂Te₃ and M1M3 (which is a compound containing M1 and M3 at a virtually equal rate).

In the method for manufacturing an information recording medium, the sputtering target may further contain M2.

In the method for manufacturing an information recording medium, it becomes possible to form a recording layer that satisfies relationships, 5 < a < 50, 0 < b ≤ 26, 0 < c ≤ 52, b ≤ a and 42 < a + 2b + c < 77, in which a represents % by atom of Ge, b represents % by atom of M1, c represents % by atom of M2, b represents % by atom of M3 and 100 - a - 2b - c represents % by atom of Te, by using the sputtering target.

The method for manufacturing an information recording medium may include at least the step of forming a reflective layer, a second dielectric layer, the recording layer and a first dielectric layer on a substrate in this order.

The method for manufacturing an information recording medium may include at least the step of forming a first dielectric layer, the recording layer, a second dielectric layer and a reflective layer on a substrate in this order.

The method for manufacturing an information recording medium may be designed so that the step of forming an interface layer is placed either between a layer-forming process of the recording layer and a layer-forming process of the second dielectric layer or between a layer-forming process of the first dielectric layer and a layer-forming process of the recording layer.

The method for manufacturing an information recording medium may be designed so that at least the step of forming a nucleus-forming layer is placed as a pre-process or a post-process of the layer-forming process of the recording layer, and the step of forming a nucleus-forming layer may use a sputtering target that contains at least one material selected from the group consisting of M1M3, SnTe and PbTe.

The method for manufacturing an information recording medium may be designed so that the step of forming the recording layer either uses an argon gas or a crypton gas or uses a mixed gas containing one of an argon gas and a crypton gas and either one of a nitrogen gas and an oxygen gas.

### BRIEF DESCRIPTION OF THE DRAWINGS

FIG. 1 is a partial cross-sectional view that shows one example of a layer structure with respect to an information recording medium that has a single recording layer in accordance with the present invention.
FIG. 2 is a partial cross-sectional view that shows one example of a layer structure with respect to an information recording medium that has a single recording layer in accordance with the present invention.
FIG. 3 is a partial cross-sectional view that shows one example of a layer structure with respect to an information recording medium that has a single recording layer in accordance with the present invention.
FIG. 4 is a partial cross-sectional view that shows one example of a layer structure with respect to an information recording medium that has N-number of information layers in accordance with the present invention.
FIG. 5 is a partial cross-sectional view that shows one example of a layer structure with respect to an information recording medium that has N-number of information layers in accordance with the present invention.
FIG. 6 is a partial cross-sectional view that shows one example of a layer structure with respect to an information recording medium that has N-number of information layers in accordance with the present invention.
FIG. 7 is a partial cross-sectional view that shows one example of a layer structure with respect to an information recording medium that has two information layers in accordance with the present invention.
FIG. 8 is a partial cross-sectional view that shows one example of a layer structure with respect to an information recording medium that has two information layers in accordance with the present invention.
FIG. 9 is a partial cross-sectional view that shows one example of a layer structure with respect to an information recording medium that has two information layers in accordance with the present invention.
FIG. 10 is a partial cross-sectional view that shows one example of a layer structure with respect to an information recording medium that has N-number of information layers in accordance with the present invention.
FIG. 11 is a partial cross-sectional view that shows one example of a layer structure with respect to an information recording medium that has N-number of information layers in accordance with the present invention.
FIG. 12 is a partial cross-sectional view that shows one example of a layer structure with respect to an information recording medium that has N-number of information layers in accordance with the present invention.
FIG. 13 is a drawing that schematically shows one portion of a structure of a recording/reproducing apparatus to be used for recording and reproducing operations in an information recording medium in accordance with the present invention.
FIG. 14 is a drawing that schematically shows one portion of a structure with respect to an information recording medium and an electric information recording medium reproducing apparatus of the present invention.
FIG. 15 is a drawing that schematically shows one portion of a structure with respect to an electric information recording medium having a large capacity of the present invention.
FIG. 16 is a drawing that schematically shows one portion of a structure with respect to an electric information recording medium and its recording/reproducing system of the present invention.
FIG. 17 is a partial cross-sectional view that shows one example of a sputtering target to be used in manufacturing processes of an information recording medium of the present invention.
FIG. 18 is a drawing that schematically shows one portion of a structure with respect to a sputtering device to be used in manufacturing processes of the information recording medium of the present invention.
FIG. 19 is a partial cross-sectional view that shows one example of a layer structure with respect to an information recording medium that has a single recording layer in accordance with the present invention.
FIG. 20 is a partial cross-sectional view that shows one example of a layer structure with respect to an information recording medium that has a single recording layer in accordance with the present invention.
FIG. 21 is a partial cross-sectional view that shows one example of a layer structure with respect to an information recording medium that has a single recording layer in accordance with the present invention.

### BEST MODE FOR CARRYING OUT THE INVENTION

Referring to Figures, the following description will discuss embodiments of the present invention. The invention is illustrated by the following embodiments; however, the invention is not intended to be limited thereby. In the following embodiments, the same parts are indicated by the same reference numerals, and the repetitive description thereof is omitted.

### (Embodiment 1)

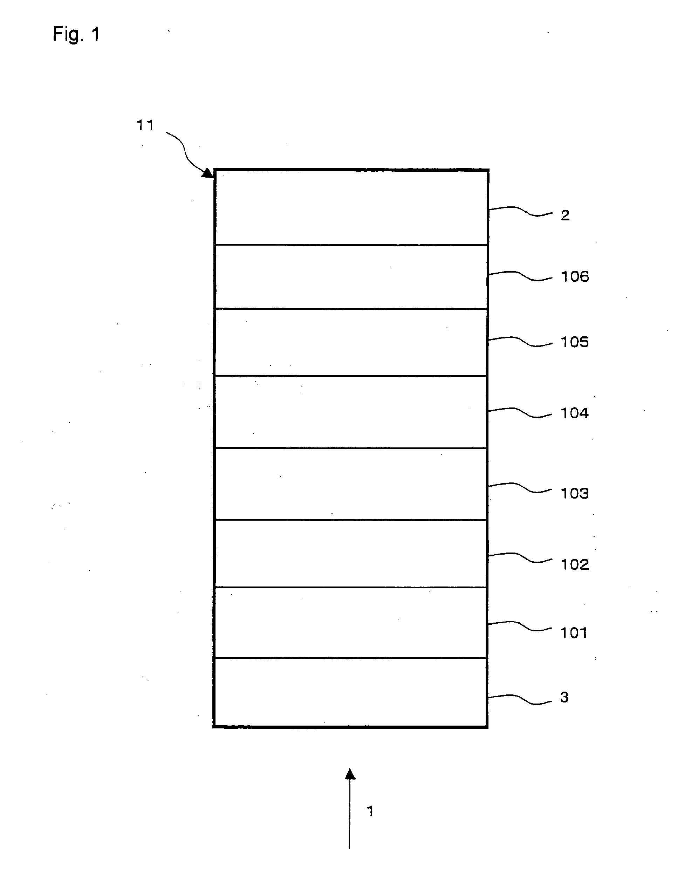

Embodiment 1 explains one example of an information recording medium of the present invention. Fig. 1 shows a partial cross-sectional view of an information recording medium 11 of Embodiment 1. This information recording medium 11 is an optical information recording medium that is capable of recording and reproducing information through irradiation with a laser beam 1.

The information recording medium 11 is constituted by a reflective layer 106, a second dielectric layer 105, a second interface layer 104, a recording layer 103, a first interface layer 102, a first dielectric layer 101 and a transparent layer 3 that are successively laminated on a substrate 2.

Since the laser beam 1 is made incident on the side of a transparent layer 3 and light reflected from the recording layer 103 is utilized as a reproducing signal, the transparent layer 3, placed on the light incident side of the recording layer 103, is preferably made to have little light absorbing property to the laser beam 1 to be used, with a small optical birefringence in a short wavelength range. Resins and dielectric layers may be used as the material for the transparent layer 3. In the case when a resin is used as the transparent layer 3, a photocurable resin (in particular, ultraviolet-ray setting resin), a slow-acting resin or the like may be applied to the first dielectric layer 101 to form the layer. Resins such as polycarbonate, amorphous polyolefin and PMMA or glass, formed into a transparent disc-shape, may be bonded to the first dielectric layer 101 by using a photocurable resin (in particular, ultraviolet-curable resin) or a slow-acting resin so as to prepare the layer. In the case when a dielectric layer is used as the transparent layer 3, the layer may be formed through sputtering. The transparent layer 3 may be constituted by a plurality of layers.

A spot diameter to be formed upon converging the laser beam 1 is determined by the wavelength λ of the laser beam 1 (as the wavelength λ becomes shorter, light can be converged into a smaller spot diameter); therefore, in the case of a high-density recording medium like the information recording medium 11, the wavelength λ of the laser beam 1 is preferably set to 450 nm or less, and since the wavelength of less than 350 nm tends to increase the light absorption of the transparent layer 3 and the like, the wavelength is preferably set within a range from 350 nm to 450 nm.

Guide grooves to be used for directing the laser beam 1 may be formed on the surface of the substrate 2 on the reflective layer 106 side on demand. The surface on the side opposite to the reflective layer 106 of the substrate is preferably formed into a smooth face. With respect to the material for the substrate 2, in particular, polycarbonate is effectively used because of its superior copying property and mass-productivity and low costs. With respect to the thickness of the substrate 2, it is preferably set in a range from 500 µm to 1200 µm so as to provide sufficient strength and allow the information recording medium 11 to have a thickness of about 1200 µm. In the case when the thickness of the transparent layer 3 is about 600 µm (which makes it possible to provide desirable recording and reproducing operations when NA = 0.6), the thickness is preferably set in a range from 550 µm to 650 µm. In the case when the thickness of the transparent layer is about 100 µm (which makes it possible to provide desirable recording and reproducing operations when NA = 0.85), the thickness is preferably set in a range from 1050 µm to 1150 µm.

The first dielectric layer 101 is made of a dielectric material. The first dielectric layer 101 has functions for preventing oxidation, corrosion and deformation of the recording layer 103, for adjusting the optical distances so as to improve the light absorbing efficiency of the recording layer 103 and for increasing a change in amounts of reflected light rays before and after the recording operation so as to increase the signal amplitude. With respect to the first dielectric layer 101, for example, oxides such as TiO₂, ZrO₂, ZnO₂, ZnO, Nb₂O₅, Ta₂O₅, SiO₂, Al₂O₃, Bi₂O₃ and Cr₂O₃ may be used. Nitrides such as C-N, Ti-N, Zr-N, Nb-N, Ta-N, Si-N, Ge-N, Cr-N, Al-N, Ge-Si-N and Ge-Cr-N may also be used. Sulfides such as ZnS, carbides such as SiC and fluorides such as LaF₃ may also be used. Mixtures of the above-mentioned materials may also be used. For example, ZnS-SiO₂, which is a mixture of ZnS and SiO₂, is particularly superior as a material for the first dielectric layer 101. ZnS-SiO₂, which is an amorphous material, has a high reflectance and a high layer-forming rate, and is superior in mechanical property and moisture-resistant property.

Based upon calculations in accordance with matrix method (for example, see chapter 3 of "Wave Optics" written by Hiroshi Kubota, Iwanami Shoten, 1971), the layer thickness of the first dielectric layer 101 can be precisely determined so as to satisfy conditions that make greater a change in the amounts of reflected light rays between the crystal portion and the amorphous portion of the recording layer 103, as well as making greater the light absorption in the recording layer 103. The layer thickness of the first dielectric layer 101 is preferably set in a range from 2 nm to 80 nm, more preferably in a range from 20 nm to 70 nm. By setting the layer thickness of the first dielectric layer 101 within this range, heat can be effectively transmitted to the recording layer 103. Thus, it becomes possible to lower the necessary recording power and consequently to improve the recording sensitivity.

The first interface layer 102 has a function for preventing substance transfers that occur between the first dielectric layer 101 and the recording layer 103 due to repetitive recording operations. In particular, in the case when the first dielectric layer 101 contains S, since a substance transfer of S often takes place between the first dielectric layer 101 and the recording layer 103, the first interface layer 102 needs to function more effectively. Upon reproducing information, a laser beam 1 with reproducing power is directed to the information recording medium 11 so that the information is read out based upon a difference in reflectances of the crystal portion and the amorphous portion. Consequently, in order to increase the amplitude of the reproducing signal, it is necessary to make the change in reflectances between the crystal phase and the amorphous phase greater. From this point of view, the first interface layer 102, which contacts with the recording layer 103 through an interface, is preferably made from a material that has little light absorption and a high melting point so that it is less susceptible to melting even upon irradiation with a recording-power (high-power) laser beam during a recording process, and also has good adhesion to the first dielectric layer 101 and the recording layer 103. The property of the material that has a high melting point and is less susceptible to melting upon recording is a necessary property so as to prevent the material from melting and entering the recording layer 103 upon irradiation with the high-power laser beam 1. The mixed material into the recording layer 103 would change the composition of the recording layer 103 to cause serious degradation in the rewriting performance. The property of the material of having good adhesion to the first dielectric layer 101 and the recording layer 103 is a necessary property so as to ensure reliability.

The second interface layer 104 has functions similar to those of the first interface layer 102. The first interface layer 104 has a function for preventing substance transfers from occurring between the second dielectric layer 105 and the recording layer 103 due to repetitive recording operations, and in particular, in the case when the second dielectric layer 105 contains S, the second interface layer 104 needs to function more effectively. In order to make greater the change in reflectances between the crystal phase and the amorphous phase that is utilized as the amplitude of the reproducing signal, the second interface layer 104, which contacts with the recording layer 103 through an interface is preferably made from a material that has little light absorption and a high melting point so that it is less susceptible to melting even upon irradiation with a recording-power (high-power) laser beam during a recording process, and also has good adhesion to the second dielectric layer 105 and the recording layer 103.

With respect to the first interface layer 102 and the second interface layer 104, the same types of materials as those of the first dielectric layer 101 may be used. Among those, in particular, materials that contain Cr, Zr and O are preferably used. Among those, materials in which Cr and O form Cr₂O₃ and Zr and O form ZrO₂ so that a mixture of Cr₂O₃ and ZrO₂ is formed are preferably used. The material Cr₂O₃ provides good adhesion to the recording layer 103. The material ZrO₂ is transparent and has a high melting point of about 2700°C, while exerting a low thermal conductivity in an oxide; therefore, this material has a good repetitive rewriting property. By mixing these two kinds of oxides, the resulting interface layer is allowed to exert a superior repetitive rewriting property even when formed in contact with the recording layer 103, thereby making it possible to achieve an information recording medium 11 having high reliability. In order to ensure the adhesion to the recording layer 103, the content of Cr₂O₃ in Cr₂O₃-ZrO₂ is preferably set to 10 mol % or more, and in order to maintain the light absorption in the first interface layer 102 and the second interface layer 104 at low levels, the content is preferably set to 60 mol % or less (as Cr₂O₃ increases, the light absorption tends to increase). More preferably, the content is set in a range from 20 mol % or more to 50 mol % or less.

With respect to the first interface layer 102 and the second interface layer 104, a material that further contains Si in addition to Cr, Zr and O may be used, and among these, materials in which Cr and O form Cr₂O₃, Zr and O form ZrO₂, and Si and 0 form SiO₂ so that a mixture of SiO₂, Cr₂O₃ and ZrO₂ is formed are preferably used. By allowing the interface layer to contain SiO₂, the effect for accelerating crystallization of the recording layer 103 is enhanced so that it becomes possible to achieve an information recording medium 11 having a superior rewriting property. The content of SiO₂ in SiO₂-Cr₂O₃-ZrO₂ is preferably set to 5 mol % or more, and in order to ensure the adhesion to the recording layer 103, the content thereof is preferably set to 40 mol % or less. More preferably, the content is set in a range from 10 mol % or more to 40 mol % or less. In order to ensure good recording/rewriting performances, the sum of the contents of SiO₂ and Cr₂O₃ is preferably set to 95 mol % or less.

The thickness of each of the first interface layer 102 and the second interface layer 104 is preferably set in a range from 1 nm to 10 nm, more preferably in a range from 2 nm to 7 nm, so as not to reduce the change in amounts of reflected light rays in the recording layer 103 before and after a recording operation due to light absorption.

With respect to the first interface layer 102 and the second interface layer 104, materials containing C may be used. By allowing the interface layer to contain C, the crystallization speed in the recording layer 103 is lowered so that it becomes possible to prevent degradation by a reproducing light. In the case when C is used as the first interface layer 102 and the second interface layer 104, the layer thickness of C is preferably set to 5 nm or less, more preferably 3 nm or less, so as not to cause degradation in the repeating property.

The second dielectric layer 105 has a function for adjusting the optical distances so as to improve the light absorbing efficiency of the recording layer 103, as well as a function for making the change in the amounts of reflected light rays greater before and after a recording operation to increase the signal amplitude. With respect to the second dielectric layer 105, the same type of materials as those of the first dielectric layer 101 can be used, and ZnS-SiO₂, which is a mixture of ZnS and SiO₂, also serves as a superior material for the second dielectric layer 105.

The layer thickness of the second dielectric layer 105 is preferably set in a range from 2 nm to 75 nm, more preferably in a range from 2 nm to 40 nm. By selecting the layer thickness of the second dielectric layer 105 from this range, heat generated in the recording layer 103 can be effectively diffused toward the reflective layer 106 side. Thus, upon recording information on the recording layer 103, the layer is easily cooled off quickly so that the amorphous phase can be formed stably.

A material, which exerts reversible phase changes between the crystal portion and the amorphous portion upon irradiation with a laser beam 1, can be used as the recording layer 103 of the present invention. The recording layer 103 is formed of a material containing Ge, Te, M1 (M1 is at least one element selected from Sc, Y, La, Ce, Pr, Nd, Sm, Gd, Tb, Dy Ho, Er, Yb and Lu, preferably from La, Ce, Nd, Sm, Gd, Tb and Dy), M2 (M2 is at least one element selected from the group consisting of Sb and Bi) and M3 (M3 is at least one element selected from the group consisting of Te and Bi). Ge, Te, M1, M2 and M3 include GeTe, M2₂Te₃ and M1M3 (M1M3 is a compound containing M1 and M3 at virtually the same rate), and are represented preferably by GeTe-M1M3-M2₂Te₃, particularly GeTe-M1Te-Sb₂Te₃, GeTe-M1Bi-Sb₂Te₃, GeTe-M1Te-Bi₂Te₃ or GeTe-M1Bi-Bi₂Te₃. M1M3 has a high melting point, that is, 1300°C or more. In particular, with respect to BiGd, BiTb, BiDy and BiY, the possibility of having a high melting point of 2000°C or more is indicated by a phase diagram of a two-element system. Preferably, BiGd, BiTb and BiDy are used. For this reason, by using these compounds as M1M3, the crystallizing temperature of the recording layer 103 is made higher so that an information recording medium 11 having good thermal stability can be obtained. M1M3 has a crystal structure of the NaCl type. Therefore, for example, in the case when the recording layer 103 having the crystal structure of the NaCl type, such as GeTe-Sb₂Te₃-type compounds, is used, M1M3, which has the same crystal structure, can be easily substituted so that the crystallizing temperature of the recording layer 103 can be raised.

More specifically, the recording layer 103 may be formed by a material represented by GeₐM1_{b}M2_{c}M3_{b}Te_{100-a-2b-c} (where a, b and c represent % by atom). In this case, relationships, 5 < a < 50 and 42 < a + 2b + c < 77, are preferably satisfied so as to increase the signal amplitude with a stable amorphous phase, and a relationship, 15 ≤ a ≤ 47, which is suitable for a high-density information recording medium, is more preferably satisfied. In the case of a ≤ 15, the crystallization speed is increased, with the result that the retaining property for recording marks that are amorphous portions is lowered. In the case of a ≥ 50, the melting point is raised with a reduced crystallization speed to cause high recording power, with the result that the recording sensitivity in the recording layer is lowered. Relationships, 0 < b ≤ 26 and 0 < c ≤ 52, preferably, relationships, 0 < b < 20 and 2 < c ≤ 50, are satisfied in which the amorphous phase is stable, the signal amplitude is large and the lowering of crystallization speed is low. In the case of b = 0, the crystallizing temperature is lowered with a reduced retaining property for recording marks. In the case of b > 26, the melting point becomes too high, with the result that the recording sensitivity of the recording layer is lowered. In the case of c < 2, the crystallization speed becomes too low, while in the case of c > 52, the crystallization speed becomes too high.

The recording layer 103 may be formed by using a material in which one portion of composition formula GeTe is substituted by M1M3 to be represented by (GeTe-M1M3)-M2₂Te₃. In the case when this material is used, since the Ge-substituting element M1 increases the melting point and the crystallizing temperature of the recording layer 103 so that it becomes possible to improve the retaining property of the amorphous portions that correspond to recording marks.

More specifically, the recording layer 103 may be formed by a material represented by [(GeTe)ₓ(M1M3)₁₋ₓ ]_{A}M2_{2+B}Te₃, preferably a material represented by [(GeTe)ₓ(M1Te)₁₋ₓ]_{A}Sb_{2+B}Te₃, [(GeTe)ₓ(M1Bi)₁₋ₓ]_{A}Sb_{2+B}Te₃, [(GeTe)ₓ(M1Te)₁₋ₓ]_{A}Bi_{2+B}Te₃ or [(GeTe)ₓ(M1Bi)₁₋ₓ]_{A}Bi_{2+B}Te₃. At this time, the following inequalities are preferably satisfied: 2 ≤ A ≤ 60 as well as 0 ≤ B ≤ 5 and 0.5 ≤ x < 1 (more preferably 0.8 ≤ x < 1).

The recording layer 103 may be formed by a material that further contains M2, and is represented by GeTe-M1M3-M2₂Te₃-M2. When the added M2 is Bi, the crystallization speed of the recording layer is improved. When the added M2 is Sb, the crystallizing temperature and the crystallization speed of the recording layer can be adjusted by the amount of addition.

The layer thickness of the recording layer 103 is preferably set in a range from 6 nm to 14 nm, preferably in a range from 8 nm to 12 nm, so as to improve the recording sensitivity of the information recording medium 11. The thickness of the recording layer 103 that is greater than 14 nm causes greater thermal effects to adjacent areas due to thermal diffusion in the in-plane direction. The thickness of smaller than 6 nm of the recording layer 103 makes the reflectance of the information recording medium 11 smaller.

The reflective layer 106 has such an optical function that the amount of light to be absorbed by the recording layer 103 is increased. The reflective layer 106 also has a thermal function for quickly diffusing heat generated in the recording layer 103 to quickly cool the recording layer 103 so as to be easily formed into an amorphous portion. Furthermore, the reflective layer 106 also has a function for protecting multilayers from environments in which they are used.

With respect to the material for the reflective layer 106, for example, elementary substances having a high thermal heat conductivity, such as Ag, Au, Cu and Al may be used. Alloys, such as Al-Cr, Al-Ti, Au-Pd, Au-Cr, Ag-Pd, Ag-Pd-Cu, Ag-Pd-Ti, Ag-Ru-Au, Ag-Cu-Ni, Ag-Zn-Al and Cu-Si, may also be used. In particular, Ag alloys, which have a high thermal conductivity, are preferably used as the material for the reflective layer 106.

The layer thickness of the reflective layer 106 is preferably set to 30 nm or more, which provides a sufficient heat diffusing function. Even within this range, when the reflective layer 106 is thicker than 200 nm, the thermal diffusing function becomes too great to cause a reduction in the recording sensitivity of the information recording medium 11. Therefore, the layer thickness of the reflective layer 106 is preferably set in a range from 30 nm to 200 nm.

In the case when Ag or an Ag alloy is used as the reflective layer 106, if the second dielectric layer 105 contains S, a substance transfer of S takes place between the second dielectric layer 105 and the reflective layer 106, with the result that Ag in the reflective layer is sulfurized; therefore, a third interface layer is preferably formed between the second dielectric layer 105 and the reflective layer 106. In this case, with respect to the third interface layer, a material, which has a thermal conductivity lower than that of the material explained in the reflective layer 106, may be used. Al or an Al alloy is preferably used as the third interface layer. With respect to the third interface layer, elements such as Cr, Ni, Si, and C, or oxides such as TiO₂, ZrO₂, ZnO, Nb₂O₅, Ta₂O₅, SiO₂, Al₂O₃, Bi₂O₃ and Cr₂O₃ may be used. Nitrides such as C-N, Ti-N, Zr-N, Nb-N, Ta-N, Si-N, Ge-N, Cr-N, Al-N, Ge-Si-N and Ge-Cr-N may also be used. Furthermore, carbides such as SiC and fluorides such as LaF₃ may also be used. Mixtures of the above-mentioned materials may also be used. The layer thickness thereof is preferably set in a range from 3 nm to 100 nm (more preferably from 5 nm to 50 nm).

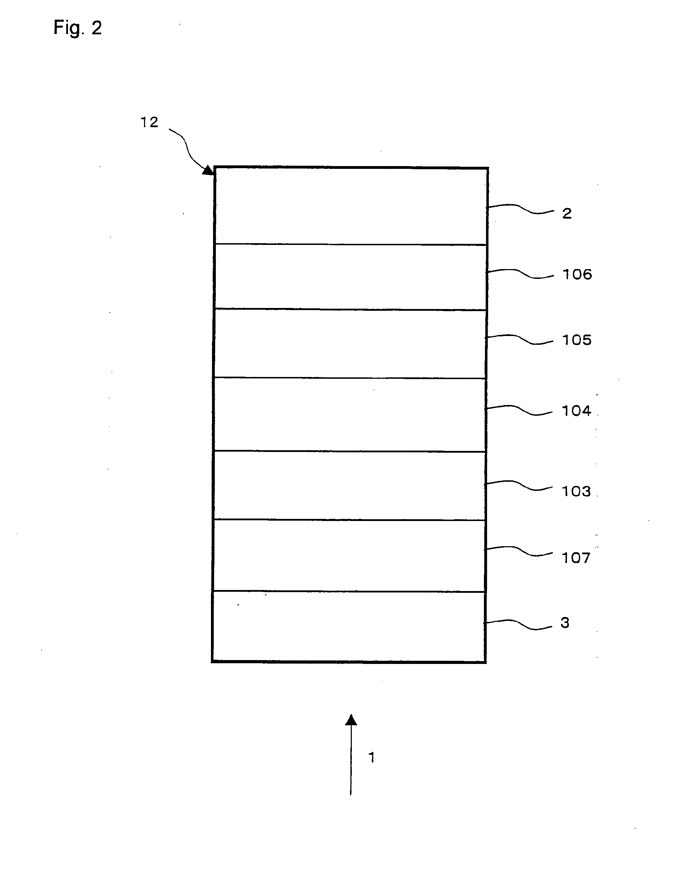

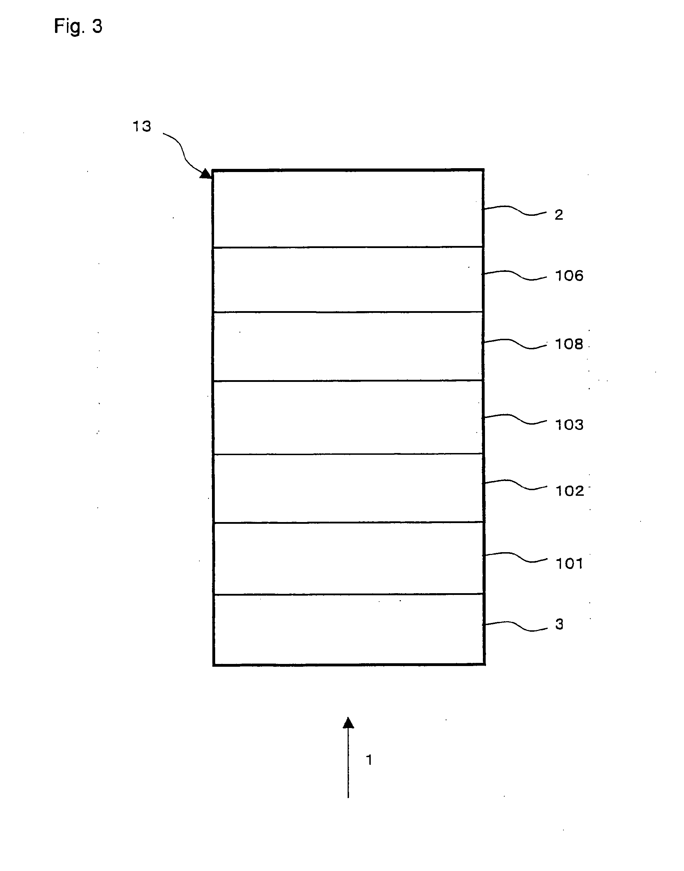

A nucleus-forming layer may be formed in at least either between the recording layer 103 and the first interface layer 102 or between the recording layer 103 and the second interface layer 104 in contact with the recording layer 103. The nucleus-forming layer may contain at least one material selected from M1M3, SnTe and PbTe. With respect to the nucleus-forming layer, for example, materials, such as DyTe, BiTb, BiTeM1₂, Bi₂TeM1 and BiTe₂M1, may be used. By using these materials, the melting point of the nucleus-forming layer is made higher, with good thermal stability, and crystal nuclei are easily generated on the interface between the nucleus-forming layer and the recording layer 103 so that the crystal growth in the recording layer 103 is accelerated; thus, an information recording medium 11 of Fig. 1, an information recording medium 12 of Fig. 2 and an information recording medium 13 of Fig. 3, which are superior in rewrite retaining property, can be obtained. The layer thickness of the nucleus-forming layer is preferably set in a range from 0.3 nm to 3 nm, more preferably from 0.5 nm to 2 nm, so as to provide a superior erasing performance as well as a superior rewriting performance after a long-term storage, even in the case of a high-speed transfer rate. Any of the island-shaped nucleus layer and thin-film-shaped nucleus layer can provide the same effects as the nucleus-forming layer.

The first interface layer may be omitted, and as shown Fig. 2, the information recording medium 12 is constituted by a reflective layer 106, a second dielectric layer 105, a second interface layer 104, a recording layer 103, a first dielectric layer 107 and a transparent layer 3 that are successively laminated on a substrate 2. In this case, preferably, the first dielectric layer 107 does not contain S so as to prevent a substance transfer from occurring between the first dielectric layer 107 and the recording layer 103 to cause a change in the composition of the recording layer. The second interface layer may be omitted, and as shown in Fig. 3, the information recording medium 13 is constituted by a reflective layer 106, a second dielectric layer 108, a recording layer 103, a first interface layer 102, a first dielectric layer 101 and a transparent layer 3 that are successively laminated on a substrate 2. In this case also, preferably, the second dielectric layer 108 does not contain S so as to prevent a substance transfer from occurring between the second dielectric layer 108 and the recording layer 103 to cause a change in the composition of the recording layer.

The information recording medium 11 of Fig. 1, the information recording medium 12 of Fig. 2 and the information recording medium 13 of Fig. 3 are manufactured by using methods as described below.

First, the following description will discuss a manufacturing method for the information recording medium 11 of Fig. 1.

A substrate 2 (having a thickness of, for example, 1100 µm) is first prepared, and placed in a layer-forming device.

Next, the reflective layer 106 is formed on the substrate 2. At this time, in the case when guide grooves used for directing a laser beam 1 to the substrate 2 are formed on the substrate 2, the reflective layer 106 is formed on the side on which the guide grooves are formed. The reflective layer 106 is formed by sputtering a sputtering target made of metal or alloy that forms the reflective layer 106 in an Ar gas atmosphere or a mixed gas atmosphere of Ar gas and a reactive gas (at least one gas selected from oxygen gas and nitrogen gas).

Successively, the second dielectric layer 105 is formed on the reflective layer 106. The second dielectric layer 105 is formed by sputtering a sputtering target made of a compound that forms the second dielectric layer 105 in an Ar gas atmosphere or a mixed gas atmosphere of Ar gas and a reactive gas (at least one gas selected from oxygen gas and nitrogen gas). The second dielectric layer 105 is formed by reactive-sputtering a sputtering target made of metal that forms the second dielectric layer 105 in a mixed gas atmosphere of Ar gas and a reactive gas.

Next, the second interface layer 104 is formed on the second dielectric layer 105. The second interface layer 104 can be formed in the same method as that of the second dielectric layer 105.

Next, the recording layer 103 is formed on the second interface layer 104. The recording layer 103 is formed by sputtering a sputtering target made of a Ge-M1-M2-M3-Te alloy depending on its composition by using a single power supply. With respect to the sputtering atmospheric gas, Ar gas, Kr gas, a mixed gas of Ar gas and a reactive gas, or a mixed gas of Kr gas and a reactive gas may be used. The recording layer 103 may also be formed by simultaneously sputtering respective sputtering targets of Ge, M1, Te and M2 or M3, using a plurality of power supplies. The recording layer 103 may also be formed by simultaneously sputtering a two-element-system sputtering target or a three-element-system sputtering target, formed by combining any of elements of Ge, M1, Te and M2, or M3, by the use of a plurality of power-supplies. In any of these cases, the layer is formed by carrying out the sputtering processes in an Ar gas atmosphere, a Kr gas atmosphere, a mixed gas atmosphere of Ar gas and a reactive gas or a mixed gas atmosphere of Kr gas and a reactive gas. For example, a recording layer of a Ge-Dy-Sb-Te alloy may be formed by using an alloy sputtering target of GeTe, Sb₂Te₃ or TeDy as the two-element-system sputtering target.

Next, the first interface layer 102 is formed on the recording layer 103. The first interface layer 102 can be formed by using the same method as the second dielectric layer 105.

The first dielectric layer 101 is formed on the first interface layer 102. The first dielectric layer 101 can be formed by using the same method as the second dielectric layer 105.

Lastly, the transparent layer 3 is formed on the first dielectric layer 101. The transparent layer 3 is formed through processes in which: a resin such as a photo-curable resin (in particular, an ultraviolet-ray setting resin) or a slow-acting resin is applied to the first dielectric layer 101, and this is spin-coated with a substrate being made in close-contact onto the first dielectric layer 101, and the resin is then cured. The transparent layer 3 may be prepared as a transparent disc-shaped substrate made from a resin, such as polycarbonate or amorphous polyolefin and PMMA, or glass. In this case, the substrate to be used as the transparent layer 3 is preliminarily coated with a sticky resin uniformly, and this is then made in close-contact onto the first dielectric layer 101.

After the first dielectric layer 101 has been formed, or after the transparent layer 3 has been formed, an initializing process in which the whole area of the recording layer 103 is crystallized may be carried out, if necessary. In the initializing process, the recording layer 103, which is in an amorphous state, is irradiated with, for example, a semiconductor laser so as to be heated to a temperature above the crystallizing temperature, and crystallized.

As described above, the information recording medium 11 of Fig. 1 is manufactured.

Next, the following description will discuss a manufacturing method for the information recording medium 12 of Fig. 2. After the recording layer 103 has been formed on the substrate 2 by using the same method as the manufacturing method of the information recording medium 11, the first dielectric layer 107 is formed on the recording layer 103. The first dielectric layer 107 is preferably formed by using a target made from a material containing no S, and is formed under the same conditions as those of the first dielectric layer 101 of Fig. 1. Successively, the transparent layer 3 is formed on the first dielectric layer 107. With respect to the processes of layers the reference numerals of which are the same as those in the information recording medium 11 of Fig. 1, the description thereof is omitted. In this manner, the information recording medium 12 of Fig. 2 is manufactured.

The following description will discuss a manufacturing method for the information recording medium 13 of Fig. 3. After the reflective layer 106 has been formed on the substrate 2 by using the same method as the manufacturing method of the information recording medium 11, the second dielectric layer 108 is formed on the reflective layer 106. The second dielectric layer 108 is preferably formed by using a target made from a material containing no S, and is formed under the same conditions as those of the second dielectric layer 105 of Fig. 1. Successively, the recording layer 103 is formed on the second dielectric layer 108. The first interface layer 102 and the first dielectric layer 101 are formed on the recording layer 103 in this order, and the transparent layer 3 is formed on the first dielectric layer 101. With respect to the manufacturing processes of layers the reference numerals of which are the same as those in the information recording medium 11 of Fig. 1, the description thereof is omitted. In this manner, the information recording medium 13 of Fig. 3 is manufactured.

### (Embodiment 2)

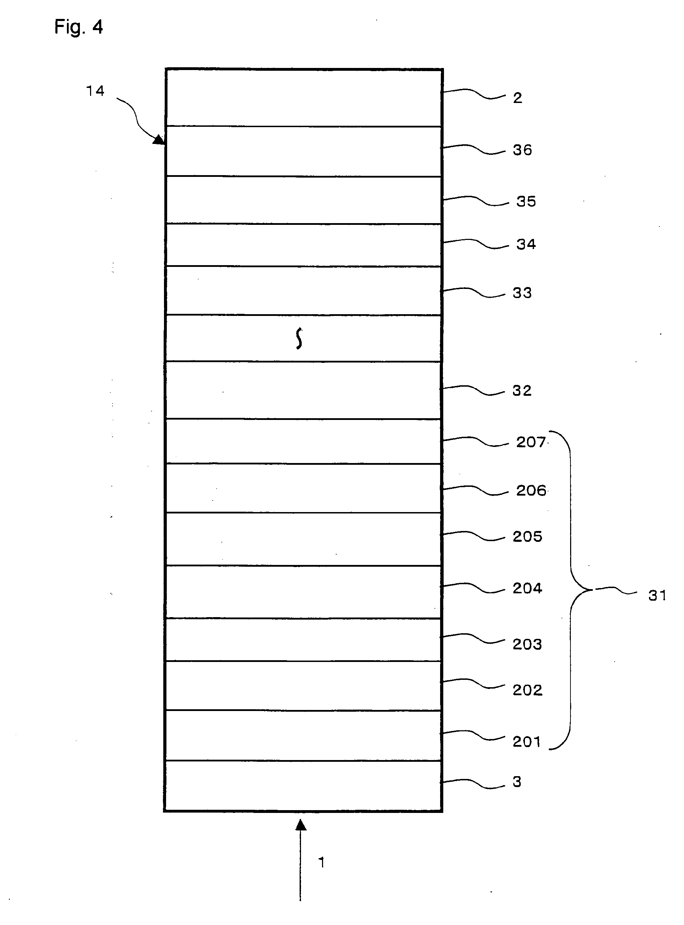

Embodiment 2 explains one example of an information recording medium of the present invention. Fig. 4 shows a partial cross-sectional view of an information recording medium 14 of Embodiment 2. This information recording medium 14 is a multilayer optical information recording medium that is capable of recording and reproducing information through irradiation of a laser beam 1 from one side of the faces.

The information recording medium 14 is constituted by N sets (N is a natural number satisfying N ≥ 2) of layers, that is, the N information layer 36, the (N - 1) information layer 34, the first information layer 31 and the transparent layer 3, which are successively laminated on the substrate 2 through optical separation layers 35, 33, 32, etc. Those information layers up to the (N - 1)-numbered layer counted from the light incident side of the laser beam 1 and those information layers from the first information layer 31 to the (N - 1) information layer 34 (hereinafter, the N-numbered information layer counted from the light-incident side of the laser beam 1 is referred to as "the N information layer") are information layers of a light transmitting type.

With respect to the materials for the substrate 2 and the transparent layer 3, the same materials as those explained in Embodiment 1 may be used. The shapes and functions of those materials are the same as the shapes and functions of those explained in Embodiment 1.

Optical separation layers 35, 33, 32, etc. , which are made from a resin, such as a photo-curable resin (in particular, ultraviolet-ray setting resin) and a slow-acting resin, or constituted by dielectric layers, are preferably made to have little light absorption with respect to the laser beam 1 and an optically small refractive index in a short wavelength range.

The optical separation layers 35, 33, 32, etc. are layers that are placed so as to distinguish respective focus positions of the first information layer 31, the (N - 1) information layer 34, the N information layer 36, etc. of the information recording medium 14. The thickness of each of the optical separation layers 35, 33, 32, etc. needs to be set to not less than the focal depth ΔZ that is determined by the numerical aperture NA of the objective lens and the wavelength λ of the laser beam 1. Supposing that the standard of the intensity of the focal point is 80% of that in the case of no aberration, ΔZ can be approximated by ΔZ = λ/{2(NA)²}. When λ = 400 nm and NA = 0.6, ΔZ = 0.556 µm holds, with a focal depth being set within ± 0.6 µm. In this case, the thickness of each of the optical separation layers 35, 33, 32, etc. needs to be 1.2 µm or more. The distances to the first information layer 31, the (N - 1) information layer 34, the N information layer 36, etc. are preferably set within a range that allows the laser beam 1 to be converged by using the objective lens. Therefore, the total thickness of the optical separation layers 35, 33, 32, etc. is preferably set within intersections (for example, 50 µm or less) that are allowed by the objective lens.

With respect to the substrate 2 and the optical separation layers 35, 33, 32, etc., guide grooves used for directing the laser beam 1 may be formed on the surface on the laser-beam incident side, if necessary. In the case when the laser beam 1 is directed only from one side, the K-numbered information layer (K is a natural number within 1 ≤ K ≤ N) can be recorded and reproduced by using a laser beam 1 that has transmitted through the first to the (K - 1) information layers.

At least any one of the layers from the first information layer 31 to the N information layer 36 may be prepared as an information layer of a ROM (Read Only Memory) type that is exclusively used for reproducing or as an information layer of a WO (Write Once) type that can be written only once.

The following description will discuss the structure of the first information layer 31 in detail.

The first information layer 31 is constituted by a first dielectric layer 201, a first interface layer 202, a first recording layer 203, a second interface layer 204, a second dielectric layer 205, a first reflective layer 206 and a transmittance adjusting layer 207 that are placed in succession from the light incident side of the laser beam 1.

The first dielectric layer 201 may be formed by using the same material as that of the first dielectric layer 101 of Embodiment 1. The functions thereof are the same as those of the first dielectric layer 101 of Embodiment 1.

Based upon calculations in accordance with the matrix method, the layer thickness of the first dielectric layer 201 can be precisely determined so as to satisfy conditions that make greater a change in the amounts of reflected light rays between the crystal portion and the amorphous portion of the first recording layer 203, as well as making greater the transmittance of the first information layer 31.

The same material as that of the first interface layer 102 of Embodiment 1 may be used for the first interface layer 202. The functions and shape thereof are the same as those of the first interface layer 102 of Embodiment 1.

The same material as that of the second interface layer 104 of Embodiment 1 may be used for the second interface layer 204. The functions and shape thereof are the same as those of the second interface layer 104 of Embodiment 1.

The same material as that of the second dielectric layer 105 of Embodiment 1 may be used for the second dielectric layer 205. The functions and shape thereof are the same as those of the second dielectric layer 105 of Embodiment 1.

The same material as that of the recording layer 103 of Embodiment 1 may be used for the first recording layer 203. With respect to the layer thickness of the first recording layer 203, since a laser beam having a quantity of light required for a recording or reproducing operation is allowed to reach information layers located farther from the first information layer 31 from the incident side of the laser beam 1 so as to read information, the first information layer 31 needs to have high light transparency. For this reason, it is necessary to make the first recording layer 203 thinner than 15 nm.

The same material as that of the reflective layer 106 of Embodiment 1 may be used for the first reflective layer 206. The functions thereof are the same as those of the reflective layer 106 of Embodiment 1. In order to make the transmittance of the first information layer 31 higher, the thickness of the first reflective layer 206 is preferably set in a range from 3 nm to 15 nm, more preferably in a range from 8 nm to 12 nm. By setting the thickness of the first reflective layer 206 within this range, a sufficient thermal diffusing function is provided, with a sufficient reflectance of the first information layer 31 being maintained; thus, the first information layer 31 is also allowed to have a sufficient transmittance.

The transmittance adjusting layer 207 is made from a dielectric material, and has a function for adjusting the transmittance of the first information layer 31. The transmittance adjusting layer 207 makes it possible to increase both of the transmittance Tc (%) of the first information layer in the crystal portion of the first recording layer 203 and the transmittance Ta (%) of the first information layer 31 in the amorphous portion of the first recording layer 203 to higher levels. More specifically, the first information layer 31 having the transmittance adjusting layer 207 is allowed to have a transmittance 2% to 10% higher than that in the case of no transmittance adjusting layer 207. The transmittance adjusting layer 207 also has a function for effectively diffusing heat generated in the first recording layer 203.

The refractive index n and the attenuation coefficient k of the transmittance adjusting layer 207 are preferably set to satisfy 2.0 ≤ n and k ≤ 0.1, more preferably 2.0 ≤ n ≤ 3.0 and k ≤ 0.05, so as to more effectively increase the transmittances Tc and Ta of the first information layer 31.

The layer thickness d of the transmittance adjusting layer 207 is preferably set within a range of (1/32)λ /n ≤ d ≤ (3/16)λ/n or (17/32)λ/n ≤ d ≤ (11/16)λ/n, more preferably within a range of (1/16)λ/n ≤ d ≤ (5/32)λ/n or (9/16)λ/n ≤ d ≤ (21/32)λ/n. Within this range, the reflectance Rc₁ in the crystal portion of the first recording layer 203 and the reflectance Ra₁ in the amorphous portion thereof are allowed to satisfy Rc₁ > Ra₁ so that recording and reproducing operations can be carried out stably, and the reflectance Rc₁ in the crystal portion is allowed to satisfy 2 ≤ Rc₁ ≤ 8. The above-mentioned range is preferably set within a range of 3 nm ≤ d ≤ 40 or 60 nm ≤ d ≤ 130 nm, more preferably within a range of 7 nm ≤ d ≤ 30 or 65 nm ≤ d ≤ 120 nm, by respectively selecting the wavelength λ of the laser beam 1 and the refractive index n of the transmittance adjusting layer 207, for example, in a range of 350 nm ≤ λ≤ 450 nm and in a range of 2.0 ≤ n ≤ 3.0. By selecting d within this range, it becomes possible to make both of the transmittances Tc and Ta of the first information layer 31 higher.

With respect to the transmittance adjusting layer 207, for example, oxides, such as TiO₂, ZrO₂, ZrO, Nb₂O₅, Ta₂O₅, SiO₂, Al₂O₃, Bi₂O₃, Cr₂O₃ and Sr-O, may be used. Nitrides, such as Ti-N, Zr-N, Nb-N, Ta-N, Si-N, Ge-N, Cr-N, Al-N, Ge-Si-N and Ge-Cr-N, may be used. Sulfides such as ZnS may also be used. Mixtures of the above-mentioned materials may also be used. Among these, in particular, TiO₂ and a material containing TiO₂ are preferably used. These materials have a great refractive index (n = 2.5 to 2.8) and also have a small attenuation coefficient (k = 0.0 to 0.05) so that the function of the first information layer 31 for increasing the transmittance is made greater.

The transmittances Tc and Ta of the first information layer 31 are preferably made to satisfy 40 < Tc and 40 < Ta, more preferably 46 < Tc and 46 < Ta, in order to allow laser light having a quantity required for a recording or reproducing operation to reach information layers located on the side opposite to the first information layer 31 with respect to the incident side of the laser beam 1.

The transmittances Tc and Ta of the first information layer 31 preferably satisfy - 5 ≤ (Tc - Ta) ≤ 5, more preferably - 3 ≤ (Tc - Ta) ≤ 3. In the case when Tc and Ta are allowed to satisfy this condition, upon recording or reproducing information on or from an information layer located on the side farther from the first information layer 31 from the light incident side of the laser beam 1, it becomes possible to minimize influences given to the change in the transmittance in the first information layer 31 from the first recording layer 203 depending on its state, and consequently to provide good recording or reproducing characteristics.

The reflectances Rc₁ and Ra₁ of the first recording layer 203 are preferably made to satisfy Ra₁ < Rcᵢ. With this arrangement, the reflectance is maintained in a high level in an initial state in which no information has been recorded so that it becomes possible to carry out a recording or reproducing operation stably. The reflectances Rc₁ and Ra₁ preferably satisfy 0.1 ≤ Ra₁ ≤ 5 and 4 ≤ Rc₁ ≤ 15, more preferably 0.1 ≤ Ra₁ ≤ 3 and 4 ≤ Rc₁ ≤ 10, in order to make the reflectance difference (Rc₁ - Ra₁) greater to consequently provide good recording and reproducing characteristics.

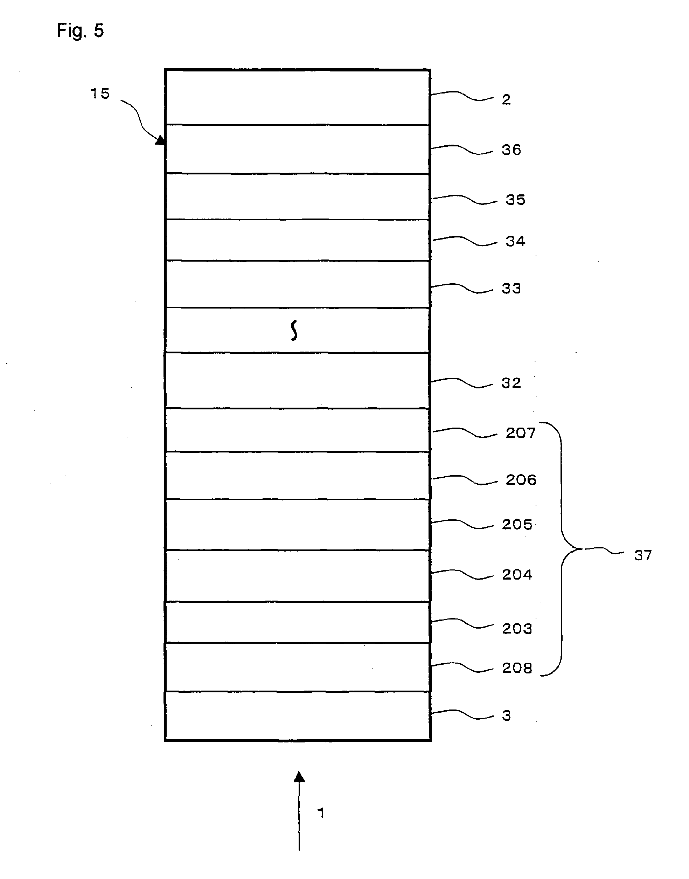

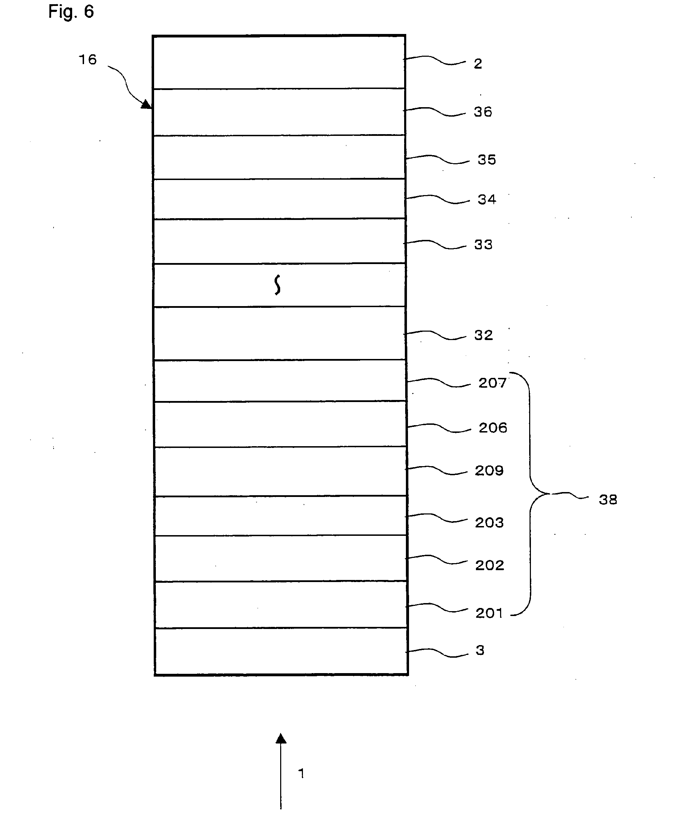

The first interface layer may be omitted, and in this case, as shown in the information recording medium 15 of Fig. 5, the first information layer 37 is constituted by a first dielectric layer 208, a first recording layer 203, a second interface layer 204, a second dielectric layer 205, a first reflective layer 206 and a transmittance adjusting layer 207 that are placed in this order from the light-incident side of the laser beam 1. In this case, the material of the first dielectric layer 208 is preferably designed so as not to contain S; thus, it becomes possible to prevent a substance transfer from occurring between the first dielectric layer 208 and the first recording layer 203 to cause a change in the composition of the recording layer. The second interface layer may be omitted, and in this case, as shown in the information recording medium 16 of Fig. 6, the first information layer 38 is constituted by a first dielectric layer 201, a first interface layer 202, a first recording layer 203, a second dielectric layer 209, a first reflective layer 206 and a transmittance adjusting layer 207 that are placed in this order from the light-incident side of the laser beam 1. In this case also, the second dielectric layer 209 is preferably designed so as not to contain S; thus, it becomes possible to prevent a substance transfer from occurring between the second dielectric layer 209 and the first recording layer 203 to cause a change in the composition of the recording layer.

The information recording medium 14 of Fig. 4, the information recording medium 15 of Fig. 5 and the information recording medium 16 of Fig. 6 are manufactured by using a method as described below.

First, the following description will discuss a manufacturing method for the information recording medium 14 shown in Fig. 4.

First, (N - 1) number of information layers are successively laminated on a substrate 2 (with a thickness of, for example, 1100 µm) through optical separation layers. The information layer is formed by a single-layer or a multilayer, and each of the layers is successively formed by sputtering a sputtering target that forms the corresponding material in a layer-forming device. The optical separation layer 35 is formed through processes in which a photo-curable resin (in particular, ultraviolet-ray setting resin) or a slow-acting resin is applied to the N information layer 36, and the substrate 2 is then rotated to uniformly expand the resin (spin coating) so that the resin is then cured. In the case when the optical separation layer 35 is provided with guide grooves for the laser beam 1, after a substrate (mold) in which grooves are formed is made in close-contact with the resin prior to curing, and the substrate 2 and the covered substrate (mold) are rotated so as to be spin-coated, and after the resin has been cured, the substrate (mold) is separated so that the guide grooves are formed.

In this manner, (N - 1) number of information layers are laminated on the substrate 2 through optical separation layers, and an optical separation layer 32 is then formed thereon.

Successively, the first information layer 31 is formed on the optical separation layer 32. More specifically, the substrate 2 on which first, (N - 1) number of information layers are laminated through optical separation layers and the optical separation layer 32 is then formed is placed in a layer-forming device so that a transmittance adjusting layer 207 is formed on the optical separation layer 32. The transmittance adjusting layer 207 is formed by sputtering a sputtering target made of a compound that forms the transmittance adjusting layer 207 in an Ar gas atmosphere or a mixed gas atmosphere of Ar gas and a reactive gas. The transmittance adjusting layer 207 may also be formed by reactive-sputtering a sputtering target made of metal that forms the transmittance adjusting layer in a mixed gas atmosphere of Ar gas and a reactive gas.

Next, the first reflective layer 206 is formed on the transmittance adjusting layer 207. The first reflective layer 206 is formed by using the same method as that of the reflective layer 106 of Fig. 1 explained in Embodiment 1.

Successively, the second dielectric layer 205 is formed on the first reflective layer 206. The second dielectric layer 205 is formed by using the same method as that of the second dielectric layer 105 of Fig. 1 explained in Embodiment 1.

Next, the second interface layer 204 is formed on the second dielectric layer 205. The second interface layer 204 is formed by using the same method as that of the second interface layer 104 of Fig. 1 explained in Embodiment 1.

Next, the first recording layer 203 is formed on the second interface layer 204. The first recording layer 203 is formed by using the same method as that of the recording layer 103 of Fig. 1 explained in Embodiment 1.

Successively, the first interface layer 202 is formed on the first recording layer 203. The first interface layer is formed by using the same method as that of the first interface layer 102 of Fig. 1 explained in Embodiment 1.

Next, the first dielectric layer 201 is formed on the first interface layer 202. The first dielectric layer 201 is formed by using the same method as that of the first dielectric layer 101 of Fig. 1 explained in Embodiment 1.

Successively, the transparent layer 3 is formed on the first dielectric layer 201. The transparent layer 3 is formed by using the same method as that of the transparent layer 3 of Fig. 1 explained in Embodiment 1.

After the first dielectric layer 201 has been formed, or after the transparent layer 3 has been formed, an initializing process in which the entire area of the first recording layer 203 is crystallized may be carried out, if necessary.

In this manner, the information recording medium 14 of Fig. 4 is manufactured.

The following description will discuss a manufacturing method for the information recording medium 15 of Fig. 5. After the layers up to the recording layer 203 have been formed on the substrate 2 by using the same method as the manufacturing method of the information recording medium 14 of Fig. 4, the first dielectric layer 208 is formed on the recording layer 203. The first dielectric layer 208 is preferably formed by using a target made from a material containing no S, and is formed under the same conditions as those of the first dielectric layer 201 of Fig. 4. In this manner, the information recording medium 37 is manufactured. Successively, the transparent layer 3 is formed on the first information layer 37. With respect to the same parts that are indicated by the same reference numerals as the information recording medium 14 of Fig. 4, the repetitive description thereof is omitted. In this manner, the information recording medium 15 of Fig. 5 is manufactured.

The following description will discuss a manufacturing method for the information recording medium 16 of Fig. 6. After the layers up to the first reflective layer 206 have been formed on the substrate 2 by using the same method as the manufacturing method of the information recording medium 14 shown in Fig. 4, the second dielectric layer 209 is formed on the first reflective layer 206. The second dielectric layer 209 is preferably formed by using a target made from a material containing no S, and is formed under the same conditions as those of the second dielectric layer 205 of Fig. 4. Successively, the recording layer 203 is formed on the second dielectric layer 209. Next, the first interface layer 202 and the first dielectric layer 201 are formed on the recording layer 203 in this order. In this manner, the first information layer 38 is formed. Successively, the transparent layer 3 is formed on the first information layer 38. With respect to the same layers that are indicated by the same reference numerals as the information recording medium 14 of Fig. 4, the repetitive description of the manufacturing processes is omitted. In this manner, the information recording medium 16 of Fig. 6 is manufactured.

### (Embodiment 3)

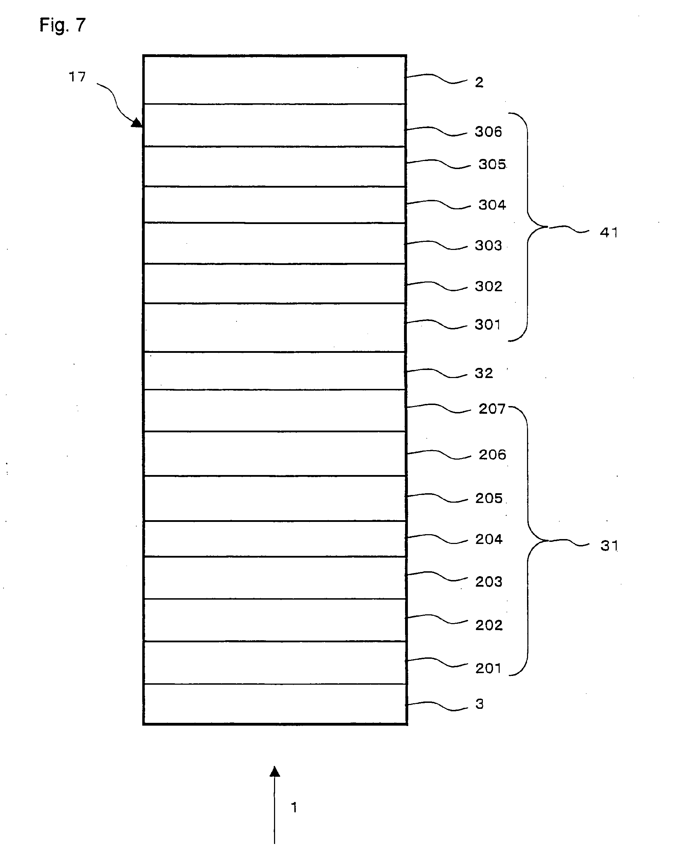

Embodiment 3 explains one example of an information recording medium in which, N = 2 holds in the multilayer optical information recording medium of Embodiment 2 in the present invention, that is, a structure in which the information recording medium is constituted by two sets of information layers. Fig. 7 shows one portion of a cross-sectional view of the information recording medium 17 of Embodiment 3. The information recording medium 17 is a two-layered optical information recording medium 14 that is capable of recording and reproducing information through irradiation of a laser beam 1 from one side of the faces.

The information recording medium 17 is constituted by a second information layer 41, an optical separation layer 32, a first information layer 31 and a transparent layer 3 that are successively laminated on the substrate 2. With respect to the substrate 2, the optical separation layer 32, the first information layer 31 and the transparent layer 3, the same materials as explained in Embodiment 2 can be used. The shapes and functions of those layers are the same as those explained in Embodiment 2.

The following description will discuss the structure of the second information layer 41 in detail.

The second information layer 41 is provided with a third dielectric layer 301, a third interface layer 302, a second recording layer 303, a fourth interface layer 304, a fourth dielectric layer 305 and a second reflective layer 306 that are placed in this order from the light incident side of the laser beam 1. A recording or reproducing operation is carried out on the second information layer 41 by a laser beam 1 that has transmitted through the transparent layer 3, the first information layer 31 and the optical separation layer 32.

With respect to the third dielectric layer 301 and the fourth dielectric layer 305, the same materials as those of the first dielectric layer 101 and the second dielectric layer 105 in Embodiment 1 can be used. The functions thereof are the same as those of the first dielectric layer 101 and the second dielectric layer 105 of Embodiment 1. Based upon calculations in accordance with the matrix method, the layer thicknesses of the third dielectric layer 301 and fourth dielectric layer can be precisely determined so as to satisfy conditions that make greater a change in the amounts of reflected light rays between the crystal portion and the amorphous portion of the second recording layer 303.

With respect to the third interface layer 302 and the fourth interface layer 304, the same materials as those of the first interface layer 102 and the second interface layer 104 of Embodiment 1 can be used. The functions and shapes thereof are the same as those of the first interface layer 102 and the second interface layer 104 of Embodiment 1.

With respect to the second recording layer 203, the same material as that of the recording layer 103 of Embodiment 1 can be used. The layer thickness thereof is the same as the layer thickness of the recording layer 103 of Embodiment 1.

With respect to the second reflective layer 306, the same materials as that of the reflective layer 106 of Embodiment 1 can be used. The functions and shape thereof are the same as those of the reflective layer 106 of Embodiment 1.

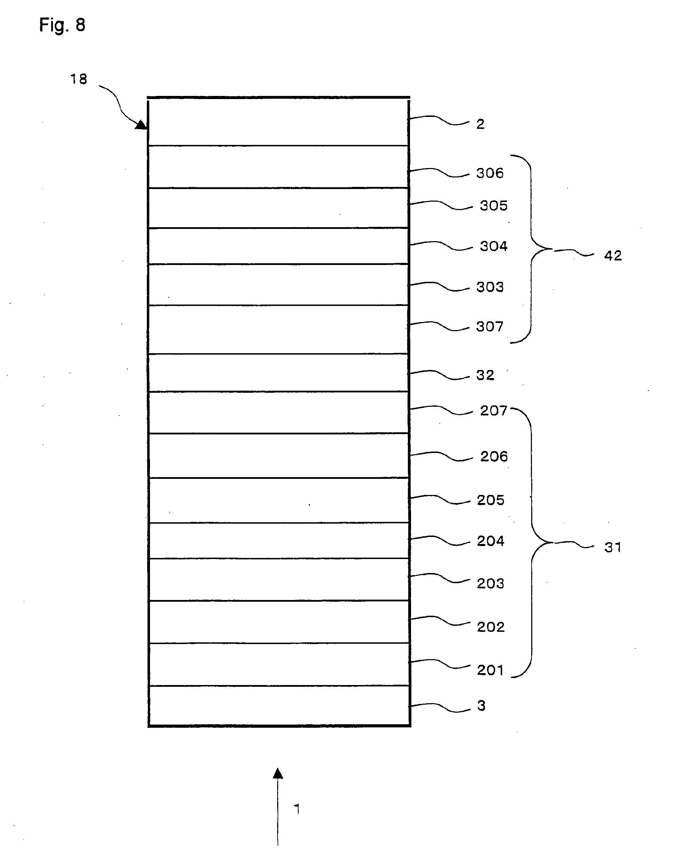

The third interface layer may be omitted, and as shown in the information recording medium 18 of Fig. 8, the second information layer 42 is constituted by a third dielectric layer 307, a second recording layer 303, a fourth interface layer 304, a fourth dielectric layer 305 and a second reflective layer 306 that are placed in this order from the light-incident side of the laser beam 1. In the case when no third interface layer is placed between the third dielectric layer 307 and the second recording layer 303, preferably, the material of the third dielectric layer 307 does not contain S so as to prevent a substance transfer from occurring between the third dielectric layer 307 and the second recording layer 303 to cause a change in the composition of the recording layer. In this case, in the first information layer 31, at least either one of the first interface layer and the second interface layer may be omitted.

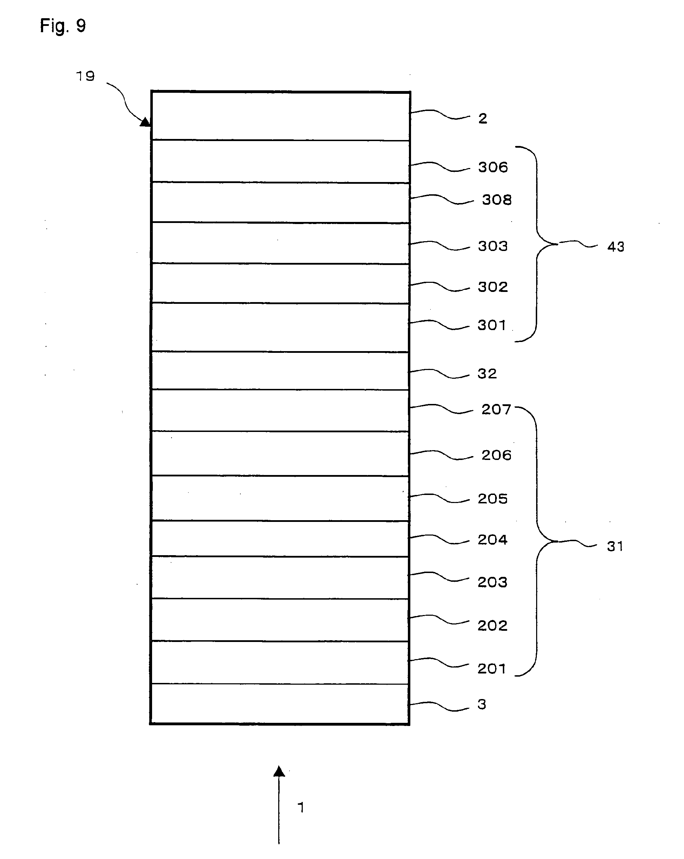

The fourth interface layer may be omitted, and as shown in the information recording medium 19 of Fig. 9, the second information layer 43 is constituted by a third dielectric layer 301, a third interface layer 302, a second recording layer 303, a fourth dielectric layer 308 and a second reflective layer 306 that are placed in this order from the light-incident side of the laser beam 1. In the case also, preferably, the fourth dielectric layer 308 does not contain S so as to prevent a substance transfer from occurring between the fourth dielectric layer 308 and the second recording layer 303 to cause a change in the composition of the recording layer. In this case, in the first information layer 31, at least either one of the first interface layer and the second interface layer may be omitted. The third interface layer and the fourth interface layer may be omitted.

The information recording medium 17 of Fig. 7, the information recording medium 18 of Fig. 8 and the information recording medium 19 of Fig. 9 can be manufactured by methods as explained below.

First, the following description will discuss the manufacturing method of the information recording medium 17 of Fig. 7.

The second information layer 41 is first formed on the substrate 2. More specifically, first, a substrate 2 (having a thickness of, for example, 1100 µm) is prepared and placed in a layer-forming device.

Next, the second reflective layer 306 is formed on the substrate 2. At this time, in the case when guide grooves used for directing a laser beam 1 are formed on the substrate 2, the second reflective layer 306 is formed on the side on which the guide grooves are formed. The second reflective layer 306 is formed by using the same method as that of the reflective layer 106 explained in Embodiment 1.

Next, the fourth dielectric layer 305 is formed on the second reflective layer 306. The fourth dielectric layer 305 is formed by using the same method as that of the second dielectric layer 105 of Fig. 1 explained in Embodiment 1.

Successively, the fourth interface layer 304 is formed on the fourth dielectric layer 305. The fourth interface layer 304 is formed by using the same method as that of the fourth interface layer 104 of Fig. 1 explained in Embodiment 1.

Next, the second recording layer 303 is formed on the fourth interface layer 304. The second recording layer is formed by using the same method as that of the recording layer 103 of Fig. 1 explained in Embodiment 1.

Successively, the third interface layer 302 is formed on the second recording layer 303. The third interface layer 302 is formed by using the same method as that of the first interface layer 102 of Fig. 1 explained in Embodiment 1.

Next, the third dielectric layer 301 is formed on the third interface layer 302. The third dielectric layer 301 is formed by using the same method as that of the first dielectric layer 101 of Fig. 1 explained in Embodiment 1.

In this manner, the second information layer 42 is formed.

Next an optical separation layer 32 is formed on the third dielectric layer 301 of the second information layer 41. The optical separation layer 32 is formed through processes in which a photo-curable resin (in particular, ultraviolet-ray setting resin) or a slow-acting resin is applied to the third dielectric layer 301 so as to be spin-coated with the resin, and the resin is then cured. In the case when the optical separation layer 32 is provided with guide grooves for the laser beam 1, after a substrate (mold) in which grooves are formed is made in close-contact with the resin prior to curing, and after the resin has been cured, the substrate (mold) is separated so that the guide grooves are formed.

After the third dielectric layer 301 has been formed or the optical separation layer 32 has been formed, an initializing process in which the whole area of the second recording layer 303 is crystallized may be carried out, if necessary.

Successively, the first information layer 31 is formed on the optical separation layer 32. More specifically, a transmittance adjusting layer 207, a first reflective layer 206, a second dielectric layer 205, a second interface layer 204, a first recording layer 203, a first interface layer 202 and a first dielectric layer 201 are formed on the optical separation layer 32 in this order. With respect to the manufacturing processes of the layers that have the same reference numerals as those of the information recording medium 14, those layers can be respectively formed by using the methods explained in Example 2.

Lastly, the transparent layer 3 is formed on the first dielectric layer 201. The transparent layer 3 can be formed by using the same method as explained in Embodiment 1.

After the first dielectric layer 201 has been formed or after the transparent layer 3 has been formed, an initializing process in which the whole area of the first recording layer 203 is crystallized may be carried out, if necessary. After the first dielectric layer 201 has been formed, or after the transparent layer 3 has been formed, an initializing process in which the whole areas of the second recording layer 303 and the first recording layer 203 are crystallized may be carried out, if necessary. In the case when the crystallizing process of the first recording layer 203 is carried out first, since the transmittance of the first recording layer 203 is lowered, the laser power required for crystallizing the second recording layer 303 tends to become larger. In particular, when a red laser is used for the initializing process, the reduction in the transmittance due to the crystallization becomes greater. For this reason, it is preferable to crystallize the second recording layer 303 first.

As described above, the information recording medium 17 of Fig. 7 is manufactured. With respect to the first information layer of the information recording medium 17, the first information layer 37 of Fig. 5 or the first information layer 38 of Fig. 6 may be used in place of the first information layer 31.

The following description will discuss the information recording medium 18 of Fig. 8. The layers up to the second recording layer 303 are formed on the substrate 2 by using the same method as the manufacturing method of the information recording medium 17 of Fig. 7. Next, the third dielectric layer 307 is formed on the second recording layer 303. The third dielectric layer 307 is preferably formed by using a target made from a material containing no S, and is formed under the same conditions as those of the first dielectric layer 101 of Fig. 1 as explained in Embodiment 1. In this manner, the second information layer 42 is formed. Successively, the optical separation layer 32 is formed on the second information layer 42. Then, the first information layer 31 is formed on the optical separation layer 32. With respect to the processes of those layers having the same reference numerals as those of the information recording medium 14 of Fig. 4, the description thereof is omitted. In this manner, the information recording medium 18 of Fig. 8 is manufactured. With respect to the first information layer of the information recording medium 18, the first information layer 37 of Fig. 5 or the first information layer 38 of Fig. 6 may be used in place of the first information layer 31.

The following description will discuss a manufacturing method for the information recording medium 19 of Fig. 9. After the layers up to the second reflective layer 306 have been formed on the substrate 2 by using the same method as the manufacturing method of the information recording medium 17 shown in Fig. 7, the fourth dielectric layer 308 is formed on the second reflective layer 306. The fourth dielectric layer 308 is preferably formed by using a target made from a material containing no S, and is formed under the same conditions as those of the second dielectric layer 105 of Fig. 1 explained Embodiment 1. Next, the recording layer 303 is formed on the fourth dielectric layer 308. The third interface layer 302 and the third dielectric layer 301 are formed on the recording layer 303 in this order. Thus, the second information layer 43 is formed. Next, the optical separation layer 32 is formed on the second information layer 43, and the first information layer 31 is formed on the optical separation layer 32. With respect to the manufacturing processes for the layers having the same reference numerals as those of the information recording medium 14 of Fig. 4, the description thereof is omitted. Thus, the information recording medium 19 of Fig. 9 is manufactured. With respect to the first information layer of the information recording medium 19, the first information layer 37 of Fig. 5 or the first information layer 38 of Fig. 6 may be used in place of the first information layer 31.

### (Embodiment 4)

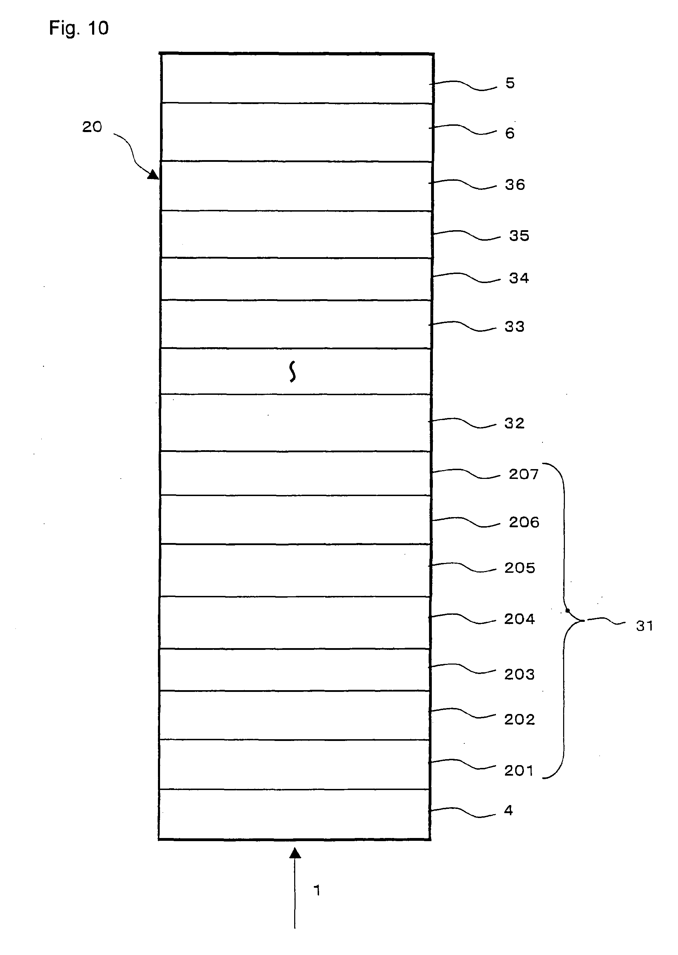

Embodiment 4 explains one example of an information recording medium of the present invention. Fig. 10 shows a partial cross-sectional view of an information recording medium 20 of Embodiment 4. In the same manner as the information recording medium 14 of Embodiment 2, this information recording medium 20 is a multilayer optical information recording medium that is capable of recording and reproducing information through irradiation of a laser beam 1 from one side of the faces.

The information recording medium 20 is constituted by N sets of information layers, that is, a first information layer 31, the (N - 1) information layer 34 and the N information layer 36, which are successively laminated on the substrate 4 through optical separation layers 32, 33, 35, etc., and a dummy substrate 5 that is made in close-contact thereon through a bonding layer 6.

Both of the substrate 4 and the dummy substrate 5 are transparent disc-shaped substrates in the same manner as the substrate 4. The substrate 4 and the dummy substrate 5 are made from, for example, a resin, such as polycarbonate, amorphous polyolefin and PMMA, or glass.

Guide grooves to be used for directing the laser beam 1 may be formed on the surface of the substrate 4 on the first dielectric layer 201 side on demand. The surface on the side opposite to the first dielectric layer 201 of the substrate is preferably formed into a smooth face. With respect to the material for the substrate 4 and the dummy substrate 5, in particular, polycarbonate is effectively used because of its superior copying property and mass-productivity and low costs. With respect to the thickness of the substrate 4, it is preferably set in a range from 500 µm to 1200 µm so as to achieve sufficient strength of the substrate 4 and allow the information recording medium 20 to have a thickness of about 1200 µm.

The first information layer 31 formed on the substrate 4 is indicated by the same reference numerals as those of the information recording medium 14 of Fig. 4, and the description thereof is omitted.

The bonding layer 6 is made from a resin such as a photocurable resin (in particular, an ultraviolet-ray-setting resin) and a slow-acting resin, and is preferably made to have little light absorbing property to the laser beam 1 to be used, with a small optical birefringence in a short wavelength range.

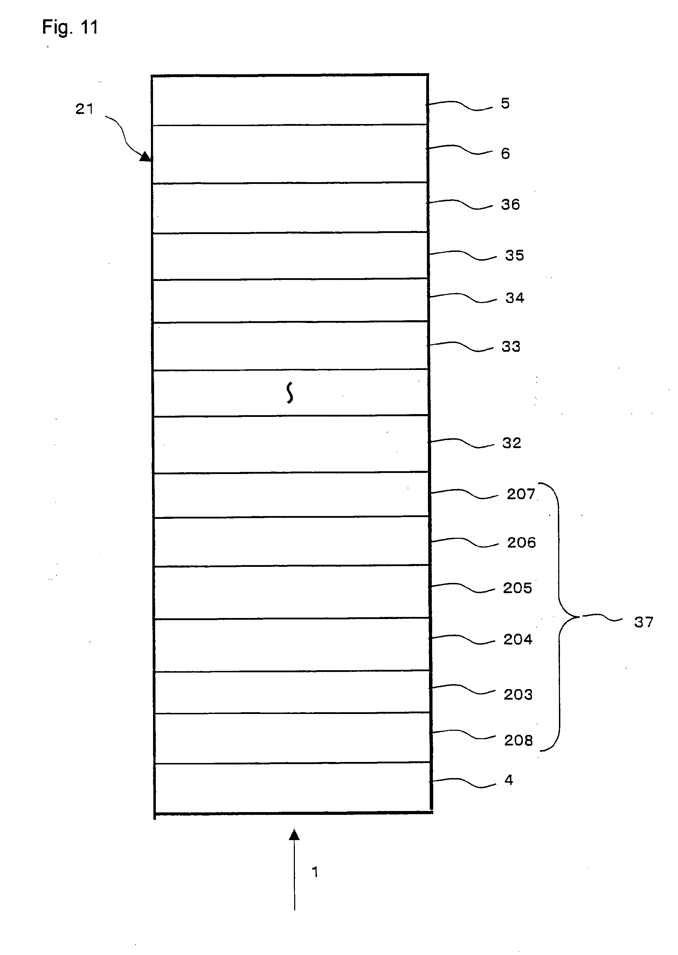

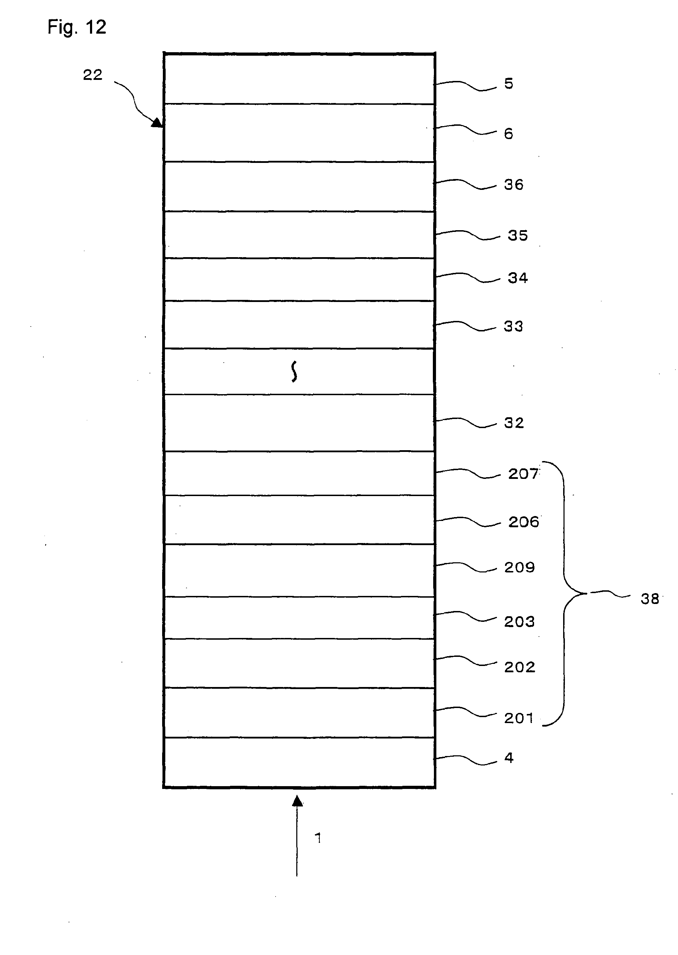

The first interface layer 202 may be omitted, or as shown in the information recording medium 21 of Fig. 11, the first information layer 37 of Fig. 5 may be used as the first information layer 31. The second interface layer 204 may be omitted, and as shown in the information recording medium 22 of Fig. 12, the first information layer 38 of Fig. 6 may be used as the first information layer 31.

The following description will discuss manufacturing methods for the information recording medium 20 of Fig. 10, the information recording medium 21 of Fig. 11 and the information recording medium 22 of Fig. 12.

First, the manufacturing method for the information recording medium 20 of Fig. 10 is explained.

The first information layer 31 is first formed on the substrate 4 (having a thickness of, for example, 600 µm). At this time, in the case when guide grooves used for directing a laser beam 1 are formed on the substrate 4, the first information layer 31 is formed on the side on which the guide grooves are formed. More specifically, with the substrate 4 being placed inside a layer-forming device, layer-forming processes are carried out in the order reversed to that of the information recording medium 14 of Fig. 4 explained in Embodiment 2. With respect to the first information layer 31, the first dielectric layer 201, the first interface layer 202, the first recording layer 203, the second interface layer 204, the second dielectric layer 205, the first reflective layer 206 and the transmittance adjusting layer 207 are successively formed on the substrate 4 in this order to prepare the first information layer 31. Thereafter, (N - 1) number of information layers are successively laminated thereon through optical separation layers. The information layer is formed by a single-layer or multilayer, and each of the layers is successively formed by sputtering a sputtering target that forms the corresponding material in a layer-forming device.

Lastly, the N information layer 36 and the dummy substrate 5 are bonded to each other by using a bonding layer 6. More specifically, the layers are bonded through processes in which a resin, such as a photocurable resin (in particular, ultraviolet-ray-setting resin) and a slow-acting resin, is applied to the information layer 36, and a spin-coating process is carried out with the dummy substrate 5 being made in close-contact onto the information layer 36, and the resin is then cured. Alternatively, a sticky resin is preliminarily applied to the dummy substrate 5 uniformly, and the information layer 36 may be made in close-contact therewith.

After the dummy substrate 5 has been bonded thereto, an initializing process in which the whole area of the first recording layer 203 is crystallized may be carried out, if necessary.

Thus, the information recording medium 20 of Fig. 10 is manufactured.

As shown in the information recording medium 21 of Fig. 11, the first information layer 31 of Fig. 10 may be replaced by the first information layer 37 of Fig. 5. As shown in the information recording medium 22 of Fig. 12, the first information layer 31 of Fig. 10 may be replaced by the first information layer 38 of Fig. 6.

### (Embodiment 5)

Embodiment 5 explains a recording/reproducing method for the information recording medium of the present invention that has been discussed in Embodiments 1, 2, 3 and 4.

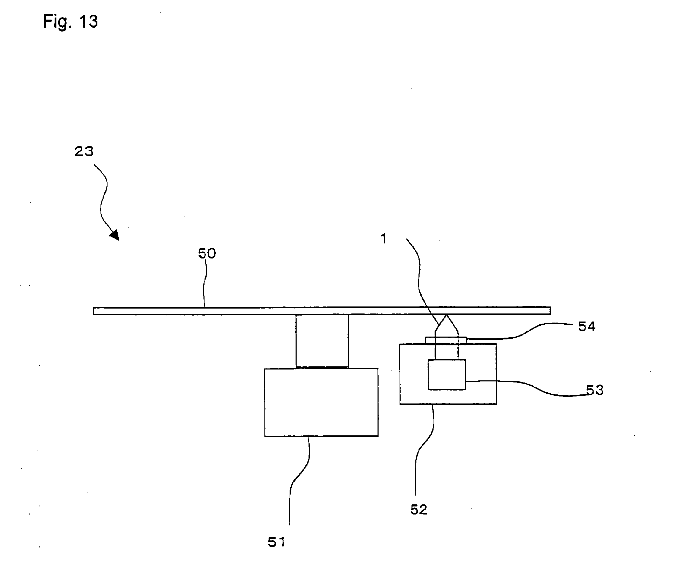

Fig. 13 schematically shows one portion of the structure of a recording/reproducing device 23 to be used in the recording/reproducing method of the present invention. As shown in Fig. 13, the recording/reproducing device 23 is provided with a spindle motor 51 to be used for rotating an information recording medium 50, an optical head 52 having a semiconductor laser 53 and an objective lens 54 that converges a laser beam 1 released from the semiconductor laser 53. The information recording medium 50, which is each of the information recording media that have been explained in Embodiments 1, 2, 3 and 4, is provided with a single information layer or a plurality of information layers (for example, the first information layer 31, the second information layer 41). The objective lens 54 converges the laser beam 1 onto the information layer.

The recording, erasing and overwrite recording operations of information on and from the optical information recording medium are carried out by modulating the power of the laser beam 1 between a peak power (Pp (mW)) with high power and a bias power (Pb (mW)) with low power. By directing a laser beam 1 with the peak power onto the recording layer, a recording mark is formed at the irradiated portion. Between the recording marks, upon irradiation with the laser beam 1 with bias power, the recording mark is allowed to have a crystal phase so that an erased portion (mark gap) is formed. In the case when the laser beam 1 with peak power is directed, so-called multi-pulses, formed by using pulse strings, are generally used. The multi-pulses may be modulated by using only the power levels of peak power and bias power, or may be modulated by using power levels within a peak power range of 0 mW to peak power.

A power level that is lower than any of peak power and bias power and gives no influences to the optical condition of recording marks even upon irradiation of a laser beam 1 in that power level to provide a sufficient quantity of reflected light required for reproducing the recording mark from the optical information recording medium is defined as a reproducing power (Pr (mW)), and by directing the laser beam 1 with the reproducing power thereto, the resulting signal obtained from the optical information recording medium is detected by a detecting device so that a reproducing process of an information signal is carried out.

The wavelength of the laser beam 1 is preferably set to 700 nm or less, and is more preferably set in a range from 350 to 450 nm in order to achieve high density. The numerical aperture NA of the objective lens 54 is preferably set within a range from 0.5 to 1.1, more preferably from 0.6 to 1.0, in the case when a purple-blue laser beam is used. For example, in an information recording medium with a 25 GB density in which the purple-blue laser beam is used to carry out a recording/reproducing operation, upon recording information, the linear velocity of the optical information recording medium may be set to about 10 m/sec so as to carry out the recording/reproducing operation. This arrangement makes it possible to achieve a transfer rate of 70 Mbps.

With respect to the information recording medium 17, the information recording medium 18 and the information recording medium 19 that have two information layers, upon carrying out a recording process on the first information layer 31, information is recorded on the first recording layer 203 by using a laser beam 1 that has transmitted through the transparent layer 3, with the focal point of the laser beam 1 being set onto the first recording layer 203. A reproducing operation is carried out by using a laser beam 1 that has been reflected by the first recording layer 203, and transmitted through the transparent layer 3. Upon carrying out a recording operation onto the second information layer 41, 42 or 43, information is recorded by using a laser beam 1 that has transmitted through the transparent layer 3, the first information layer 31 and the optical separation layer 32 with the focal point of the laser beam 1 being set onto the second recording layer 41, 42 or 43. A reproducing operation is carried out by using a laser beam 1 that has been reflected by the second recording layer 303, and transmitted through the optical separation layer 32, the first information layer 31 and the transparent layer 3.

For example, in the information recording medium 14 of Fig. 4, in the case when guide grooves used for directing the laser beam 1 to the substrate 2, the optical separation layers 32, 33 and 35 are formed, the information may be recorded in a groove gap (groove) on the side closer to the laser beam 1 or may be recorded on a groove top (land) on the side farther from the laser beam 1. Alternatively, information may be recorded on both of the groove and the land.

The recording performance is evaluated by carrying out processes in which: power of the laser beam 1 is modulated between these Pp and Pb so that random signals having mark lengths from 0.149 µm (2T) to 0.596 µm (8T) are recorded in the (1 - 7) modulation system, and jitters between the front ends as well as between the rear ends are measured by using a time interval analyzer.

### (Embodiment 6)

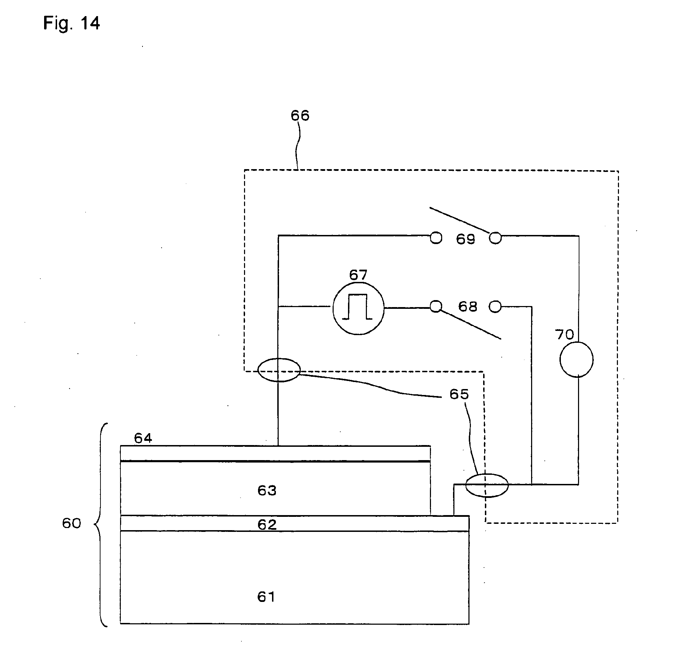

Embodiment 6 explains an information recording medium shown in Fig. 14 as one example of the information recording medium of the present invention. The information recording medium 60 is an electric information recording medium which is capable of recording and reproducing information upon application of electric current.

With respect to the material for the substrate 61, a resin substrate such as polycarbonate, a glass substrate, a ceramic substrate such as Al₂O₃, a Si substrate and various metal substrates such as Cu substrates may be used. The present embodiment exemplifies a case in which a Si substrate is used as one example of the substrate 61. The information recording medium 60 has a structure in which a lower electrode 62, the recording layer 63 of the present invention and an upper electrode 64 are successively laminated on the substrate 61. The lower electrode 62 and the upper electrode 64 are formed so as to apply an electric current to the recording layer 63 of the present invention.

The recording layer 63 of the present invention is made from a material which can phase-change reversibly between the crystal portion and the amorphous portion by Joule heat generated upon application of an electric current, and a phenomenon in which resistivity changes between the crystal portion and the amorphous portion is utilized for recording information. The same material as the recording layer 103 of Embodiment 1 may be used as the material of the recording layer 63 of the present invention, and the recording layer 63 of the present invention can be formed by using the same method as that of the recording layer 103 of Embodiment 1.

With respect to the materials for the lower electrode 62 and the upper electrode 64, a simple substance metal material such as Al, Au, Ag, Cu and Pt or an alloy material, mainly composed of one or a plurality of elements of these to which one or a plurality of other elements are appropriately added so as to improve the moisture resistance or adjust the thermal conductivity, may be used. The lower electrode 62 and the upper electrode 64 can be formed by sputtering a metal base material or an alloy base material to form the corresponding material in an Ar gas atmosphere.

The electric information recording/reproducing device 66 is electrically connected to the information recording medium 60 through an applying unit 65. The electric information recording/reproducing device 66 allows a pulse current 67 for applying an electric current pulse to the recording layer 63 of the present invention to flow between the lower electrode 62 and the upper electrode 64 through a switch 68. In order to detect a change in the resistance value due to a phase change in the recording layer 63 of the present invention, a resistance measuring device 70 is connected across the lower electrode 62 and the upper electrode 64 through a switch 69. In order to make a change from the amorphous phase (high-resistance state) to the crystal phase (low-resistance state) in the recording layer 63 of the present invention, an electric current pulse is applied between the electrodes, with the switch 68 being closed (with the switch 69 being open), so that the temperature of the portion to which the electric current pulse is applied is maintained at a temperature that is higher than the crystallizing temperature of the material, and lower than the melting point thereof for a crystallizing time. When the crystal phase is returned to the amorphous phase, an electric current pulse, which is relatively higher than that at the time of crystallizing, is applied for a shorter time so that the recording layer 63 of the present invention is heated to a temperature higher than the melting point to be fused, and then rapidly cooled.

Supposing that the resistance value is rₐ when the recording layer 63 of the present invention is in the amorphous phase and that the resistance value is r_{c} when the recording layer 63 of the present invention is in the crystal phase, rₐ > r_{c} holds. Therefore, by measuring the resistance value between the electrodes using a resistance measuring device 70, two different states, that is, information of a single value, can be detected.

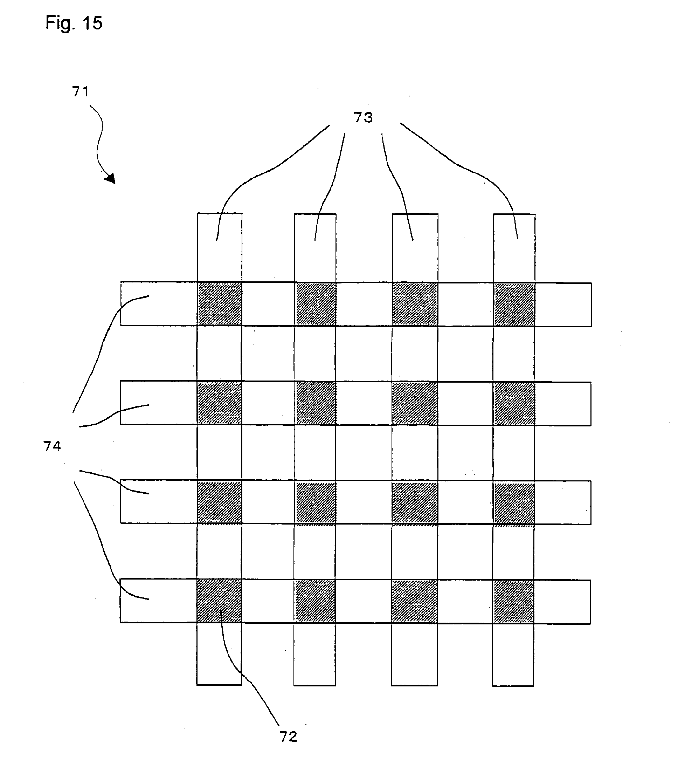

By placing a number of these information recording media 60 in a matrix format, an electric information recording medium 71 with a large capacity is formed, as shown in Fig. 15. Each of memory cells 72 has the same structure as the information recording medium 60 in a fine area. The information recording/reproducing operation is carried out on each memory cell 72 by specifying one of the word lines 73 and one of the bit lines 74 respectively.

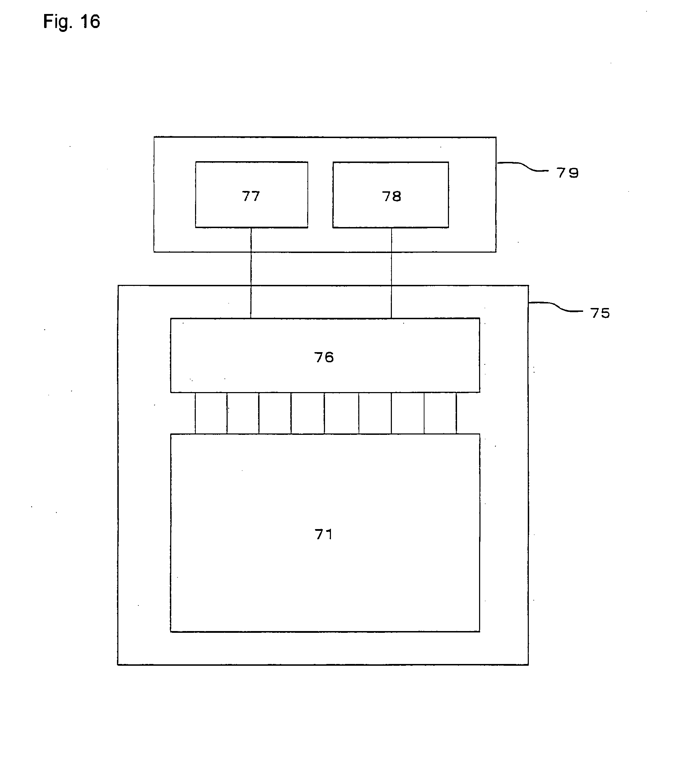

Fig. 16 shows a structural example of an information recording system in which the electric information recording media 71 are used. A memory device 75 is constituted by the electric information recording media 71 and an address specifying circuit 76. A word line 73 and a bit line 74 of each electric information recording medium 71 are respectively specified by the address specifying circuit 76 so that an information recording/reproducing process is carried out on each of the memory cells 72. The memory device 75 is electrically connected to an external circuit 79 constituted by at least a pulse power supply 77 and a resistance measuring device 78 so that an information recording/reproducing process is carried out on the electric information recording medium 71.

### (Embodiment 7)

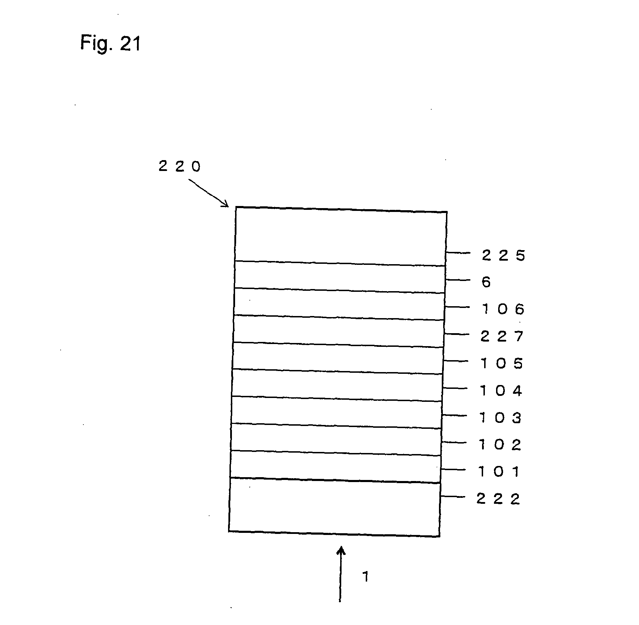

Embodiment 7 explains one example of an information recording medium in accordance with the present invention. Fig. 21 is a cross-sectional view that shows one portion of an information recording medium 220 of Embodiment 7. The information recording medium 220 is an optical information recording medium which is capable of recording and reproducing information upon irradiation with a laser beam 1, and used for a DVD-RAM medium.

The information recording medium 220 is constituted by a first dielectric layer 101, a first interface layer 102, a recording layer 103, a second interface layer 104, a second dielectric layer 105, a light absorption-correcting layer 227, a reflective layer 106, a bonding layer 6 and a dummy substrate 225 that are successively laminated on a substrate 222.

The laser beam 1 is made incident on the substrate 222 side, and in the present embodiment, the laser beam 1 having a wavelength of about 660 nm may be used.

Polycarbonate may be used as the material for the substrate 222 in the same manner as the substrate 2 of Embodiment 1, and in the present embodiment, such a substrate having a thickness of about 600 µm is preferably used. Guide grooves made of lands and trenches may be formed on the substrate 222, if necessary, and the groove face that is closer when viewed from the laser beam 1 is defined as the groove and the groove face that is farther when viewed from the laser beam 1 is defined as the land.

The first dielectric layer 101 has the same functions as those of Embodiment 1, and the same material may be used as the material thereof. When, for example, ZnS-SiO₂ is used based upon calculations through the matrix method, the layer thickness thereof is preferably set in a range from 100 nm to 160 nm in the present embodiment.

The first interface layer 102 and the second interface layer 104 have the same functions as those of Embodiment 1, and the same materials may be used as the materials thereof. In the same manner, the layer thickness is preferably set in a range from 1 nm to 10 nm.

In the same manner as Embodiment 1, the recording layer 103 of the present invention may be made from a material containing Ge, Te, M1, M2 and M3, and the layer thickness thereof is preferably set in a range from 6 nm to 12 nm.

The second dielectric layer 105 has the same functions as those of Embodiment 1, and the same material may be used as the material thereof. When, for example, ZnS-SiO₂ is used based upon calculations through the matrix method, the layer thickness thereof is preferably set in a range from 20 nm to 60 nm in the present embodiment.

The light absorption-correcting layer 227 adjusts the ratio Ac/Aa, that is, a ratio between the light absorbing rate Ac of the recording layer 103 when the recording layer 103 is in the crystal state and the light absorbing rate Aa of the recording layer 103 when it is in the amorphous state so that it exerts a function for preventing the mark shape from distorting upon rewriting information. The light absorption-correcting layer 227 is preferably made from a material that has a high refractive index and properly absorbs light. For example, the light absorption-correcting layer 227 is preferably made from a material that has a refractive index n from 3 or more to 6 or less and a attenuation coefficient k from 1 or more to 4 or less with respect to a laser light beam having a wavelength of about 660 nm. More specifically, the material is preferably selected from an amorphous Ge alloy such as Ge-Cr and Ge-Mo, an amorphous Si alloy such as Si-Cr, Si-Mo and Si-W, Te-modified compound and a crystalline metal, semi-metal and semiconductor material, such as Ti, Zr, Nb, Ta, Cr, Mo, W, SnTe and PbTe. The layer thickness of the light absorption-correcting layer 227 is preferably set in a range from 10 nm to 60 nm, more preferably from 20 nm to 50 nm.

The reflective layer 106 has the same functions as those of Embodiment 1, and the same material may be used as the material thereof. In the same manner, the layer thickness is preferably set in a range from 30 nm to 200 nm, more preferably from 50 to 160 nm.

The bonding layer 6 is placed so as to bond the dummy substrate 225 to the reflective layer 106. The bonding layer 6 may be formed by using a material that has high heat resistance and adhesive property, for example, a bonding resin such as an ultraviolet-ray setting resin. More specifically, the bonding layer 6 may be formed by using a material that is mainly composed of acrylic resin or a material that is mainly composed of epoxy resin. Prior to the formation of the bonding layer 6, a protective layer having a thickness in a range from 5 to 20 µm, made from an ultraviolet-ray setting resin, may be formed on the surface of the reflective layer 106. The thickness of the bonding layer 6 is preferably set in a range from 15 to 40 µm, more preferably from 20 to 35 µm.

The dummy substrate 225 enhances the mechanical strength of the information recording medium 220, and also protects the laminated body from the first dielectric layer 101 to the reflective layer 106. The materials that are preferably used as the dummy substrate 225 are the same as those preferably used as the substrate 222. In an information recording medium 220 to which the dummy substrate 225 is bonded, in order to prevent mechanical warping, distortion and the like, the dummy substrate 222 and the substrate 225 are preferably formed by using virtually the same material with the same thickness, in the present embodiment.

The following description will discuss a manufacturing method for an information recording medium 220 shown in Fig. 21.

In the present embodiment, layer-forming processes are carried out in an order opposite to the layer-forming order of Embodiment 1. With respect to the layer-forming processes that are the same as those of Embodiment 1, the description thereof is omitted.

First, a substrate 222 (having a thickness of, for example, 600 µm) is prepared, and placed in a sputtering device.

Successively, a first dielectric layer 101 is formed on the substrate 222. At this time, in the case when guide grooves used for directing a laser beam 1 are formed on the substrate 222, the first dielectric layer 101 is formed on the side on which the guide grooves are formed.

Successively, a first interface layer 102 is formed on the first dielectric layer 101, and a recording layer 103 is formed on the first interface layer 102.

Next, a second interface layer 104 is formed on the recording layer 103, and a second dielectric layer 105 is formed on the second interface layer 104.

Successively, the light absorption-correcting layer 227 is formed on the second dielectric layer 105. The light absorption-correcting layer 227 is formed through a sputtering process by the use of a dc power supply or a high-frequency power supply. With respect to the sputtering target, the material is selected from an amorphous Ge alloy such as Ge-Cr and Ge-Mo, an amorphous Si alloy such as Si-Cr and Si-Mo, Te-modified compound and a crystalline metal, semi-metal and semiconductor material, such as Ti, Zr, Nb, Ta, Cr, Mo, W, SnTe and PbTe. The sputtering is generally carried out in an Ar gas atmosphere.

Lastly, a reflective layer 106 is formed on the light absorption-correcting layer 227.

After the reflective layer 106 has been formed, the substrate 222 on which the layers from the first dielectric layer 101 up to the reflective layer 106 have been successively laminated is taken out of the sputtering device. Then, an ultraviolet-ray setting resin to form the bonding layer 6 is applied onto the surface of the reflective layer 106, for example, by the spin coating method. A dummy substrate 225 is made in close-contact with the ultraviolet-ray setting resin thus applied, and ultraviolet rays are directed thereto from the dummy substrate 225 side so that the resin is cured; thus, the joining process is completed.

After the joining process has been completed, an initializing process is carried out, if necessary. The initializing process is a process in which the recording layer 103, which is in an amorphous state, is heated through, for example, irradiation with a semiconductor laser to a temperature that is higher than the crystallizing temperature so as to be crystallized. The initializing process may be carried out prior to the joining process. By successively carrying out the forming process of the bonding layer 6 and the joining process of the dummy substrate 225, the information recording medium 220 of Embodiment 7 is manufactured.

### (Embodiment 8)

Embodiment 8 explains an evaluation method for the recording/reproducing process of the information recording medium 220 in accordance with the present invention.

Upon evaluation of the recording/reproducing process of the information recording medium220, a recording/reproducing device 23 shown in Fig. 13 may be used. The recording/reproducing device 23 is prepared as an information recording system having a generally-used structure including a spindle motor 51 that rotates the information recording medium 220, an optical head 52 having a semiconductor laser 53 that emits a laser beam 1 and an objective lens 54 that converges the laser beam 1 onto the recording layer 103 of the information recording medium 220.

When the information recording medium 220 is evaluated, a recording/reproducing operation corresponding to a capacity of 4.7 GB can be carried out by using a semiconductor laser having a wavelength of 660 nm and an objective lens having a numerical aperture of about 0.6.

The following description will discuss the present invention in more detail by means of examples.

### (Example 1)

In Example 1, an information recording medium 11 shown in Fig. 1 was prepared, and relationships among the material for the recording layer 103, the crystallizing temperature Tx of the information recording medium 11, the limit value maxPr of reproducing power and the rewriting performance after a long-term storage Aow of the information recording medium 11 were examined. More specifically, samples of four kinds of the information recording medium 11 with different materials for the recording layer 103 were formed. With respect to the recording layer 103 that wa represented by [(GeTe)ₓ (M1M3)₁₋ₓ ]_{A}M2_{2+B}Te₃, Sb was used as M2 and A = 22, B = 0 and x = 0.95 held so that the corresponding recording layer 103 was represented by [(GeTe)_{0.95} (M1M3)_{0.05}]₂₂Sb₂Te₃, and Sn, Tb or Dy was used as M1 and Te was used as M3; thus, the recording layers 103 of three kinds in which M1M3 was represented by SnTe, TbTe and DyTe were used. A sample in which x = 1 holds to form (GeTe)₂₂Sb₂Te₃ was also used as a comparative sample without M1M3. With respect to the four kinds of samples, the crystallizing temperature Tx of the information recording medium 11, the limit value maxPr of reproducing power and the rewriting performance after a long-term storage Aow were measured. A sample to be used for measuring the crystallizing temperature Tx of the information recording medium 11 was prepared as a sample member, and samples to be used for measuring the limit value maxPr of reproducing power and the rewriting performance after a long-term storage Aow were prepared as sample disks, and four kinds of sample members and sample disks were respectively manufactured by using the following methods.

First, with respect to the sample member, a quartz substrate (10 mm in diameter, 0.3 mm in thickness) was prepared, and placed in a sputtering device. A recording layer 103 (10 nm in thickness) and a cover layer made of (ZrO₂)₂₅(SiO₂)₂₅(Cr₂O₃)_{50(mol %)}(5 nm in thickness) were successively laminated on the quartz substrate by using a sputtering method. With respect to the sample member manufactured as described above, those sample members of four kinds in which materials for the recording layer 103 were made different were prepared. Measurements on the crystallizing temperature were carried out on the sample members of the four kinds. A laser beam was directed to the sample member so that, while the sample member was heated at 50°C/min, the transmittance was continuously measured. Based upon the results of the measurements, the temperature at which an abrupt drop of the transmittance was observed was defined as the crystallizing temperature, and the corresponding temperatures of the four samples were determined.

Next, with respect to the sample disk, a polycarbonate substrate (120 mm in diameter, 1.1 mm in thickness) on which guide grooves (20 nm in depth, 0.32 nm in groove-to-groove gap) used for directing a laser beam 1 had been formed was prepared as a substrate 2. The substrate 2 was placed in a sputtering device, and an Ag-Pd-Cu layer (80 nm in thickness) serving as the reflective layer 106 and a (ZnS)₈₀(SiO₂)₂₀ layer (20 nm in thickness) serving as the second dielectric layer 105 were laminated on the substrate 2 on the groove side. In order to prevent reaction between Ag contained in the reflective layer 106 and S contained in the second dielectric layer 105, an Ni layer (5 nm in thickness) serving as an interface layer and an Al layer (10 nm in thickness) were successively formed on the reflective layer 106. A (ZnS)₈₀(SiO₂)₂₀ layer (20 nm in thickness) serving as the second dielectric layer 105, a (ZrO₂)₂₅(SiO₂)₂₅(Cr₂O₃)₅₀ layer (5 nm in thickness) serving as the second interface layer 104, a recording layer 103 (11 nm in thickness), a (ZrO₂)₂₅(SiO₂)₂₅(Cr₂O₃)₅₀ layer (5 nm in thickness) serving as the first interface layer 102 and a (ZnS)₈₀(SiO₂)₂₀ layer (60 nm in thickness) serving as the first dielectric layer 101 were successively laminated on the Al layer by using a sputtering method. Lastly, an ultraviolet-ray setting resin was applied to the first dielectric layer 101, and this was rotated, with a polycarbonate sheet (120 mm in diameter, 90 µm in thickness) being tightly made in contact with the first dielectric layer 101, to form a uniform resin layer, and the resin layer was cured by irradiation with ultraviolet rays so that the transparent layer 3 was formed. Thereafter, an initializing process in which the recording layer 103 was crystallized by a semiconductor laser was carried out. With respect to the sample disk manufactured as described above, those samples of four kinds in which the materials of the recording layer 103 were different were formed.

The layer thicknesses of the first dielectric layer 101 and the second dielectric layer 105 were strictly determined based upon calculations carried out using the matrix method. More specifically, these thicknesses were determined so that, by using a wavelength of 405 nm, the reflectance Rc (%) on the substrate mirror face portion of the information recording medium 11 in the crystal portion of the recording layer 103 was set to about 20% and the reflectance Ra (%) on the substrate mirror face portion of the information recording medium 11 in the amorphous portion was set to about 2%.

With respect to those sample disks of four kinds prepared as described above, the limit value maxPr of reproducing power and the rewriting performance after a long-term storage Aow of the information recording medium 11 were measured by using a recording/reproducing device 23 shown in Fig. 13. At this time, the wavelength of the laser beam 1 was set to 405 nm, the numerical aperture NA of the objective lens 54 was set to 0.85, the shortest mark length was set to 0.149 µm, and the linear velocity of the sample at the time of measurements was set to 5.3 m/s upon measuring the limit value maxPr of reproducing power, and was also set to 10.6 m/s upon measuring the rewriting performance after a long-term storage Aow. Information was recorded in the grooves.

With respect to the measurements on the limit value maxPr of reproducing power, first, the laser beam 1 was power-modulated between the peak power Pp and the bias power Pb as explained in Embodiment 5 so that random signals from a mark length 0.149 µm (2T) to that of 0.596 µm (8T) were continuously recorded in the same groove with rewriting processes of 10 times through a (1-7) modulation system. The recorded signals were reproduced through reproducing power Pr = 0.25 mW to 0.35 mW so that a jitter between the front ends as well as a jitter between the rear ends were measured by using a time interval analyzer; thus, the average value of the jitter between the front ends and the jitter between the rear ends was defined as a jitter in the reproducing power. A jitter immediately after a recording process with a certain reproducing power Pr within a range of Pr from 0.25 mW to 0.35 mW (with a scale of 0.01 mW) was measured, and after a lapse of four minutes, a jitter was again measured. An increase of the jitter 4 minutes later to the jitter immediately after the recording was defined as ΔJit. In the case when the increase in jitter ΔJit. was confirmed as ΔJit. ≥ 0.2%, it was determined that reproducing light degradation occurred in the reproducing power Pr; thus, when the limit value maxPr of reproducing power that caused no degradation in reproducing light was indicated by maxPr < 0.25 mW, this case was evaluated as x; when it was indicated by 0.25 mW ≤ maxPr < 0.35, this case was evaluated as Δ; and when it was indicated by 0.35 mW ≤ maxPr, this case was evaluated as o.

With respect to the evaluation on the rewriting performance after a long-term storage Aow, first, the laser beam 1 was power-modulated between the Pp and the Pb so that random signals from a mark length 0.149 µm (2T) to that of 0.596 µm (8T) were continuously recorded in the same groove with rewriting processes of 10 times through a (1-7) modulation system. In the recorded groove, a jitter between the front ends as well as a jitter between the rear ends were measured by using a time interval analyzer; thus, the average value of the jitter between the front ends and the jitter between the rear ends was defined as a jitter prior to the long-term storage. Thereafter, the sample on which the signals had been recorded was left in a thermo-hygrostat for 100 hours under conditions of a temperature of 80°C and a relative humidity of 20%. With respect to the sample left for 100 hours, the recorded signal prior to leaving was once rewritten after having left for 100 hours, and jitters between the front ends as well as between the rear ends were then measured so that the average jitter of the jitter between the front ends and the jitter between the rear ends was defined as a jitter after the long-term storage. By comparing the jitters before and after the long-term storage with each other, the rewriting performance before and after the long-term storage was evaluated. In this case, the smaller the increase in the jitters before and after the long-term storage, the more superior the rewriting performance after the long-term storage. Therefore, with respect to the evaluation on the rewriting performance after a long-term storage Aow, an increase in the jitters before and after the long-term storage was defined as ΔJit. When ΔJit. ≤ 2%, this case was evaluated as o; when 2% < ΔJit. ≤ 3%, this case was evaluated as Δ; and when 3% < ΔJit., this case was evaluated as x.

Table 1 shows the material of M1 in the recording layer 103 in the information recording medium 11, the crystallizing temperature Tx of the information recording medium 11, evaluation results of the limit value maxPr of reproducing power and evaluation results of the rewriting performance after a long-term storage Aow.

**Table 1**

| Sample No. | Recording layer material M1 | Sample member | Crystallizing temperature of Information recording medium Tx | Sample disk | Limit value of reproducing power maxPr | Rewriting performance after long-term storage Aow |
|---|---|---|---|---|---|---|
| 1-1 | Sn | S-1-1 | 212°C | D-1-1 | × | ○ |
| 1-2 | None | S-1-2 | 228°C | D-1-2 | Δ | Δ |
| 1-3 | Tb | S-1-3 | 233°C | D-1-3 | ○ | ○ |
| 1-4 | Dy | S-1-4 | 236°C | D-1-4 | ○ | ○ |

The results in Table 1 indicate that in the case of the sample 1-1 in which Sn is used as M1 of the recording layer 103, the crystallizing temperature Tx of the recording layer 103 is 212°C that is a low level to cause a limit value maxPr of reproduced power of less than 0.25 mW that is insufficient. In the case of sample 1-2 in which x = 1 holds without containing M1M3 in the recording layer 103, the crystallizing temperature Tx of the recording layer 103 is 228°C with a limit value maxPr of reproduced power of 0.25 or more; however, this is less than 0.35 that is an insufficient level. In the case of samples 1-3 and 1-4 in which Tb and Dy are used as M1 in the recording layer, the crystallizing temperature Tx of the recording layer 103 in sample 1-3 is 233°C, and the crystallizing temperature Tx of the recording layer 103 in sample 1-4 is 236°C; consequently, both of the samples achieve a limit value maxPr of reproduced power of 0.35 mW or more, which is a sufficient level. At this time, the rewriting performance after a long-term storage Aow is 2% or less that is a sufficient level.

In summary, when Sn is used as M1, and when x = 1 holds, the limit value maxPr of reproducing power is less than 0.35 mW to cause degradation due to the reproducing power. When Tb and Dy are used as M1, the limit value maxPr of reproducing power is 0.35 mW or more so that the amorphous portion of the recording layer is maintained in a stable manner in response to the reproducing light. Based upon these facts, it is confirmed that by using a compound between a rare earth metal, such as Tb and Dy, and Te as M1M3, the crystallizing temperature of the recording layer is raised so that both of the reproducing power limit value and the rewriting performance after a long-term storage can be enhanced.

In the case when in sample 1-3, a DyTe (1 nm in thickness) layer is placed between the first interface layer 102 and the recording layer 103 as a nucleus-forming layer M1M3, although the limit value maxPr of reproducing power is not changed, the rewriting performance after a long-term storage Aow is further improved so that good results are obtained. In the case when a nucleus-forming DyTe (1 nm) layer is placed between the recording layer 103 and the second interface layer 104, the rewriting performance after a long-term storage Aow is also improved so that good results are obtained.

### (Example 2)

In Example 2, an information recording medium 11 shown in Fig. 1 was prepared, and relationships among the material for the recording layer 103, the limit value maxPr of reproducing power and the rewriting performance after a long-term storage Aow of the information recording medium were examined. More specifically, samples of eight kinds with different materials for the recording layer 103 were formed. With respect to the recording layer 103 that was represented by [(GeTe)ₓ (M1M3)₁₋ₓ]_{A}M2_{2+B}Te₃, Bi was used as M2 and A = 22, B = 0 and x = 0.95 held so that the corresponding recording layer 103 was represented by [(GeTe)_{0.95} (M1M3)_{0.05}]₂₂Bi₂Te₃, and eight kinds of materials, that is, GaTe, MnTe, NiTe, PbTe, SnTe, ZnTe, GdTe and DyTe were used as M1M3. These materials were Te-modified compounds having different melting points and crystal structures. These eight samples were formed by using the same method as the sample disk of Embodiment 1, and by using the same method as that of Embodiment 1, the limit value maxPr of reproducing power and the rewriting performance after a long-term storage Aow were evaluated.

Table 2 shows eight kinds of materials of M1M3 used in the recording layer 103 of the information recording medium 11 and the melting point and the crystal structure of each of the materials, the results of evaluation on the reproducing power limit value in the information recording medium 11 and the results of evaluation on the rewriting performance after a long-term storage Aow. In the same manner as Table 1, with respect to the limit value maxPr of reproducing power, when maxPr < 0.25 mW, this case was evaluated as x; when 0.25 mW ≤ maxPr <0.35 mW, this case was evaluated as Δ; and when 0.35 mW ≤ maxPr, this case was evaluated as o. With respect to an increase ΔJit. in jitter before and after a long-term storage, when ΔJit. ≤ 2%, this case was evaluated as ○; when 2% < ΔJit. ≤ 3%, this case was evaluated as Δ; and when 3% < ΔJit., this case was evaluated as ×.

**Table 2**

| Sample No. | Recording layer material M1M3 | Melting point of M1M3 | Crystalline structure of M1M3 | Limit value of reproducing power maxPr | Rewriting performance after long-term storage Aow |
|---|---|---|---|---|---|
| 2-1 | GaTe | 824°C | Monoclinic | × | Δ |
| 2-2 | MnTe | 1165°C | Hexagonal | Δ | × |
| 2-3 | NiTe | 860°C | Hexagonal | × | Δ |
| 2-4 | PbTe | 917°C | Cubic | × | ○ |
| 2-5 | SnTe | 780°C | Cubic | × | ○ |
| 2-6 | ZnTe | 1238°C | Cubic | Δ | ○ |
| 2-7 | GdTe | 1825°C | Cubic | ○ | ○ |
| 2-8 | DyTe | 1850°C | Cubic | ○ | ○ |

The results in Table 2 indicate that in the case of the application of GaTe, MnTe or NiTe that is not a cubic system in the crystal structure as M1M3 of the recording layer 103, the rewriting performance after a long-term storage Aow is greater than 2%, which is insufficient. In the case of the application of a cubic system in the crystal structure as M1M3 of the recording layer 103, the rewriting performance after a long-term storage Aow is 2% or less, which provides a good result.

In the case of the application of GaTe, NiTe, PbTe or SnTe that has a melting point of less than 1000°C that is a low level as M1M3 of the recording layer 103, the limit value maxPr of reproducing power becomes less than 0.25 mW, which is insufficient. In the case of the application of MnTe or ZnTe having a melting point of less than 1300°C as M1M3, the limit value maxPr of reproducing power becomes less than 0.35 m. Furthermore, in the case of the application of GdTe or DyTe having a high melting point of 1300°C or more as M1M3, the limit value maxPr of reproducing power becomes 0.35 mW or more, which is a sufficient level, and the rewriting performance after a long-term storage Aow becomes 2% or less, which is also a sufficient level.

Therefore, the results in Table 2 indicate that when the crystal structure of M1M3 is not a cubic system, the rewriting performance after a long-term storage is lowered, and that when the melting point of M1M3 is less than 1000°C, there is degradation in the reproducing light.

In the case of the recording layer 103 [(GeTe)_{0.95}(M1M3)_{0.05}]₂₂Sb₂Te₃ in which M2 is Sb as well as in the case of the recording layer 103 [(GeTe)_{0.95}(M1Bi)_{0.05}]₂₂M2₂Te₃ in which M3 is Bi, the same results are obtained. Furthermore, in the case when at least one element selected from the group consisting of Sc, Y, La, Ce, Pr, Nd, Sm, Tb, Ho, Er, Yb and Lu is used as M1, the crystallizing temperature is made higher, with a good limit value of reproducing power of 0.35 mW or more, and the rewriting performance after a long-term storage Aow becomes 2% or less, which is also a good level.

As described above, with respect to M1M3, in a Bi-modified compound of M3 = Bi or a Te-modified compound of M3 = Te which has a cubic system in its crystal structure with a melting point of 1300°C or more, when a rare-earth element is used as M1, it is possible to obtain an information recording medium that has a superior rewriting performance after a long-term storage, and is free from degradation in reproducing light.

### (Example 3)

In Example 3, an information recording medium 11 shown in Fig. 1 was prepared, and relationships among the material for the recording layer 103, the limit value maxPr of reproducing power and the rewriting performance after a long-term storage Aow of the information recording medium 11 were examined. More specifically, samples of eight kinds with different materials for the recording layer 103 were formed. With respect to the recording layer 103 that was represented by [(GeTe)ₓ (M1M₃)₁₋ₓ]_{A}M2_{2+B}Te₃, Bi was used as M2, LaBi was used as M1M3 and A = 22 and x = 0.90 held so that the corresponding recording layer 103 was represented by [(GeTe)_{0.90} (LaBi)_{0.10}]₂₂Bi_{2+B}Te₃; thus, the recording layers 103 of three kinds in which B = 1, 3 and 5 were used. These eight samples were formed by using the same method as the sample disk of Embodiment 1, and by using the same method as that of Embodiment 1, the limit value maxPr of reproducing power and the rewriting performance after a long-term storage Aow were evaluated.

With respect to the three samples in which B = 1, 3 and 5 of the recording layer 103 of the information recording medium 11, Table 3 shows the results of evaluation on the reproducing power limit value maxPr and the results of evaluation on the rewriting performance after a long-term storage Aow. In the same manner as Table 2, with respect to the limit value maxPr of reproducing power, when maxPr < 0.25 mW, this case was evaluated as x; when 0.25 mW ≤ maxPr< 0.35 mW, this case was evaluated as Δ; and when 0.35 mW ≤ maxPr, this case was evaluated as o. With respect to an increase ΔJit. in jitter before and after a long-term storage, when ΔJit. ≤ 2%, this case was evaluated as o; when 2% < ΔJit. ≤ 3%, this case was evaluated as Δ; and when 3% < ΔJit., this case was evaluated as ×.

**Table 3**

| Sample No. | B value of recording layer | Limit value of reproducing power maxPr | Rewriting performance after long-term storage Aow |
|---|---|---|---|
| 3-1 | 1 | ○ | ○ |
| 3-2 | 3 | ○ | ○ |
| 3-3 | 5 | ○ | ○ |

As shown in Table 3, in any of the cases in which B = 1, 3 and 5 in the recording layer 103 represented by [(GeTe)_{0.90} (LaBi)_{0.10}]₂₂Bi_{2+B}Te₃ in the information recording medium 11, the limit value maxPr of reproducing power was 0.35 mW or more, and the rewriting performance after a long-term storage Aow was 2% or less; thus, good results were obtained.

### (Example 4)

With respect to the case in which the second interface layer 104 is placed only on the second dielectric layer 105 side of the recording layer 103 as the interface layer as indicated by the information recording medium 12 of Fig. 2 as well as to the case in which the first interface layer 102 is placed only on the first dielectric layer 101 side of the recording layer 103 as the interface layer, measurements were carried out on the limit value maxPr of reproducing power as well as on the rewriting performance after a long-term storage Aow, in the same manner as Example 2. With respect to the first dielectric layer 107 of the information recording medium 12 and the second dielectric layer 108 of the information recording medium 13, a (ZrO₂)₃₅(SiO₂)₃₅(Cr₂O₃)₃₀ layer (30 nm in thickness) was used. In the present example, the same results as those of Example 2 were obtained.

### (Example 5)

In Example 5, with respect to the information recording medium 17 of Fig. 7, measurements of the limit value maxPr of reproducing power and the rewriting performance after a long-term storage Aow were carried out on the first information layer 31 and the second information layer 41. More specifically, samples in which materials for the first recording layer 203 and the second recording layer 303 were different from each other were formed.

With respect to the first recording layer 203 that is represented by [(GeTe)ₓ (M1M3)₁₋ₓ]_{A}M2₂Te₃, Bi is used as M2 and A = 31, B = 0 and x = 0.97 hold so that the corresponding first recording layer 203 is represented by [(GeTe)_{0.97} (M1M3)_{0.03}]₃₁Bi₂Te₃, and LaBi, LaTe, PrTe, TbBi, GdTe or DyBi is used as M1M3. A sample in which x = 1 holds to form (GeTe)₃₁Bi₂Te₃ is also used as a comparative sample. With respect to the second recording layer 303 that is represented by [(GeTe)ₓ (M1M3)₁₋ₓ]_{A}M2₂Te₃, Sb is used as M2 and A = 22, B = 0 and x = 0.9 hold so that the corresponding second recording layer 303 is represented by [(GeTe)_{0.9} (M1M3)_{0.1}]₂₂Sb₂Te₃, and CeBi, GdBi, NdBi, ErBi, DyBi, GdTe or DyTe is used as M1M3. With respect to the sample thus formed, the limit value maxPr of reproducing power and the rewriting performance after a long-term storage Aow were evaluated in the first information layer 31 and the second information layer 41 of the information recording medium 17.

The sample was manufactured in the following processes. First, a polycarbonate substrate (120 mm in diameter, 1.1 mm in thickness) on which guide grooves (20 nm in depth, 0.32 µm in track pitch) used for directing a laser beam 1 had been formed was prepared as a substrate 2, and placed in a sputtering device. Then, an Ag-Pd-Cu layer (80 nm in thickness) serving as the second reflective layer 306, a (ZnS)₈₀(SiO₂)₂₀ layer (22 nm in thickness) serving as the fourth dielectric layer 305, a (ZrO₂)₃₅(SiO₂)₃₅(Cr₂O₃)₃₀ layer (5 nm in thickness) serving as the fourth interface layer 304, the second recording layer 303 (11 nm in thickness), a (ZrO₂)₃₅(SiO₂)₃₅(Cr₂O₃)₃₀ layer (5 nm in thickness) serving as the third interface layer 302 and a (ZnS)₈₀(SiO₂)₂₀ layer (22 nm in thickness) serving as the third dielectric layer 301 were laminated on the substrate 2 on the groove side by using a sputtering method. Since an Ag alloy was contained in the second reflective layer 306 and since S was contained in the fourth dielectric layer 305, an Ni layer (5 nm in thickness) was formed between the second reflective layer 306 and the fourth dielectric layer 305 as an interface layer, and an AlCr layer (10 nm in thickness) was formed on the second reflective layer 306 successively. The layer thicknesses of the fourth dielectric layer 305 and the third dielectric layer 301 were strictly determined based upon calculations through the matrix method so that, in response to a wavelength of 405 nm, the quantity of reflected light in the crystal portion of the second recording layer 303 could become greater than the quantity of reflected light in the amorphous portion; a change in the reflectances between the crystal portion and the amorphous portion of the second recording layer 303 could become greater; and the light-absorbing efficiency of the second recording layer 303 could become greater.

Next, an ultraviolet-ray setting resin was applied onto the third dielectric layer 301, and a substrate on which guide grooves (20 nm in depth, 0.32 µm in groove-to-groove gap) had been formed was put thereon so as to be made in close-contact therewith, and this was rotated so that a uniform resin layer was formed, and after the resin had been cured, the substrate was separated. This process made it possible to form an optical separation layer 32 on which the guide grooves used for directing a laser beam had been formed on the second information layer 41 side.

Thereafter, a TiO₂ layer (20 nm in thickness) serving as the transmittance-adjusting layer 207, an Ag-Pd-Cu layer (10 nm in thickness) serving as the reflective layer 206, a (ZnS)₈₀(SiO₂)₂₀ layer (22 nm in thickness) serving as the second dielectric layer 205, a (ZrO₂)₅₆(SiO₂)₁₄ (Cr₂O₃)₃₀ layer (5 nm in thickness) serving as the second interface layer 204, the first recording layer 203 (6 nm in thickness), a (ZrO₂)₅₆(SiO₂)₁₄ (Cr₂O₃)₃₀ layer (5 nm in thickness) serving as the first interface layer 202 and a (ZnS)₈₀(SiO₂)₂₀ layer (40 nm in thickness) serving as the first dielectric layer 205 were successively laminated on the optical separation layer 32 by using a sputtering method. Thereafter, an ultraviolet-ray setting resin was applied onto the first dielectric layer 201, and a polycarbonate sheet (120 mm in diameter, 90 µm in thickness) was tightly made in contact with the first dielectric layer 201, and rotated together so that a transparent layer 3 was formed. Lastly, an initializing process in which the whole area of the second recording layer 303 was crystallized and an initializing process in which the whole area of the first recording layer 203 was crystallized were carried out in this order. In this manner, a plurality of samples in which the materials for the second recording layer 303 and the first recording layer 203 were different from each other were manufactured.

Table 4 shows materials of M1M3 in the first recording layer 203 and the second recording layer of the information recording medium 17, the evaluation results on the limit value maxPr of reproducing power at a linear velocity of 5.3 m/s and the evaluation results on the rewriting performance after a long-term storage Aow at a linear velocity of 10.6 m/s. A jitter was measured immediately after a recording process using a certain reproducing power, and the jitter was again measured four minutes later, and in this case when an increase in the jitter, ΔJit. ≥ 0.2%, was confirmed, it was determined that a reproducing light degradation occurred in the reproducing power Pr; thus, when the limit value maxPr of reproducing power that caused no degradation in reproducing light was indicated by maxPr < 0.25 mW, this case was evaluated as ×; when it was indicated by 0.25 mW ≤ maxPr < 0.35, this case was evaluated as Δ; and when it was indicated by 0.35 mW ≤ maxPr, this case was evaluated as o. With respect to the evaluation on the rewriting performance after a long-term storage Aow, when an increase in the jitters ΔJit. was indicated by ΔJit. ≤ 2%, this case was evaluated as o; when 2% < ΔJit. ≤ 3%, this case was evaluated as Δ; and when 3% < ΔJit., this case was evaluated as ×.

**Table 4**

| Sample No. | Information layer No. | Recording layer material in each Information layer M1M3 | Melting point of M1M3 | Crystalline structure of M1M3 | Limit value of reproducing power maxPr | Rewriting performance after long-term storage Aow |
|---|---|---|---|---|---|---|
| 4-1 | Second Information layer | LaBi | 1615°C | Cubic | ○ | ○ |
| | First Information layer | CeBi | 1630°C | Cubic | ○ | ○ |
| 4-2 | Second Information layer | LaTe | 1720°C | Cubic | ○ | ○ |
| | First Information layer | GdBi | 2015°C | Cubic | ○ | ○ |
| 4-3 | Second Information layer | PrTe | 1950°C | Cubic | ○ | ○ |
| | First Information layer | NdBi | 1900°C | Cubic | ○ | ○ |
| 4-4 | Second Information layer | TbBi | 2000°C | Cubic | ○ | ○ |
| | First Information layer | ErBi | 2000°C | Cubic | ○ | ○ |
| 4-5 | Second Information layer | GdTe | 1825°C | Cubic | ○ | ○ |
| | First Information layer | DyBi | 2050°C | Cubic | ○ | ○ |
| 4-6 | Second Information layer | DyBi | 2050°C | Cubic | ○ | ○ |
| | First Information layer | GdTe | 1825°C | Cubic | ○ | ○ |
| 4-7 | Second informal layer | DyBi | 2050°C | Cubic | ○ | ○ |
| | First Information layer | DyTe | 1850°C | Cubic | ○ | ○ |

Table 4 indicates that in any of sample 4-1 using CeBi and LaBi, sample 4-2 using GdBi and LaTe, sample 4-3 using NdBi and PrTe, sample 4-4 using ErBi and TbBi, sample 4-5 using DyBi and GdTe, sample 4-6 using GdTe and DyBi and sample 4-7 using DyTe and DyBi, respectively as the first information layer and the second information layer, the limit value maxPr of reproducing power is 0.35 mW or more, with the rewriting performance after a long-term storage Aow being set to 2% or less.

Therefore, since the limit value maxPr of reproducing power is set to 0.35 mW or more in the first recording layer 203 and the second recording layer 303 used in Example 5, the amorphous portion corresponding to the recording mark is maintained in a stable manner with respect to reproducing light. Since the rewriting performance after a long-term storage Aow is set to 2% or less, it is possible to provide a superior rewriting performance after a long-term storage.

As described above, in the case of an information recording medium having two recording layers also, it is confirmed that by using a rare earth metal as M1 for Bi-modified compound in which M3 = Bi or for Te-modified compound in which M3 = Te in M1M3 of the recording layer, an information recording medium that is free from degradation in reproducing light and superior in the rewriting performance after a long-term storage can be obtained.

### (Example 6)

With respect to an information recording medium 18 shown in Fig. 8 in which the first interface layer 202, the second interface layer 204 and the fourth interface layer 304 are respectively formed on the interface between the first dielectric layer 201 and the first recording layer 203, the interface between the first recording layer 203 and the second dielectric layer 205 and the interface between the second recording layer 303 and the fourth dielectric layer 305, the same measurements as Example 5 were carried out. Since the third dielectric layer 307 is made in contact with the recording layer 303, a (ZrO₂)₂₅(SiO₂)₂₅(Cr₂O₃)₅₀ layer (20 nm in thickness) was used. When the same measurements as Example 5 were carried out on the limit value maxPr of reproducing power and the rewriting performance after a long-term storage Aow, the same results as Example 5 were obtained.

With respect to an information recording medium 19 shown in Fig. 9 in which the first interface layer 202, the second interface layer 204 and the third interface layer 302 are respectively formed on the interface between the first dielectric layer 201 and the first recording layer 203, the interface between the first recording layer 203 and the second dielectric layer 205 and the interface between the third dielectric layer 301 and the second recording layer 303, with a (ZrO₂)₂₅(SiO₂)₂₅(Cr₂O₃)₅₀ layer (20 nm in thickness) being used as the fourth dielectric layer 308, the same measurements as Example 5 were carried out to obtain the same results as those of Example 5.

### (Example 7)

In Example 7, samples in which the first information layer 31 and the second information layer 36 were formed with N = 2 being held, in the information recording medium 20 of Fig. 10, and measurements of the material of the first recording layer 203, the limit value maxPr of reproducing power and the rewriting performance after a long-term storage Aow were carried out thereon. More specifically, the same recording layer as that shown in Table 2 was used.

The sample was manufactured in the following processes. First, a polycarbonate substrate (120 mm in diameter, 0.6 mm in thickness) on which guide grooves (40 nm in depth, 0.344 µm in groove-to-groove gap) used for directing a laser beam 1 had been formed was prepared as a substrate 4, and placed in a sputtering device. Then, a (ZnS)₈₀(SiO₂)₂₀ layer (40 nm in thickness) serving as the first dielectric layer 201, a (ZrO₂)₅₀(SiO₂)₂₀(Cr₂O₃)₃₀ layer (5 nm in thickness) serving as the first interface layer 202, the first recording layer 203 (11 nm in thickness), a (ZrO₂)₅₀(SiO₂)₂₀(Cr₂O₃)₃₀ layer (5 nm in thickness) serving as the second interface layer 204, a (ZnS)₈₀(SiO₂)₂₀ layer (25 nm in thickness) serving as the second dielectric layer 205, a Ag-Pd-Cu layer (10 nm in thickness) serving as the first reflective layer 206 and a TiO₂ layer (20 nm in thickness) serving as the transmittance-adjusting layer 207 were successively laminated on the substrate 4 on the groove side by using a sputtering method. In order to prevent Ag contained in the reflective layer 206 and S contained in the second dielectric layer 205 from reacting with each other, an Ni layer (5 nm in thickness) serving as an interface layer and an Al₉₈Cr₂ layer (10 nm in thickness) were successively laminated on the second dielectric layer 205.

Next, a polycarbonate substrate (120 mm in diameter, 0.6 mm in thickness) was prepared as a dummy substrate 5, and placed in a sputtering device. Then, a second information layer 36 was formed on the dummy substrate 5.

Next, an ultraviolet-ray setting resin was applied to the transmittance-adjusting layer 207, and this was rotated, with the second information layer 36 being tightly made in contact with the setting resin, to form a uniform resin layer, and the resin layer was cured by irradiation with ultraviolet rays so that an optical separation layer 33 was formed. Lastly, an initializing process for initializing the whole area of the first recording layer 203 was carried out. Thus, a plurality of samples in which M1M3 was made different in the materials of the first recording layer 203 were formed.

With respect to the samples obtained in this manner, measurements of the limit value maxPr of reproducing power and the rewriting performance after a long-term storage Aow in the first information layer 31 of the information recording medium 20 were carried out on M1M3 of the first recording layer 203 by using the same method as that of Example 1.

At this time, the wavelength of the laser beam 1 was set to 405 nm, the numerical aperture NA of the objective lens 54 was set to 0.65, the linear velocity of the sample at the time of measurements was set to 8.6 m/s upon measuring, and the shortest mark length was set to 0.294 µm. Information was recorded in the grooves.

Consequently, in the case when, upon carrying out measurements of the limit value maxPr of reproducing power and after a long-term storage Aow on the material of M1M3 of the first recording layer 203 in the same manner as Example 3, M1 is prepared as at least one element selected from Sc, Y, La, Ce, Pr, Nd, Sm, Gd, Tb, Dy, Ho, Er, Yb and Lu, it becomes possible to provide an information recording medium 20 which prevents degradation in reproducing light, and is superior in the rewriting performance after a lingterm storage.

With respect to the information recording medium 21 of Fig. 11 in which no first interface layer 202 was formed and the second interface layer 204 was formed between the recording layer 203 and the second dielectric layer 205, with a (ZrO₂)₂₅(SiO₂)₂₅(Cr₂O₃)₅₀ layer (25 nm in thickness) being used as the first dielectric layer 208, the same experiments as described above were carried out so that an information recording medium 21 that was superior in the limit value maxPr of reproducing power and the rewriting performance after a long-term storage Aow in the first information layer 31 in the same manner as Example 6 was obtained.

### (Example 8)

In Example 8, an information recording medium 60 of Fig. 14 was manufactured, and a phase change in the recording layer 63 upon application of an electric current was confirmed.

An Si substrate the surface of which was subjected to a nitriding treatment was prepared as a substrate 61, and on this were successively laminated through a sputtering method Pr serving as a lower electrode 62 with an area of 10 µm x 10 µm and a thickness of 0.1 µm, a recording layer 63 [(GeTe)_{0.95}(M1Bi)_{0.05}]₂Sb₂Te₃ in which A = 2, B = 0 and x = 0.95, with an area of 5 µm × 5 µm and a thickness of 0.1 µm, and Pt serving as an upper electrode 64 with an area of 5 µm × 5 µm and a thickness of 0.1 µm. Thereafter, the lower electrode 62 and the upper electrode 64 were joined to each other through an Au lead line, and an electric information recording/reproducing device 66 was connected to the information recording medium 60 through an applying unit 65. In the electric information recording/reproducing device 66, a pulse power supply 67 was connected between the lower electrode 62 and the upper electrode 64 through a switch 68 so that a change in the resistance value due to a phase change in the recording layer 63 was detected by a resistance measuring device 70 that was connected between the lower electrode 62 and the upper electrode 64 through a switch 69.

In the case when Dy was used as M1 of the recording layer 63, a current pulse having an amplitude of 2 mA was applied across the lower electrode 62 and the upper electrode 64 in a high resistance state in the amorphous phase of the recording layer 63, and the phase change in the recording layer 63 was confirmed while the pulse width of the current pulse was increased by a unit of 10 ns. As a result, upon application of a current pulse having a pulse width of 80 ns, the recording layer 63 had a phase change from the amorphous phase to the crystal phase. In a low resistance state in the crystal phase of the recording layer 63, a current pulse having an amplitude of 10 mA was applied across the lower electrode 62 and the upper electrode 64, and the phase change in the recording layer 63 was confirmed while the pulse width of the current pulse was increased by a unit of 10 ns. As a result, upon application of a current pulse having a pulse width of 50 ns, the recording layer 63 has a phase change from the crystal phase to the amorphous phase. Immediately after the phase change of the recording layer 63 from the crystal phase to the amorphous phase, a reproducing current pulse having an amplitude of 0.1 mA and a pulse width of 2 ns was applied across the lower electrode 62 and the upper electrode 64 of the recording layer 63 for four minutes, and the phase change in the recording layer 63 was examined to find that the amorphous phase was still maintained.

In the case when Sb was used as M2 as well as in the case when Te was used as M3, the same method was used to carry out the experiments and the same results were obtained. In the same manner, in the case when at least one element selected from the group consisting of Sc, Y, La, Ce, Pr, Nd, Sm, Tb, Ho, Er, Yb and Lu was used as M1, the same results were obtained.

As described above, even in the information recording medium 60 in which a phase change took place by the use of electric means, the recording layer 63 using a rare-earth element as M1 devoted to the improvement in the crystallizing temperature and the improvement in the upper limit value of a reproducing current pulse. Therefore, it was confirmed that the material [(GeTe)_{0.95}(M1M3)_{0.05}]₂M2₂Te₃ could be preferably used as an electric information recording medium.

### (Example 9)

In Example 9, an information recording medium 13 as shown in Fig. 3 was manufactured, and relationships among the material for the recording layer 103, the limit value maxPr of reproducing power and the rewriting performance after a long-term storage Aow of the information recording medium were examined. More specifically, samples of fourteen kinds in which different materials were used for the recording layer 103 were formed.

With respect to the recording layer 103 that was represented by [(GeTe)ₓ (M1M3)₁₋ₓ]_{A}M2_{2+B}Te₃, Bi was used as M2, Te was used as M3 and A = 31, B = 2 and x = 0.9 held so that the corresponding recording layer 103 was represented by [(GeTe)_{0.9} (M1Te)_{0.1}]₃₁Bi₄Te₃, and Sc, Y, La, Ce, Pr, Nd, Sm, Gd, Tb, Dy, Ho, Er, Yb or Lu, that is, fourteen kinds of elements, was used as M1. These fourteen samples were formed by using the same method as the sample disks of Example 1, and the limit value maxPr of reproducing power and the rewriting performance after a long-term storage Aow were evaluated by using the same method as Example 1.

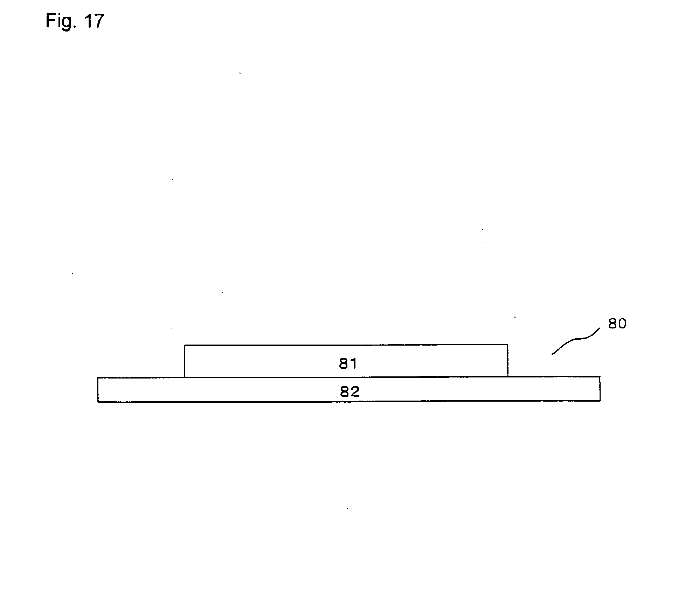

First, with respect to the sample disk 2, a polycarbonate substrate (120 mm in diameter, 1.1 mm in thickness) on which guide grooves (20 nm in depth, 0.32 nm in groove-to-groove gap) used for directing a laser beam 1 had been formed was prepared. A sputtering target 80 shown in Fig. 17 was prepared as the sputtering target. The sputtering target 80 was constituted by a packing plate 82 (140 mm in diameter, 6 mm in thickness) mainly composed by Cu and a target 81 (100 mm in diameter, 6 mm in thickness). Upon layer-forming the recording layer 103 [(GeTe)ₓ (M1M3)₁₋ₓ ]_{A}M2_{2+B}Te₃, a sputtering target 80, prepared by allowing the target 81 to fuse GeTe, M1M3, M2₂Te₃ and M2, was used.

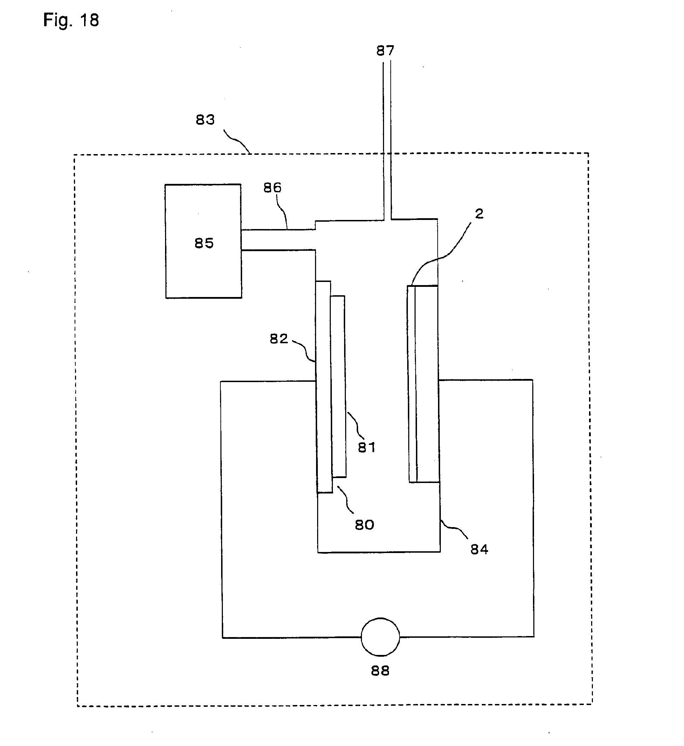

As shown in Fig. 18, the substrate 2 and the sputtering target 80 were placed in a vacuum chamber 84 of the sputtering device 83, and a vacuum was drawn on the inside of the vacuum chamber 84 through an exhaust port 86 by using a vacuum pump 85. Thereafter, an argon gas was introduced through a gas inlet 87 so that in the layer-forming process of the recording layer 103, a plasma was generated by using a dc power supply as the power supply 88 so as to carry out a sputtering process to form the layers on the substrate 2.

An Ag-Pd-Cu layer (80 nm in thickness) serving as the reflective layer 106, a (ZrO₂)₂₅(SiO₂)₂₅(Ga₂O₃)₅₀ layer (22 nm in thickness) serving as the second dielectric layer 108, the recording layer 103 (10 nm in thickness), a (ZrO₂)₂₅(SiO₂)₂₅(Cr₂O₃)₅₀ layer (5 nm in thickness) serving as the first interface layer 102, a (ZnS)₈₀(SiO₂)₂₀ layer (48 nm in thickness) serving as the first dielectric layer 101 were successively laminated on the substrate 2 on the groove side. Lastly, an ultraviolet-ray setting resin was applied to the first dielectric layer 101, and this was rotated, with a polycarbonate sheet (120 mm in diameter, 90 µm in thickness) being tightly made in contact with the first dielectric layer 101, to form a uniform resin layer, and the resin layer was cured by irradiation with ultraviolet rays so that the transparent layer 3 was formed. Thereafter, an initializing process for crystallizing the recording layer 103 by using a semiconductor laser was carried out. With respect to the sample disk manufactured as described above, those samples of fourteen kinds in which M1 forming one of the elements of the recording layer 103 was made different were formed.

The layer thicknesses of the first dielectric layer 101 and the second dielectric layer 108 were strictly determined based upon calculations carried out using the matrix method. More specifically, these thicknesses were determined so that, by using a wavelength of 405 nm, the reflectance Rc (%) on the substrate mirror face portion of the information recording medium 11 in the crystal portion of the recording layer 103 was set to about 20% and the reflectance Ra (%) on the substrate mirror face portion of the information recording medium 11 in the amorphous portion of the recording layer 103 was set to about 2% or less.

With respect to those sample disks of fourteen kinds prepared as described above, the limit value maxPr of reproducing power and the rewriting performance after a long-term storage Aow of the information recording medium 13 were measured by using a recording/reproducing device 23 shown in Fig. 13. At this time, the wavelength of the laser beam 1 was set to 405 nm, the numerical aperture NA of the objective lens 54 was set to 0.85, and the shortest mark length was set to 0.149 µm. With respect to the recording and reproducing operations of the samples, upon measuring the limit value maxPr of reproducing power, the recording/reproducing operation was carried out at 4.92 m/s, and upon measuring the rewriting performance after a long-term storage Aow, signals recorded at 9.84 m/s were reproduced at 4.92 m/s. Information was recorded in the grooves.

With respect to the measurements on the limit value maxPr of reproducing power and the rewriting performance after a long-term storage Aow, the same method as Example 1 was carried out. With respect to the evaluation process, in the same manner as Example 1, when the limit value maxPr of reproducing power that caused no degradation in reproducing light was indicated by maxPr < 0.25 mW, this case was evaluated as x; when it was indicated by 0.25 mW ≤ maxPr < 0.35, this case was evaluated as Δ; and when it was indicated by 0.35 mW ≤ maxPr, this case was evaluated as o. With respect to the evaluation on the rewriting performance after a long-term storage Aow, an increase in the jitters before and after the long-term storage is defined as ΔJit. When ΔJit. ≤ 2%, this case was evaluated as o; when 2% < ΔJit. ≤ 3%, this case was evaluated as Δ; and when 3% < ΔJit., this case was evaluated as ×.

Table 5 shows evaluation results of the limit value maxPr of reproducing power and evaluation results of the rewriting performance after a long-term storage Aow with respect to materials of the recording layer 103 in which M1 was different in the information recording medium 13.

**Table 5**

| Sample No. | Recording layer material [(GeTe)_{0.9}(M1Te)_{0.1}]₃₁Bi₄Te₃ | Limit value of reproducing power maxPr | Rewriting performance after long-term storage Aow |
|---|---|---|---|
| 5-1 | [(GeTe)_{0.9}(ScTe)_{0.1}]₃₁Bi₄Te₃ | ○ | ○ |
| 5-2 | [(GeTe) _{0.9}(YTe)_{0.1}]₃₁Bi₄Te₃ | ○ | ○ |
| 5-3 | [(GeTe)_{0.9}(PrTe)_{0.1}]₃₁Bi₄Te₃ | ○ | ○ |
| 5-4 | [(GeTe)_{0.9}(HoTe)_{0.1}]₃₁Bi₄Te₃ | ○ | ○ |
| 5-5 | [(GeTe)_{0.9}(ErTe)_{0.1}]₃₁Bi₄Te₃ | ○ | ○ |
| 5-6 | [(GeTe)_{0.9}(YbTe)_{0.1}]₃₁Bi₄Te₃ | ○ | ○ |
| 5-7 | [(GeTe)_{0.9}(LuTe)_{0.1}]₃₁Bi₄Te₃ | ○ | ○ |
| 5-8 | [(GeTe)_{0.9}(LaTe)_{0.1}]₃₁Bi₄Te₃ | ○ | ○ |
| 5-9 | [(GeTe)_{0.9}(CeTe)_{0.1}]₃₁Bi₄Te₃ | ○ | ○ |
| 5-10 | [(GeTe)_{0.9}(NdTe)_{0.1}]₃₁Bi₄Te₃ | ○ | ○ |
| 5-11 | [(GeTe)_{0.9}(SmTe)_{0.1}]₃₁Bi₄Te₃ | ○ | ○ |
| 5-12 | [(GeTe)_{0.9}(GdTe)_{0.1}]₃₁Bi₄Te₃ | ○ | ○ |
| 5-13 | [(GeTe)_{0.9}(TbTe)_{0.1}]₃₁Bi₄Te₃ | ○ | ○ |
| 5-14 | [(GeTe)_{0.9}(DyTe)_{0.1}]₃₁Bi₄Te₃ | ○ | ○ |

Table 5 indicates that in any of samples 5-1 to 5-14 of fourteen kinds in which in the recording layer 103 represented by [(GeTe)_{0.9} (M1Te)_{0.1}]₃₁Bi₄Te₃, M1 is prepared as Sc, Y, La, Ce, Pr, Nd, Sm, Gd, Tb, Dy, Ho, Er, Yb or Lu, good results are obtained with respect to the limit value maxPr of reproducing power and the rewriting performance after a long-term storage Aow.

Prior to a long-term storage, signals recorded at a linear velocity of 9.84 m/s were reproduced at 4.92 m/s so that a jitter prior to the long-term storage was measured, and the signals recorded prior to the long-term storage were reproduced at a linear velocity of 4.92 m/s after the long-term storage so that a jitter after the long-term storage was measured; thus, an increase in the jitters before and after the long-term storage was defined as ΔJit (Arc). In this case, supposing that the reproducing performance after the long-term storage is indicated by Arc, when ΔJit (Arc) < 2%, the Arc was evaluated as o; and when 2% ≤ ΔJit (Arc), the Arc was evaluated as x. All the samples of 5-1 to 5-14 of Example 9 satisfy ΔJit (Arc) < 2% so that a superior reproducing performance after a long-term storage Arc was obtained.

In particular, among fourteen kinds of M1, seven kinds of them, that is, La, Ce, Nd, Sm, Gd, Tb and Dy, are elements that are inexpensive in costs as compared with the other M1 elements, and commonly utilized in the industry as materials for magneto-optical information recording media and magnets and easily available; therefore, these elements are preferably used as the materials of M1. In particular, in view of mass production of information recording media, these facts that the material cost is inexpensive and that the material is easily available are very important factors, and among the elements of M1, the above-mentioned seven kinds of elements, La, Ce, Nd, Sm, Gd, Tb and Dy, are preferably used.

In the case when M1 is prepared as any one of the fourteen kinds of elements, Sc, Y, La, Ce, Pr, Nd, Sm, Gd, Tb, Dy, Ho, Er, Yb and Lu, it becomes possible to prepare superior limit value maxPr of reproducing power and rewriting performance after a long-term storage Aow, and in particular, in the case when M1 is prepared as any one of the seven kinds of elements, La, Ce, Nd, Sm, Gd, Tb and Dy, it becomes possible to prepare further superior limit value maxPr of reproducing power and rewriting performance after a long-term storage Aow.

In the same manner as described above, in the case of the recording 103 represented by [(GeTe)_{0.9}(M1Te)_{0.1}]₃₁Sb₄Te₃
in which Sb is used as M2, when M1 is prepared as any one of elements, Sc, Y, La, Ce, Pr, Nd, Sm, Gd, Tb, Dy, Ho, Er, Yb and Lu, it becomes possible to prepare superior limit value maxPr of reproducing power and rewriting performance after a long-term storage Aow.

In the same manner, in the case of the recording 103 represented by [(GeTe)_{0.9} (M1Bi)_{0.1}]₃₁Bi₄Te₃ in which Bi is used as M3, when M1 is prepared as any one of elements, Sc, Y, La, Ce, Pr, Nd, Sm, Gd, Tb, Dy, Ho, Er, Yb and Lu, it becomes possible to prepare superior limit value maxPr of reproducing power and rewriting performance after a long-term storage Aow.

For example, in samples 5-8, the recording layer material is [(GeTe)_{0.9} (LaTe)_{0.1}]₃₁Bi₄Te₃], and this material may be indicated by (GeTe)_{27.9}-(LaTe)_{3.1}-(Bi₂Te₃)-Bi₂. In samples 5-1 to 5-7 and 5-9 to 5-14, the material may be indicated by (GeTe)-(M1Te)-(Bi₂Te₃)-Bi.

### (Example 10)

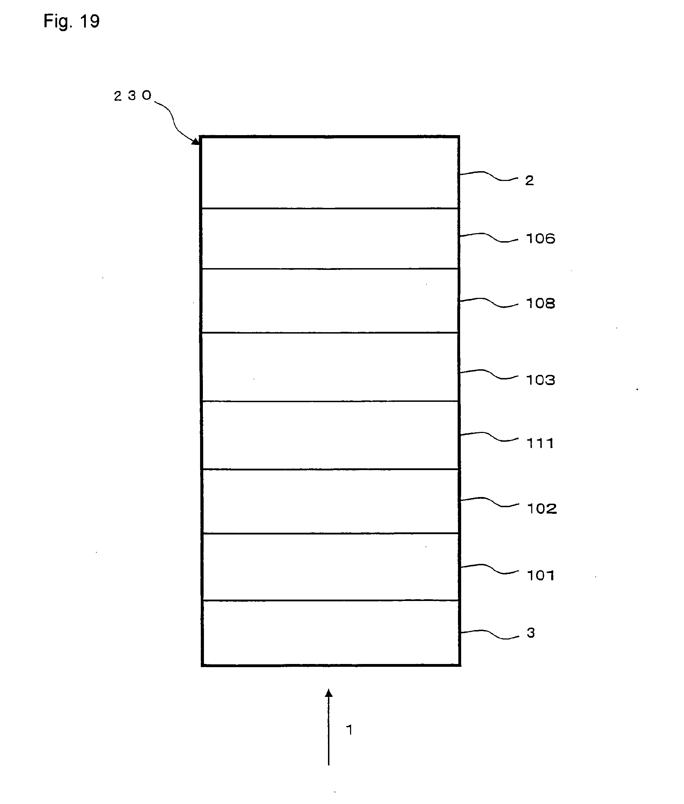

In Example 10, with respect to an information recording medium 230 shown in Fig. 19 in which a first nucleus-forming layer 111 is made in contact only with the first interface layer 102 side of the recording layer 103 as a nucleus-forming layer, relationships among the material for the first nucleus-forming layer 111, the limit value maxPr of reproducing power of the information recording medium 230 and the rewriting performance after a long-term storage Aow were examined.

More specifically, in contrast to the recording layer 103 [(GeTe)_{0.9} (DyTe)_{0.1}]₃₁Bi₄Te₃ of sample 5-14 used in Example 9, the recording layer 103 of the present Example 10 is represented by [(GeTe)_{0.9}(DyTe)_{0.1}]₆₀Sb₂Te₃ in which Sb is used as M2, with A = 60 and B = 0 being held. The layer thickness of the recording layer 103 of Example 10 is set to 9 nm that is thinner than the layer thickness of Example 9.

With respect to the sample, after the layers up to the second dielectric layer 108 have been laminated by using the same materials and the same method as those of Example 9, the recording layer 103 [(GeTe)_{0.9}(DyTe)_{0.1}]₆₀Sb₂Te₃ (9 nm in thickness) and a SnTe layer (1 nm in thickness) serving as the first nucleus-forming layer 111 were successively laminated thereon, and the first interface layer 102 and the succeeding layers were then formed thereon in succession by using the same materials and the same methods as those of Example 9. These samples were evaluated in the same manner as Example 9, so that superior limit value maxPr of reproducing power and rewriting performance after a long-term storage Aow were obtained.

With respect to the first nucleus-forming layer 111, DyTe or PbTe may be used with good results. With respect to the first nucleus-forming layer 111, Bi₂TeTb may also be used with good results.

In the same manner as Example 9, the reproducing performance after a long-term storage Arc was examined. In the information recording media 230 and 240 having the recording layer 103 [(GeTe)_{0.9}(DyTe)_{0.1}]₆₀Sb₂Te₃ (9 nm in thickness) used in the present Example 10, since the increase in jitter ΔJit (Arc) before and after a long-term storage satisfies ΔJit (Arc) < 2%, it becomes possible to obtain a superior reproducing performance after a long-term storage Arc.

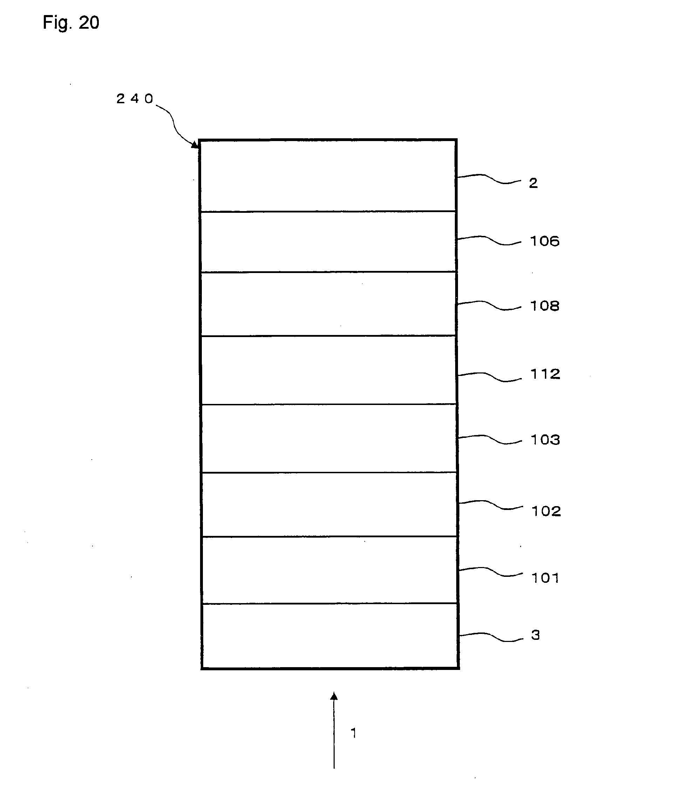

With respect to an information recording medium 240 shown in Fig. 20 in which a second nucleus-forming layer 112 is made in contact only with the second dielectric layer 108 side of the recording layer 103 as a nucleus-forming layer, relationships among the material for the second nucleus-forming layer 112, the limit value maxPr of reproducing power of the information recording medium 240 and the rewriting performance after a long-term storage Aow were examined.

More specifically, with respect to the sample, after the layers up to the second dielectric layer 108 have been laminated by using the same materials and the same method as those of Example 9, a SnTe layer (1 nm in thickness) serving as the second nucleus-forming layer 112 and the recording layer 103 [(GeTe)_{0.9}(DyTe)_{0.1}]₆₀Sb₂Te₃ (9 nm in thickness) were successively laminated thereon, and the first interface layer 102 and the succeeding layers were then formed thereon in succession by using the same materials and the same methods as those of Example 9. These samples were evaluated in the same manner as Example 9, so that superior limit value maxPr of reproducing power and rewriting performance after a long-term storage Aow were obtained.

With respect to the second nucleus-forming layer 112, PbTe and M1M3 may be used with good results on the limit value maxPr of reproducing power and the rewriting performance after a long-term storage Aow, in the same manner as the use of SnTe. With respect to M1, for the same reasons as those of Example 9, La, Ce, Nd, Sm, Gd, Tb or Dy is preferably used.

In this manner, all the nucleus-forming materials SnTe, PbTe and M1M3 that provide superior limit value maxPr of reproducing power and rewriting performance after a long-term storage Aow have a cubic system of NaCl type in the crystal structure.

### (Example 11)

In Example 11, an information recording medium 13 as shown in Fig. 3 was manufactured, and relationships among the material for the recording layer 103, the limit value maxPr of reproducing power and the rewriting performance after a long-term storage Aow of the information recording medium 13 were examined. More specifically, samples of eight kinds in which compositions of the recording layers 103 were different from one another.

With respect to the recording layer 103 that was represented by [(GeTe)ₓ (M1M3)₁₋ₓ]_{A}M2_{2+B}Te₃, Dy was used as M1, Bi was used as M2 and Te was used as M3 so that the corresponding recording layer 103 was represented by [(GeTe)ₓ (DyTe)₁₋ₓ]_{A}Bi_{2+B}Te₃, and three kinds thereof in which among x, A and B, only the value of x was made different, two kinds thereof in which among them, only A was made different, and three kinds thereof in which among them, only B was made different were prepared; thus, the total eight kinds of the recording layers 103 were used.

With respect to each of these eight kinds of samples in which the compositions of the respective recording layers 103 were made different, after the layers up to the second dielectric layer 108 had been laminated by using the same materials and the same method as those of Example 9, a [(GeTe)ₓ(DyTe)₁₋ₓ]_{A}Bi_{2+B}Te₃ layer (10 nm in thickness) was laminated as the recording layer 103, and the first interface layer 102 and the succeeding layers were then formed thereon in succession by using the same materials and the same method as those of Example 9.

First, with respect to the recording layer 103 [(GeTe)ₓ(DyTe)₁₋ₓ]_{A}Bi_{2+B}Te₃, A and B were set to A = 31 and B = 0 so that a recording layer 103 [(GeTe)ₓ(DyTe)₁₋ₓ]₃₁Bi₂Te₃ was prepared, and x was set to x = 0.50, 0.80 and 0.99 so that three kinds of samples were prepared and evaluated in the following processes.

As described in Example 5, the laser beam 1 was power-modulated between the peak power Pp and the bias power Pb so that random signals from a mark length 0.149 µm (2T) to that of 0.596 µm (8T) were continuously recorded in the same groove with rewriting processes of 10 times through a (1-7) modulation system. The recorded signals were reproduced through reproducing power Pr = 0.30 mW so that a jitter between the front ends and a jitter between the rear ends were measured by using a time interval analyzer; thus, the average value of the jitter between the front ends and the jitter between the rear ends was defined as a resulting jitter. The jitter was measured at a linear velocity of 4.92 m/s with respect to values of the peak power Pp and the bias power Pb. At this time, with respect to the peak power Pp and the bias power Pb that reduce the jitter to the minimum value, the peak power Pp at this time was defined as a recording sensitivity Pw, and in particular, the recording sensitivity upon recording a sample at a linear velocity of 4.92 m/s was defined as 1x recording sensitivity Pw.

With respect to the three kinds of samples in which the values of x were different, the 1x recording sensitivity Pw was measured, and the limit value maxPr of reproducing power and the rewriting performance after a long-term storage Aow were also measured by using the same method as Example 1.

With respect to the evaluation of 1x recording sensitivity Pw, when Pw ≤ 5.5 mW, this case was evaluated as ⓞ; when 5.5 mW < Pw ≤ 6.0 mW, this case was evaluated as o; and when 6.0 mW ≤ Pw, this case was evaluated as ×. With respect to the evaluations of the limit value maxPr of reproducing power and the rewriting performance after a long-term storage Aow, in the same manner as Example 1, when the limit value maxPr of reproducing power that caused no degradation in reproducing light was indicated by maxPr < 0.25 mW, this case was evaluated as ×; when it was indicated by 0.25 mW ≤ maxPr < 0.35, this case was evaluated as Δ; and when it was indicated by 0.35 mW ≤ maxPr, this case was evaluated as o. In the evaluation on the rewriting performance after a long-term storage Aow, an increase in the jitters before and after the long-term storage was defined as ΔJit. When ΔJit. ≤ 2%, this case was evaluated as ○; when 2% < ΔJit. ≤ 3%, this case was evaluated as Δ; and when 3% < ΔJit., this case was evaluated as ×.

Table 6 shows evaluation results of the 1x recording sensitivity, evaluation results of the limit value maxPr of reproducing power and evaluation results of the rewriting performance after a long-term storage Aow, with respect to each of the materials of the recording layer 103 in which the values of x are different in the information recording medium 13.

**Table 6**

| Sample No. | Recording layer material [(GeTe)ₓ(DyTe)₁₋ₓ]₃₁Bi₂Te₃ | 1x Recording sensitivity Pw | Limit value of reproducing power maxPr | Rewriting performance after long-term storage Aow |
|---|---|---|---|---|
| 6-1 | [(GeTe)_{0.50}(DyTe)_{0.50}]₃₁Bi₂Te₃ | ○ | ○ | ○ |
| 6-2 | [(GeTe)_{0.80}(DyTe)_{0.20}]₃₁Bi₂Te₃ | ⓞ | ○ | ○ |
| 6-3 | [(GeTe)_{0.99}(DyTe)_{0.01}]₃₁Bi₂Te₃ | ⓞ | ○ | ○ |

Table 6 indicates that in any of samples 6-1 to 6-3 in which the values of x were set to x = 0.50, 0.80 and 0.99 in the recording layer 103 [(GeTe)ₓ(DyTe)₁₋ₓ]₃₁Bi₂Te₃, good results were obtained in all the evaluations on the 1x recording sensitivity Pw, the limit value maxPr of reproducing power and the rewriting performance after a long-term storage Aow. In particular, samples 6-2 and 6-3 in which the values of x were set to 0.80 and 0.99 respectively provided better results in the 1x recording sensitivity.

As described above, when 0.5 ≤ x < 1.0 is satisfied in the recording layer 103 [(GeTe)ₓ(DyTe)₁₋ₓ]₃₁Bi₂Te₃, good results are obtained in the evaluations on the 1x recording sensitivity Pw, the limit value maxPr of reproducing power and the rewriting performance after a long-term storage Aow, and in particular, when 0.8 ≤ x < 1.0 is satisfied, better results are obtained in the 1x recording sensitivity Pw.

Therefore, with respect to the recording layer 103[(GeTe)ₓ (DyTe)₁₋ₓ]_{A}Bi_{2+B}Te₃, x is preferably set in a range of 0.5 ≤ x < 1.0, more preferably 0.8 ≤ x < 1.0.

For example, in sample 6-2, the recording layer material is [(GeTe)_{0.8} (DyTe)_{0.2}]₃₁Bi₂Te₃], and this material may be indicated by (GeTe)_{24.8}-(DyTe)_{6.2}-(Bi₂Te₃). In samples 6-1 and 6-3 also, the material may be indicated by (GeTe)-(M1Te)-(Bi₂Te₃).

With respect to the recording layer 103 [(GeTe)ₓ(DyTe)₁₋ₓ]_{A}Bi_{2+B}Te₃, x and B were set to x = 0. 8 and B = 0 so that a recording layer 103 [(GeTe)_{0.8}(DyTe)_{0.2}]_{A}Bi₂Te₃ was prepared, and the values of A were set to A = 22 and A = 60 so that two kinds of samples were prepared. With respect to the two kinds of samples with different values of A, the limit value maxPr of reproducing power and the rewriting performance after a long-term storage Aow were measured by using the same method as Example 1.

With respect to the evaluations on the limit value maxPr of reproducing power and the rewriting performance after a long-term storage Aow, in the same manner as Example 1, when the limit value maxPr of reproducing power that caused no degradation in reproducing light was indicated by maxPr < 0.25 mW, this case was evaluated as x; when it was indicated by 0.25 mW ≤ maxPr < 0.35, this case was evaluated as Δ; and when it was indicated by 0.35 mW ≤ maxPr, this case was evaluated as o. With respect to the evaluation on the rewriting performance after a long-term storage Aow, an increase in jitters before and after a long-term storage was defined as ΔJit., and when ΔJit. ≤ 2%, this case was evaluated as o; when 2% < ΔJit. ≤ 3%, this case was evaluated as Δ; and when 3% < ΔJit., this case was evaluated as ×. Table 7 shows the results of evaluation on the limit value maxPr of reproducing power and the results of evaluation on the rewriting performance after a long-term storage Aow, with respect to materials for the recording layer 103 in which the values of A are different in the information recording medium 13.

**Table 7**

| Sample No. | Recording layer material [(GeTe)_{0.8}(DyTe)_{0.2}]_{A}Bi₂Te₃ | Limit value of reproducing power maxPr | Rewriting performance after long-term storage Aow |
|---|---|---|---|
| 7-1 | [(GeTe)_{0.8}(DyTe)_{0.2}]₂₂Bi₂Te₃ | ○ | ○ |
| 7-2 | [(GeTe)_{0.8}(DyTe)_{0.2}]₆₀Bi₂Te₃ | ○ | ○ |

Table 7 indicates that in both of samples 7-1 and 7-2 in which the values of A were set to A = 31 and A = 60 in the recording layer 103 [(GeTe)_{0.8}(DyTe)_{0.2}]_{A}Bi₂Te₃, good results were obtained in all the evaluations on the limit value maxPr of reproducing power and the rewriting performance after a long-term storage Aow.

Thus, when 22 ≤ A < 60 is satisfied in the recording layer 103[(GeTe)_{0.8}(DyTe)_{0.2}]_{A}Bi₂Te₃, good results are obtained in the evaluations on the limit value maxPr of reproducing power and the rewriting performance after a long-term storage Aow.

Therefore, in the recording layer 103 [(GeTe)ₓ(DyTe)₁₋ₓ ]_{A}Bi_{2+B}Te₃, A is preferably set in a range of 22 ≤ A ≤ 60.

Lastly, with respect to the recording layer 103 [(GeTe)ₓ(DyTe)₁₋ₓ]_{A}Bi_{2+B}Te₃, x and A were set to x = 0.8 and A = 31 so that a recording layer 103 [(GeTe)_{0.8}(DyTe)_{0.2}]₃₁Bi_{2+B}Te₃ was prepared, and the values of B were set to B = 0, 2 and 5 so that three kinds of samples were prepared. With respect to the three kinds of samples with different values of B, the limit value maxPr of reproducing power and the rewriting performance after a long-term storage Aow were measured by using the same method as Example 1.

With respect to the evaluations on the limit value maxPr of reproducing power and the rewriting performance after a long-term storage Aow, in the same manner as Example 1, when the limit value maxPr of reproducing power that caused no degradation in reproducing light was indicated by maxPr < 0.25 mW, this case was evaluated as x; when it was indicated by 0.25 mW ≤ maxPr < 0.35, this case was evaluated as Δ; and when it was indicated by 0.35 mW ≤ maxPr, this case was evaluated as o. With respect to the evaluation on the rewriting performance after a long-term storage Aow, an increase in jitters before and after a long-term storage was defined as ΔJit., and when ΔJit. ≤ 2%, this case was evaluated as ○; when 2% < ΔJit. ≤ 3%, this case was evaluated as Δ; and when 3% < ΔJit., this case was evaluated as ×.

Table 8 shows the results of evaluation on the limit value maxPr of reproducing power and the results of evaluation on the rewriting performance after a long-term storage Aow, with respect to materials for the recording layer 103 in which the values of B are different in the information recording medium 13.

**Table 8**

| Sample No. | Recording layer material [(GeTe)_{0.8}(DyTe)_{0.2}]₃₁Bi_{2+B}Te₃ | Limit value of reproducing power maxPr | Rewriting performance after long-term storage Aow |
|---|---|---|---|
| 8-1 | [(GeTe)_{0.8}(DyTe)_{0.2}]₃₁Bi₂Te₃ | ○ | ○ |
| 8-2 | [(GeTe)_{0.8}(DyTe)_{0.2}]₃₁Bi₄Te₃ | ○ | ○ |
| 8-3 | [(GeTe)_{0.8}(DyTe)_{0.2}]₃₁Bi₇Te₃ | ○ | ○ |

Table 8 indicates that in both of samples 8-1 and 8-3 in which the values of B were respectively set to 0, 2 and 5 in the recording layer 103 [(GeTe)_{0.8}(DyTe)_{0.2}]₃₁Bi_{2+B}Te₃, good results were obtained in all the evaluations on the limit value maxPr of reproducing power and the rewriting performance after a long-term storage Aow.

Thus, when 0 ≤ B ≤ 5 is satisfied in the recording layer 103[(GeTe)_{0.8}(DyTe)_{0.2}]₃₁Bi_{2+B}Te₃, good results are obtained in the evaluations on the limit value maxPr of reproducing power and the rewriting performance after a long-term storage Aow.

Therefore, in the recording layer 103 [(GeTe)ₓ(DyTe)₁₋ₓ ]_{A}Bi_{2+B}Te₃, B is preferably set in a range of 0 ≤ B ≤ 5.

Based upon systematical judgments from the results in Tables 6, 7 and 8, since x, A and B are independent parameters, it becomes possible to obtain superior limit value maxPr of reproducing power and rewriting performance after a long-term storage Aow, by satisfying the respective ranges of 0.5 ≤ x < 1.0, 22 ≤ A ≤ 60 and 0 ≤ B ≤ 5. In particular, it is preferable to satisfy 0.8 ≤ x < 1.0 in order to obtain superior 1x recording sensitivity Pw.

### (Example 12)

In Example 12, the same manufacturing method as Example 11 was carried out by using the same materials and layer thicknesses as those of Example 11 except that only the composition of the recording layer 103 was different from that of Example 11 to manufacture an information recording medium 13. The rewriting performance after a long-term storage Aow was examined on the information recording medium 13.

More specifically, a recording layer 103 [(GeTe)_{0.8}(TbTe)_{0.2}]₂Bi₂Te₃ in which Tb was used as M1 and x = 0.8, A = 2 and B = 0 held was used as the recording layer 103.

In the present example, upon measuring the rewriting performance after a long-term storage, signals that had been recorded at a linear velocity of 39.4 m/s were reproduced at a linear velocity of 4.92 m/s so that a jitter was measured.

When the evaluation of the rewriting performance after a long-term storage Aow was carried out on an information recording medium 13 having the recording layer 103 [(GeTe)_{0.8}(TbTe)_{0.2}]₂Bi₂Te₃, an increase in jitters before and after a long-term storage ΔJit. was represented by ΔJit. ≤ 2%, which was a good result.

Thus, the present example indicates that, with respect to the information recording medium 13 having the recording layer 103 [(GeTe)_{0.8}(TbTe)_{0.2}]₂Bi₂Te₃, when a recording process is carried out at a linear velocity of 39.4 m/s and a reproducing process is carried out at a linear velocity of 4.92 m/s, good results are obtained in the rewriting performance after a long-term storage Aow.

Consequently, the present example indicates that in the recording layer 103 [(GeTe)ₓ(DyTe)₁₋ₓ]_{A}Bi_{2+B}Te₃, when A = 2 is satisfied, a superior rewriting performance after a long-term storage Aow is obtained. Based upon the results of the present example and the results of Example 11 in combination, it is found that, in the case when the respective ranges of 0.5 ≤ x < 1.0, 2 ≤ A ≤ 60 and 0 ≤ B ≤ 5 are satisfied, it is possible to obtain a superior performance after a long-term storage Aow.

### (Example 13)

In Example 13, with respect to two kinds of samples having different recording-layer compositions, the compositions of the recording layer 103 were analyzed. More specifically, with respect to a recording layer 103 [(GeTe)ₓ(LaTe)₁₋ₓ]₆₀Bi₂Te₃ in which La was used as M1 and A = 60 and B = 0 held, the values of x were set to x = 0.80 and 0.99 so that two kinds of samples were prepared as shown in Table 9. The recording layer 103 [(GeTe)ₓ(M1M3)₁₋ₓ]_{A}M2_{2+B}Te₃ is also indicated by Ge_{xA}M1_{(1-x)A}M2_{2+B}M3_{(1-x)A} Te_{xA+3}. For this reason, the calculation results in the case when the composition is indicated by GeₐLa_{b}Bi_{c}Te_{b}Te_{100-a-2b-c}, that is, GeₐLa_{b}Bi_{c}Te_{100-a-b-c}, are also shown in Table 9 in combination.

**Table 9**

| Sample No. | Recording layer 103 [(GeTe)ₓ(LaTe)₁₋ₓ]₆₀Bi₂Te₃ | Recording layer 103 GeₐLa_{b}Bi_{c}Te_{100-a-b-c} [mol%] |
|---|---|---|
| 9-1 | [(GeTe)_{0.80}(LaTe)_{0.20}]₆₀Bi₂Te₃ | Ge_{37.8}La_{9.5}Bi_{3.2}Te_{49.5} |
| 9-2 | [(GeTe)_{0.99}(LaTe)_{0.01}]₆₀Bi₂Te₃ | Ge_{47.5}La_{0.5}Bi_{1.6}Te_{50.4} |

A cover glass plate (18 mm × 18 mm × 0.1 mm) was bonded to the substrate 2, and after [(GeTe)ₓ(LaTe)₁₋ₓ ]₆₀Bi₂Te₃ had been layer-formed with a thickness of 300 nm as the recording layer 103 by using a sputtering device 83 of Fig. 18, the cover glass plate on which the recording layer 103 had been formed was removed from the substrate 2 so that this cover glass plate was used as a composition-analyzing sample.

With respect to sample 9-1 and sample 9-2, the compositions of the respective elements were analyzed through an ICP light-emission spectral analysis and the results of the analysis are shown in Table 10.

**Table 10**

| Sample No. | Result of Composition analysis of Recording layer 103 | | | | Recording layer 103 GeₐLa_{b}Bi_{c}Te_{100-a-b-c} [mol%] |
|---|---|---|---|---|---|
| | Ge | La | Bi | Te | |
| 9-1 | 38.0 | 9.5 | 3.0 | 49.5 | Ge_{38.0}La_{9.5}Bi_{3.0}Te_{49.5} |
| 9-2 | 47.6 | 0.5 | 1.7 | 50.2 | Ge_{47.6}La_{0.5}Bi_{1.7}Te_{50.2} |

As shown in Table 10, based upon the composition analysis through the ICP light-emission spectral analysis, compositions of the respective elements constituting the recording layer 103 were detected. Therefore, for example, in the case of sample 9-1, the composition analysis results were given as Ge of 38.0 mol %, La of 9.5 mol %, Bi of 3.0 mol % and Te of 49.5 mol % so that the recording layer 103 of sample 9-1 was denoted as Ge_{38.0}La_{9.5}Bi_{3.0}Te_{49.5}. In the same manner, the recording layer 103 of sample 9-2 was denoted as Ge_{47.6}La_{0.5}Bi_{1.7}Te_{50.2}.

As shown in Examples 11 and 12, the recording layer [(GeTe)ₓ(M1M3)₁₋ₓ]_{A}M2_{2+B}Te₃ provides a superior rewriting performance after a long-term storage Aow when the respective ranges of 0.5 ≤ x < 1.0, 2 ≤ A ≤ 60 and 0 ≤ B ≤ 5 are satisfied. The recording layer 103 [(GeTe)ₓ(M1M3)₁₋ₓ]_{A}M2_{2+B}Te₃ is also denoted as Ge_{xA}M1_{(1-x)A}M2_{2+B} M3_{(1-x)A}Te_{xA+3}. For this reason, in the case when the composition is denoted as GeₐM1_{b}M2_{c}M3_{b}Te_{100-a-2b-c}, the conditions of a, b and c that satisfy the respective ranges of 0.5 ≤ x < 1.0, 2 ≤ A ≤ 60 and 0 ≤ B ≤ 5 are calculated as respective ranges of 7 < a < 48, 0 < b ≤ 24, 1 < c ≤ 50 and 25 < 100 - a - 2b - c < 56, with b ≤ a being satisfied. In the case when the composition is denoted as GeₐM1_{b}M2_{c}M3_{b}Te_{100-a-2b-c}, the notation is based upon the results of the composition analysis; therefore, when errors in the composition analysis are taken into consideration, respective ranges of 5 < a < 50, 0 < b ≤ 26, 0 < c ≤ 52, and 42 < a + 2b + c < 77 need to be satisfied.

When the results of Example 13 and the results of Example 11 are taken into consideration together, it is possible to obtain superior limit value maxPr of reproducing power and rewriting performance after a long-term storage Aow when respective ranges of 11 < a < 48 and 0 < b ≤ 10 are satisfied. When analysis errors in the composition analysis are taken into consideration, it is possible to obtain further superior 1x recording sensitivity Pw when respective ranges of 9 < a < 50 and 0 < b ≤ 12 are satisfied.

### (Example 14)

Example 14 relates to experiments on a DVD-RAM mode. An information recording medium 220 shown in Fig. 21 was prepared, and evaluations on the recording/reproducing operation and evaluation on reliability were carried out by using a recording/reproducing device 23. With respect to the information recording medium 220, seven kinds of those media having different M1 materials for the recording layer 103 were prepared. For comparison, a medium 220 having a recording layer 103 containing no M1 was also prepared. The evaluations on the recording/reproducing operation and the reliability evaluation were performed in a range from 16X-speed to 5X-speed.

The following description will discuss the contents of the processes in detail.

First, the manufacturing method for the information recording medium 220 is explained. A polycarbonate substrate (120 mm in diameter, 0.6 mm in thickness) on which guide grooves (50 nm in depth, 0.615 µm in groove-to-land gap) had been formed was prepared as a substrate 222, and attached to a sputtering device. A (ZnS)₈₀(SiO₂)₂₀(mol %) layer (138 nm in thickness) serving as the first dielectric layer 101, a (ZrO₂)₂₅(SiO₂)₂₅(Cr₂O₃)₅₀(mol %) layer serving as the first interface layer 102 (5 nm in thickness) and the recording layer 103 (9 nm in thickness) were laminated on the substrate 222 on the guide groove surface side. The recording layer 103 is represented by [(GeTe)ₓ(M1M3)₁₋ₓ ]_{A}M2_{2+B}Te₃, in which x = 0.95, A = 8, B = 0, and Te is used as M3 and Bi is used as M2; thus, the material represented by [(GeTe)_{0.95}(MlTe)_{0.05}]₈Bi₂Te₃ was used. The seven kinds of information recording media 220 have respective recording layers 103 each of which has M1 that is La, Ce, Nd, Sm, Gd, Tb or Dy. Next, on the recording layer 103, a (ZrO₂)₂₅(SiO₂)₂₅(Cr₂O₃)₅₀ (mol %) layer (2 nm) serving as the second interface layer 104, a (ZnS)₈₀(SiO₂)₂₀(mol %) layer (40 nm) serving as the second dielectric layer 105, a Si₂Cr layer (30 nm) serving as the light-absorption-correcting layer 227 and an Ag alloy (80 nm) serving as the reflective layer 106 were successively formed.

The sputtering conditions for the respective layers are explained. Each of the first dielectric layer 101 and the second dielectric layer 105 was formed by sputtering a sputtering target made from (ZnS)₈₀(SiO₂)₂₀(mol %) with a diameter of 100 mm and a thickness of 6 mm in a mixed-gas atmosphere of Ar gas with 3% O₂ gas under pressure of 0.13 Pa at an output of 400W by using a high-frequency power supply. Each of the first interface layer 102 and the second interface layer 104 was formed by sputtering a sputtering target made from (ZrO₂)₂₅(SiO₂)₂₅(Cr₂O₃)₅₀(mol %) with a diameter of 100 mm and a thickness of 6 mm in an Ar-gas atmosphere under pressure of 0.13 Pa at an output of 500W by using a high-frequency power supply. The recording layer 103 was formed as a [(GeTe)_{0.95}(M1Te)_{0.05}]₈Bi₂Te₃ layer by sputtering a sputtering target containing Ge, Te, M1 and Bi with a diameter of 100 mm and a thickness of 6 mm in a mixed-gas atmosphere of Ar gas with 3% N₂ gas under pressure of 0.13 Pa at an output of 100W by using a high-frequency power supply. In this case, seven kinds of sputtering targets each of which has M1 that is any one of La, Ce, Nd, Sm, Gd, Tb and Dy were used. Upon forming the recording layer 103, since the composition of the sputtering target and the composition of a layer formed by the target are not necessarily coincident with each other, it is necessary to adjust the composition of the sputtering target so that a predetermined layer composition is prepared. The light-absorption-correcting layer 227 was formed by sputtering a sputtering target containing Si and Cr with a diameter of 100 mm and a thickness of 6 mm in an Ar-gas atmosphere under pressure of 0.27 Pa at an output of 300W by using a high-frequency power supply. The reflective layer 106 was formed by sputtering an Ag-alloy sputtering target with a diameter of 100 mm and a thickness of 6 mm in an Ar-gas atmosphere under pressure of 0.4 Pa at an output of 200W by using a high-frequency power supply.

Next, the evaluation method for the recording/reproducing operation is explained. The recording/reproducing device 23 explained in Example 8 was used. The linear velocity at which the information recording medium 220 was rotated was set in a range from about 65.6 m/second (16X-speed) to about 20.5 m/second (5X-speed). Upon measuring jitter values so as to find the average jitter value which will be described later, a time interval analyzer was used. First, the peak power (Pp) and the bias power (Pb) were set through the following processes in order to determine conditions by which the jitter value would be measured. By using the above-mentioned recording/reproducing device 23, a laser beam 1 was directed to the information recording medium 220 while its power was being modulated between the high-power level Pp (mW) and the low-power level Pb (mW) so that random signals ranging from a mark length 0.42 µm (3T) to that of 1.96 µm (14T) were recorded in the same groove surface of the recording layer 103 ten times (through a groove recording system). A jitter between the front ends and a jitter between the rear ends were measured, and the average jitter value of these jitters was found. Under each of recording conditions in which the peak power was varied variously with the bias power being fixed to a predetermined value, the peak power was gradually increased so that power 1.3 times the peak power at which the average jitter value in the random signals had reached 13% was provisionally determined as Pp1. Next, under each of recording conditions in which the bias power was varied variously with the peak power being fixed to Pp1, the average jitter value was measured, and the average value of the upper limit value and the lower limit value of the bias power obtained when the average jitter value of the random signals had become 13% or less was set to Pb. Under each of recording conditions in which the peak power was varied variously with the bias power being fixed to Pb, the average jitter value was measured, and the peak power was gradually increased so that power 1.3 times the peak power at which the average jitter value in the random signals had reached 13% was set to Pp. The setting of each of Pp and Pb was carried out on the groove recording operation and the land recording operation, at 16X-speed as well as at 5X-speed. When a recording operation is carried out under Pp and Pb conditions thus determined, an average jitter value of 8 to 9% was obtained at 16X-speed as well as 5X-speed, for example, in repeated recording operations of 10 times. When the laser power upper limit value of the system is taken into consideration, it is preferable to satisfy Pp ≤ 30 mW and Pb ≤ 13 mW even at 16X-speed.

Next, the reliability evaluation is explained. The reliability evaluation is conducted so as to examine whether or not recorded signals are maintained even under a high-temperature condition or whether or not recorded signals are rewritable even after having been left under a high-temperature condition. Upon evaluation, the recording/reproducing device 23 explained in Example 8 was used. Preliminarily, by using the above-mentioned Pp and Pb powers, random signals were recorded in a plurality of tracks in grooves and on lands under conditions of 16X-speed and 5X-speed on the aforementioned seven kinds of information recording media 220, and jitter values were measured. These media were left in a thermo-hygrostat for 100 hours at a temperature of 90°C and a relative humidity of 20%, and then taken out. With respect to the media thus taken out, recorded signals were reproduced so as to measure a jitter (record retaining property). The recorded signals were subjected to an overwriting operation so that a jitter was measured (rewrite retaining property). By comparing the jitter value before storing into the thermo-hydrostat with the jitter value after having been stored therein, the reliability was evaluated. When the jitter value increases, the reliability is lowered. The record retaining property tends to deteriorate at a low X-speed, while the overwrite retaining property tends to deteriorate at a high X-speed. Therefore, in the present example, the record retaining property at 5X-speed and the rewrite retaining property at 16X-speed were evaluated in grooves and on lands.

The results of evaluation on the recording/reproducing operation and reliability evaluation are shown in Tables. The results relating to 16X-speed are shown in Table 11, and the results relating to 5X-speed are shown in Table 12. In the Tables, the unit of Pp and Pb is mW, and with respect to the record retaining property and rewrite retaining property, when an increase in the jitter value was 2% or less, this case was evaluated as ○; when it was greater than 2% and 3% or less, this case was evaluated as Δ; when it was 3% or more and 10% or less, this case was evaluated as ×; and when it was 10% or more, this case was evaluated as ××.

**Table 11**

| Medium number | Composition of Recording layer 103 [(GeTe)_{0.95}(M1Te)_{0.05}]₈Bi₂Te₃ | Groove record of 16x-speed | | | Land record of 16x-speed | | |
|---|---|---|---|---|---|---|---|
| | | Pp | Pb | Rewrite retaining property | Pp | Pb | Rewrite retaining property |
| 10-1 | [(GeTe)_{0.95}(LaTe)_{0.05}]₈Bi₂Te₃ | 25.0 | 10.0 | ○ | 25.3 | 10.2 | ○ |
| 10-2 | [(GeTe)_{0.95}(CeTe)_{0.05}]₈Bi₂Te₃ | 25.0 | 10.0 | ○ | 25.3 | 10.2 | ○ |
| 10-3 | [(GeTe)_{0.95}(NdTe)_{0.05}]₈Bi₂Te₃ | 26.0 | 10.5 | ○ | 26.4 | 10.8 | ○ |
| 10-4 | [(GeTe)_{0.95}(SmTe)_{0.05}]₈Bi₂Te₃ | 25.5 | 10.3 | ○ | 25.8 | 10.5 | ○ |
| 10-5 | [(GeTe)_{0.95}(GdTe) _{0.05}]₈Bi₂Te₃ | 24.0 | 9.5 | ○ | 24.5 | 9.8 | ○ |
| 10-6 | [(GeTe)_{0.95}(TbTe) _{0.05}]₈Bi₂Te₃ | 24.5 | 9.8 | ○ | 24.8 | 10.1 | ○ |
| 10-7 | [(GeTe)_{0.95}(DyTe)_{0.05}]₈Bi₂Te₃ | 25.0 | 10.0 | ○ | 25.3 | 10.2 | ○ |
| Comparative example | (GeTe)₈Bi₂Te₃ | 26.0 | 8.5 | ○ | 26.3 | 10.7 | ○ |

**Table 12**

| Medium number | Composition of Recording layer 103 [(GeTe)_{0.95}(M1Te)_{0.05}]₈Bi₂Te₃ | Groove record of 5x-speed | | | Land record of 5x-speed | | |
|---|---|---|---|---|---|---|---|
| | | Pp | Pb | Rewrite retaining property | Pp | Pb | Rewrite retaining property |
| 10-1 | (GeTe)_{0.95}(LaTe)_{0.05}]₈Bi₂Te₃ | 15.0 | 5.8 | ○ | 15.2 | 5.9 | ○ |
| 10-2 | [(GeTe)_{0.95}(CeTe)_{0.05}]₈Bi₂Te₃ | 15.0 | 5.7 | ○ | 15.2 | 5.8 | ○ |
| 10-3 | [(GeTe)_{0.95}(NdTe)_{0.05}]₈Bi₂Te₃ | 16.0 | 6.2 | ○ | 16.3 | 6.4 | ○ |
| 10-4 | [(GeTe)_{0.95}(SmTe)_{0.05}]₈Bi₂Te₃ | 15.5 | 6.0 | ○ | 15.7 | 6.2 | ○ |
| 10-5 | [(GeTe)_{0.95}(GdTe)_{0.05}]₈Bi₂Te₃ | 14.5 | 5.5 | ○ | 14.7 | 5.7 | ○ |
| 10-6 | [(GeTe)_{0.95}(TbTe)_{0.05}]₈Bi₂Te₃ | 14.7 | 5.6 | ○ | 14.9 | 5.7 | ○ |
| 10-7 | [(GeTe)_{0.95}(DyTe)_{0.05}]₈Bi₂Te₃ | 15.2 | 5.9 | ○ | 15.4 | 6.1 | ○ |
| Comparative example | (GeTe)₈Bi₂Te₃ | 17.0 | 5.5 | ×× | 17.2 | 5.7 | ×× |

As shown in Table 11, with respect to the rewrite retaining property at 16X-speed, desirable results were obtained in medium numbers 10-1 to 10-7 and the comparative example.

As shown in Table 12, with respect to the record retaining property at 5X-speed, desirable results were obtained in medium numbers 10-1 to 10-7. However, upon application of the recording layer 103 of the comparative example containing no M1, a jitter increase of 10% or more was observed in the record retaining property at 5X-speed. By using the [(GeTe)ₓ(M1M3)₁₋ₓ]_{A}M2_{2+B}Te₃ material containing M1, both of superior record retaining property at 5X-speed and rewrite retaining property at 16X-speed were achieved.

### EFFECTS OF THE INVENTION

The present invention provides an information recording medium having a high density and a high transfer rate, in which a recording layer thereof has a high crystallizing temperature, excellent thermal stability of recording marks against the reproducing light and is less susceptible to degradation caused by the reproducing light.

The manufacturing method for an information recording medium of the present invention makes it possible to easily produce the information recording medium of the present invention.

## Claims

1. An information recording medium, comprising:
a recording layer which can phase-change reversibly between a crystal phase and an amorphous phase by using an optical means or an electric means,
wherein the recording layer comprises at least Ge, Te, M1 (which is at least one element selected from the group consisting of Sc, Y, La, Ce, Pr, Nd, Sm, Gd, Tb, Dy, Ho, Er, Yb and Lu), M2 (which is at least one element selected from the group consisting of Sb and Bi) and M3 (which is at least one element selected from the group consisting of Te and Bi).

2. The information recording medium according to claim 1, wherein the recording layer comprises at least GeTe, M2₂Te₃ and M1M3 (which is a compound containing M1 and M3 at a virtually equal rate), and is represented by GeTe-M1M3-M2₂Te₃.

3. The information recording medium according to claim 1, wherein the recording layer is formed of at least one material selected from the group consisting of GeTe-M1Te-Sb₂Te₃, GeTe-M1Bi-Sb₂Te₃, GeTe-M1Te-Bi₂Te₃ and GeTe-M1Bi-Bi₂Te₃.

4. The information recording medium according to claim 1, wherein M1 is at least one element selected from the group consisting of La, Ce, Nd, Sm, Gd, Tb and Dy.

5. The information recording medium according to claim 1, wherein, with respect to the recording layer, one portion of GeTe is substituted by M1M3, and represented by (GeTe-M1M3) -M2₂Te₃.

6. The information recording medium according to claim 2, wherein the recording layer further comprises M2, and is represented by GeTe-M1M3-M2₂Te₃-M2.

7. The information recording medium according to claim 1, wherein the recording layer is represented by a composition formula GeₐM1_{b}M2_{c}M3_{b}Te_{100-a-2b-c}, and relationships, 5 < a < 50, 0 < b ≤ 26, 0 < c ≤ 52, b ≤ a and 42 < a + 2b + c < 77 (in which a, b and c indicate % by atom), are satisfied.

8. The information recording medium according to claim 5, wherein the recording layer is represented by [(GeTe)ₓ(M1M3)₁₋ₓ]_{A}M2_{2+B}Te₃, and relationships, 2 ≤ A ≤ 60, 0 ≤ B ≤ 5 and 0.5 ≤ x < 1, are satisfied.

9. The information recording medium according to claim 8, wherein the recording layer is represented by at least one composition formula selected from the group consisting of [(GeTe)ₓ(M1Te)₁₋ₓ]_{A}Sb_{2+B}Te₃, [(GeTe)ₓ(M1Bi)₁₋ₓ ]_{A}Sb_{2+B}Te₃, [(GeTe)ₓ(M₁Te)₁₋ₓ]_{A}Bi_{2+B}Te₃ and [(GeTe)ₓ(M1Bi)₁₋ₓ ]_{A}Bi_{2+B}Te₃.

10. The information recording medium according to claim 7, wherein the recording layer satisfies both of ranges, 9 < a < 50 and 0 < b ≤ 12.

11. The information recording medium according to claim 8, wherein the value of x satisfies 0.8 ≤ x < 1.

12. The information recording medium according to claim 1, wherein at least, a reflective layer, a second dielectric layer, the recording layer and a first dielectric layer are formed on a substrate in this order.

13. The information recording medium according to claim 1, wherein at least, a first dielectric layer, the recording layer, a second dielectric layer and a reflective layer are formed on a substrate in this order.

14. The information recording medium according to claim 12 or 13, wherein an interface layer is formed at least between the recording layer and the second dielectric layer or between the first dielectric layer and the recording layer.

15. The information recording medium according to claim 1, wherein a nucleus-forming layer is formed in contact with the recording layer through an interface.

16. The information recording medium according to claim 15, wherein the nucleus-forming layer has a cubic system in the crystal structure thereof.

17. The information recording medium according to claim 16, wherein the nucleus-forming layer comprises at least one material selected from the group consisting of M1M3 (which is a compound containing M1 and M3 at a virtually equal rate), SnTe and PbTe.

18. The information recording medium according to claim 17, wherein M1M3, which forms a material of the nucleus-forming layer, contains at least one selected from the group consisting of LaTe, CeTe, NdTe, SmTe, GdTe, TbTe, DyTe, LaBi, CeBi, NdBi, SmBi, GdBi, TbBi and DyBi.

19. The information recording medium according to claim 1, comprising at least two of the recording layers.

20. A method for manufacturing an information recording medium, comprising:
at least a step for forming a recording layer which can phase-change,
wherein the step for forming the recording layer uses a sputtering target that comprises at least Ge, Te, M1 (which is at least one element selected from the group consisting of Sc, Y, La, Ce, Pr, Nd, Sm, Gd, Tb, Dy, Ho, Er, Yb and Lu), M2 (which is at least one element selected from the group consisting of Sb and Bi) and M3 (which is at least one element selected from the group consisting of Te and Bi).

21. The method for manufacturing an information recording medium according to claim 20, wherein the sputtering target comprises at least GeTe, M2₂Te₃ and M1M3 (which is a compound containing M1 and M3 at a virtually equal rate).

22. The method for manufacturing an information recording medium according to claim 21, wherein the sputtering target further comprises M2, and is represented by GeTe-M1M3-M2₂Te₃-M2.

23. The method for manufacturing an information recording medium according to claim 20, wherein the recording layer, which satisfies relationships, 5 < a < 50, 0 < b ≤ 26, 0 < c ≤ 52, b ≤ a and 42 < a + 2b + c < 77, in which a represents % by atom of Ge, b represents % by atom of M1, c represents % by atom of M2, b represents % by atom of M3 and 100 - a - 2b - c represents % by atom of Te, is formed by using the sputtering target.

24. The method for manufacturing an information recording medium according to claim 21, wherein the recording layer, which is represented by [(GeTe)ₓ(M1M3)₁₋ₓ ]_{A}M2_{2+B}Te₃, and satisfies relationships 2 ≤ A ≤ 60, 0 ≤ B ≤ 5 and 0.5 ≤ x < 1, is formed by using the sputtering target.

25. The method for manufacturing an information recording medium according to claim 24, wherein the recording layer, which is represented by at least one composition formula selected from the group consisting of [ (GeTe)ₓ(M1Te)₁₋ₓ]_{A}Sb_{2+B}Te₃, [(GeTe)ₓ(M1Bi)₁₋ₓ]_{A}Sb_{2+B}Te₃, [(GeTe)ₓ(M1Te)₁₋ₓ]_{A}Bi_{2+B}Te₃ and [(GeTe)ₓ(M1Bi)₁₋ₓ]_{A}Bi_{2+B}Te₃, is formed by using the sputtering target.

26. The method for manufacturing an information recording medium according to claim 20, comprising at least the step of:
forming a reflective layer, a second dielectric layer, the recording layer and a first dielectric layer on a substrate in this order.

27. The method for manufacturing an information recording medium according to claim 20, comprising at least the step of:
forming a first dielectric layer, the recording layer, a second dielectric layer and a reflective layer on a substrate in this order.

28. The method for manufacturing an information recording medium according to claim 26 or 27, wherein the step of forming an interface layer is interpolated either between a layer-forming process of the recording layer and a layer-forming process of the second dielectric layer or between a layer-forming process of the first dielectric layer and a layer-forming process of the recording layer.

29. The method for manufacturing an information recording medium according to claim 20, wherein a step of forming a nucleus-forming layer is placed as a pre-process or a post-process of the layer-forming process of the recording layer, and in the step of forming a nucleus-forming layer, the nucleus-forming layer, which comprises at least one material selected from the group consisting of M1M3 (which is a compound containing M1 and M3 at a virtually equal rate), SnTe and PbTe, is formed.

30. The method for manufacturing an information recording medium according to claim 20, wherein at least two steps of forming the recording layer are prepared.

31. The method for manufacturing an information recording medium according to claim 20, wherein the step of forming the recording layer either uses an argon gas or a crypton gas or uses a mixed gas containing at least either one of an argon gas and a crypton gas and either one of a nitrogen gas and an oxygen gas.
